(19)

**Europäisches Patentamt**
**European Patent Office**
**Office européen des brevets**

(11) **EP 4 451 586 A1**

(12) **EUROPEAN PATENT APPLICATION**
published in accordance with Art. 153(4) EPC

(43) Date of publication:
**23.10.2024 Bulletin 2024/43**

(21) Application number: **22919996.3**

(22) Date of filing: **12.12.2022**

(51) International Patent Classification (IPC):
**H04L 1/00** *(2006.01)*

(52) Cooperative Patent Classification (CPC):
**H03M 13/13; H04L 1/00**

(86) International application number:
**PCT/CN2022/138444**

(87) International publication number:
**WO 2023/134363 (20.07.2023 Gazette 2023/29)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **17.01.2022 CN 202210047691
29.04.2022 CN 202210476457**

(71) Applicant: **Huawei Technologies Co., Ltd.
Shenzhen, Guangdong 518129 (CN)**

(72) Inventors:
• **NIU, Kai
Beijing 100876 (CN)**

• **WU, Bolin
Beijing 100876 (CN)**
• **DAI, Jincheng
Beijing 100876 (CN)**
• **ZHANG, Yanqing
Shenzhen, Guangdong 518129 (CN)**
• **LI, Xueru
Shenzhen, Guangdong 518129 (CN)**

(74) Representative: **Maiwald GmbH
Engineering
Elisenhof
Elisenstrasse 3
80335 München (DE)**

(54) **ENCODING METHOD, DECODING METHOD, AND COMMUNICATION DEVICE**

(57) An encoding method, a decoding method, and a communication apparatus are provided, and relate to the communication field. In the method, each row in an MCS table includes an MCS index and a code rate of at least one component encoder that corresponds to the MCS index, and data carried on a physical shared channel may be encoded or decoded based on code rates of M component polar code encoders that correspond to a first MCS index, to provide a method for encoding or decoding the data carried on the physical shared channel by using a polar code coding scheme.

FIG. 5

**EP 4 451 586 A1**

## Description

This application claims priorities to Chinese Patent Application No. 202210047691.5, filed with the China National Intellectual Property Administration on January 17, 2022, and entitled "COMMUNICATION METHOD, UE, AND NETWORK DEVICE", and to Chinese Patent Application No. 202210476457.4, filed with the China National Intellectual Property Administration on April 29, 2022, and entitled "ENCODING METHOD, DECODING METHOD, AND COMMUNICATION APPARATUS", both of which are incorporated herein by reference in their entireties.

## TECHNICAL FIELD

This application relates to the communication field, and more specifically, to an encoding method, a decoding method, and a communication apparatus in the communication field.

## BACKGROUND

Polar code (polar code) coding is a coding scheme in which a Shannon limit may be reached. During polar code coding, redundant information is introduced to improve transmission reliability.
In a polar code coding scheme, how to encode/decode data carried on a physical shared channel by using at least one component polar code encoder is an urgent problem to be resolved.

## SUMMARY

Embodiments of this application provide an encoding method, a decoding method, and a communication apparatus, to process, based on a code rate of a component polar code encoder in a modulation and coding scheme (modulation and coding scheme, MCS) table, data carried on a physical shared channel, so as to provide a method for encoding or decoding the data carried on the physical shared channel by using a polar code coding scheme.
According to a first aspect, an encoding method is provided, including: encoding, based on a code rate of each of $M$ component polar code encoders that corresponds to a first MCS index in an MCS table, data carried on a physical shared channel, where the MCS table includes at least one row, and each of the at least one row included in the MCS table includes an MCS index and a code rate of at least one component polar code encoder that corresponds to the MCS index included in each row; and sending indication information, where the indication information indicates the first MCS index, and the first MCS index is an MCS index in the MCS table. Herein, $M$ is a positive integer.
In the foregoing solution, each row in the MCS table includes the MCS index and the code rate of the at least one component encoder that corresponds to the MCS index, and the data carried on the physical shared channel may be encoded based on code rates of the $M$ component polar code encoders that correspond to the first MCS index, to provide a method for encoding the data carried on the physical shared channel by using a polar code coding scheme.
Optionally, the first MCS index is one MCS index in the MCS index.
Optionally, one row in the MCS table includes one MCS index and a code rate of at least one component polar code encoder that corresponds to the MCS index.
Optionally, the component polar code encoder may be replaced with a modulation subchannel.
In some possible implementations, the sending indication information includes: sending control information. The control information includes the indication information. The control information further indicates the physical shared channel.
Optionally, the method may be performed by a network device.
Optionally, the control information may be downlink control information (downlink control information, DCI).
Optionally, the physical shared channel may be a physical downlink shared channel (physical downlink shared channel, PDSCH).
Optionally, the method may be performed by a terminal device.
Optionally, the control information may be sidelink control information (sidelink control information, SCI).
Optionally, the physical shared channel may be a physical sidelink shared channel (physical sidelink shared channel, PSSCH).
In some possible implementations, the sending indication information includes: sending radio resource control (radio resource control, RRC) signaling. The RRC signaling includes the indication information. Optionally, the RRC signaling may indicate the physical shared channel.
Optionally, the indication information indicating the first MCS index and information indicating the physical shared channel may be one piece of information or different pieces of information. This is not limited in this application.
Optionally, a device that sends the indication information stores the MCS table, and a device that receives the indication information also stores the MCS table.

Optionally, the MCS table may be semi-statically configured by using another signaling, may be preconfigured, or may be indicated by the indication information.

Optionally, the encoding, based on a code rate of $M$ component polar code encoders that corresponds to the first MCS index in the MCS table, data carried on the physical shared channel includes: processing, based on the code rates of the $M$ component polar code encoders that correspond to the first MCS index in the MCS table, a code block (code block, CB) of the data carried on the physical shared channel.

In some possible implementations, each of the at least one row included in the MCS table further includes a modulation order and/or total spectral efficiency corresponding to the MCS index included in each row.

Optionally, the encoding, based on a code rate of $M$ component polar code encoders that correspond to the first MCS index in the MCS table, data carried on the physical shared channel includes: encoding, based on at least one of a modulation order or total spectral efficiency corresponding to the first MCS index in the MCS table and the code rates of the $M$ component polar code encoders that correspond to the first MCS index, the data carried on the physical shared channel.

Optionally, the total spectral efficiency includes first spectral efficiency and second spectral efficiency of a shaped bit. The first spectral efficiency is first spectral efficiency of an information bit.

In some possible implementations, a quantity of code rates of component polar code encoders that correspond to the MCS index included in each row is determined based on the modulation order corresponding to the MCS index included in each row.

In the foregoing solution, the quantity of code rates of the component polar code encoders is determined based on the modulation order corresponding to the MCS index included in each row. This helps to determine the quantity of code rates of the component polar code encoders. For example, the quantity of code rates of the component polar code encoders that correspond to the first MCS index is determined based on the modulation order corresponding to the first MCS index.

Optionally, that the quantity of code rates of the component polar code encoders that correspond to the MCS index included in each row is determined based on the modulation order corresponding to the MCS index included in each row is specifically as follows: The quantity of code rates of the component polar code encoders that correspond to the MCS index included in each row is equal to the modulation order corresponding to the MCS index included in each row.

In some possible implementations, that the quantity of code rates of the component polar code encoders that correspond to the MCS index included in each row is determined based on the modulation order corresponding to the MCS index included in each row is specifically as follows: The quantity of code rates of the component polar code encoders that correspond to the MCS index included in each row is a half of the modulation order corresponding to the MCS index included in each row.

In some possible implementations, the MCS table is characterized by the following: a second MCS index and a third MCS index exist, and when a modulation order corresponding to the second MCS index is different from a modulation order corresponding to the third MCS index, a quantity of code rates of component polar code encoders that correspond to the second MCS index is different from a quantity of code rates of component polar code encoders that correspond to the third MCS index.

In some possible implementations, the quantity of code rates of the component polar code encoders that correspond to the second MCS index is a half of the modulation order corresponding to the second MCS index, and the quantity of code rates of the component polar code encoders that correspond to the third MCS index is a half of the modulation order corresponding to the third MCS index.

In some possible implementations, the total spectral efficiency corresponding to the MCS index included in each row is obtained based on $R_T$ and $R_S$.

$R_T$ is first spectral efficiency, the first spectral efficiency is a sum of spectral efficiency of the at least one component polar code encoder that corresponds to the MCS index included in each row, and $R_S$ is a code rate of a shaped bit of a last component polar code encoder in the at least one component polar code encoder that corresponds to the MCS index included in each row.

In some possible implementations, that the total spectral efficiency corresponding to the MCS index included in each row is obtained based on $R_T$ and $R_S$ includes: the total spectral efficiency corresponding to the MCS index included in each row is $R_T + 2R_S$.

In some possible implementations, each of the at least one row included in the MCS table further includes the code rate $R_S$ of the shaped bit of the last component polar code encoder in the at least one component polar code encoder that corresponds to the MCS index.

In some possible implementations, the encoding method further includes: determining, in the MCS table, a code rate $R_S$ of a shaped bit of an $M^{th}$ component polar code encoder in the M component polar code encoders that corresponds to the first MCS index.

The encoding, based on a code rate of each of $M$ component polar code encoders that corresponds to a first MCS index in an MCS table, data carried on a physical shared channel includes: encoding, based on the code rate of each of the $M$ component polar code encoders that corresponds to the first MCS index in the MCS table and the code rate $R_S$ of the shaped bit of the $M^{th}$ component polar code encoder in the $M$ component polar code encoders that corresponds to the first MCS index, the data carried on the physical shared channel.

In the foregoing solution, the data carried on the physical shared channel may be encoded based on the code rate of each of the $M$ component polar code encoders that corresponds to the first MCS index in the MCS table and the code rate of the shaped bit of the $M^{th}$ component polar code encoder.

In some possible implementations, the encoding method further includes: determining, based on a Maxwell-Boltzmann parameter and a modulation order corresponding to the first MCS index, a code rate $R_S$ of a shaped bit of an $M^{th}$ component polar code encoder in the $M$ component polar code encoders that corresponds to the first MCS index, where the Maxwell-Boltzmann parameter is a preset value.

The encoding, based on a code rate of each of $M$ component polar code encoders that corresponds to a first MCS index in an MCS table, data carried on a physical shared channel includes: encoding, based on the code rate of each of the $M$ component polar code encoders that corresponds to the first MCS index in the MCS table and the code rate $R_S$ of the shaped bit of the $M^{th}$ component polar code encoder in the $M$ component polar code encoders that corresponds to the first MCS index, the data carried on the physical shared channel.

Optionally, the Maxwell-Boltzmann parameter may be semi-statically configured, for example, may be configured by using RRC signaling, or may be preconfigured.

Optionally, the encoding, based on the code rate of each of the $M$ component polar code encoders that corresponds to the first MCS index in the MCS table and the code rate $R_S$ of the shaped bit of the $M^{th}$ component polar code encoder in the $M$ component polar code encoders that corresponds to the first MCS index, the data carried on the physical shared channel includes: processing a first code block CB corresponding to the physical shared channel based on the code rate of each of the $M$ component polar code encoders that corresponds to the first MCS index in the MCS table and the code rate $R_S$ of the shaped bit of the $M^{th}$ component polar code encoder in the $M$ component polar code encoders that corresponds to the first MCS index.

Optionally, the physical shared channel corresponds to one or more CBs, and the one or more CBs corresponding to the physical shared channel may be separately processed based on the code rates of the $M$ component polar code encoders that correspond to the first MCS index. In this way, the physical shared channel may be processed.

Optionally, the physical shared channel corresponds to one or more CBs, and the one or more CBs include the first CB.

In some possible implementations, the determining, based on a Maxwell-Boltzmann parameter and a modulation order corresponding to the first MCS index, a code rate $R_S$ of a shaped bit of an $M^{th}$ component polar code encoder in the $M$ component polar code encoders that corresponds to the first MCS index includes: determining probability distribution of constellation points based on the Maxwell-Boltzmann parameter and the modulation order corresponding to the first MCS index; determining a conditional entropy of the $M^{th}$ component polar code encoder based on the probability distribution of the constellation point; and determining the code rate $R_S$ of the shaped bit of the $M^{th}$ component polar code encoder based on the conditional entropy of the $M^{th}$ component polar code encoder.

In some possible implementations, the code rates of the $M$ component polar code encoders that correspond to the first MCS index in the MCS table are determined based on channel capacities of $M$ modulation subchannels corresponding to the $M$ component polar code encoders and a code length $N$ of each of the $M$ component polar code encoders, the $M$ component polar code encoders are in one-to-one correspondence with the $M$ modulation subchannels, and the channel capacities of the $M$ modulation subchannels are determined based on the total spectral efficiency corresponding to the first MCS index.

In the foregoing solution, the code rates of the $M$ component polar code encoders may be determined based on the channel capacities of the $M$ modulation subchannels and the code length $N$ of each component polar code encoder, and the channel capacity of the modulation subchannel may represent reliability of the modulation subchannel to some extent. Therefore, the code rates of the $M$ component polar code encoders are determined based on the channel capacity of the modulation subchannel and the code length $N$ of each component polar code encoder, to help improve transmission reliability.

In some possible implementations, that the channel capacities corresponding to the $M$ modulation subchannels are determined based on the total spectral efficiency corresponding to the first MCS index is specifically as follows: The channel capacities of the $M$ modulation subchannels are determined based on a transition probability of an equivalent channel of the $M$ modulation subchannels and the probability distribution of the constellation point, the transition probability of the equivalent channel is determined based on the first spectral efficiency and the probability distribution of the constellation point, the probability distribution of the constellation points is the probability distribution that is of the constellation points and that corresponds to a modulation order corresponding to the first MCS index and the Maxwell-Boltzmann parameter, the Maxwell-Boltzmann parameter is a preset value, and the first spectral efficiency is the first spectral efficiency of the information bit in the total spectral efficiency.

In some possible implementations, that the channel capacities of the $M$ modulation subchannels are determined based on the transition probability of the equivalent channel of the $M$ modulation subchannels and the probability distribution of the constellation points is specifically as follows:

The channel capacities of the $M$ modulation subchannels satisfy Formula (1).

$$I(\overline{W}_m) = \sum_{y \in \Psi} \sum_{b_1^m \in \{0,1\}^m} p(y \mid b_1^m) p(b_1^m) \log_2 \frac{p(y \mid b_1^m)}{p(y \mid b_1^{m-1})} \tag{1}$$

Herein, $I(\overline{W}_m)$ is a channel capacity of an $m$ th modulation subchannel in the $M$ modulation subchannels, $m \in [1 \cdots, M]$, $p(y \mid b_1^m)$ is a probability that a symbol output by the equivalent channel is $Y$ when first $m$ bits in an $M$-dimensional bit vector corresponding to a modulation symbol input to the equivalent channel are $b_1^m$, $p(y \mid b_1^{m-1})$ is a probability that a symbol output by the equivalent channel is $Y$ when first $m - 1$ bits in the $M$-dimensional bit vector corresponding to the modulation symbol input to the equivalent channel are $b_1^{m-1}$, $p(b_1^m)$ is a probability that first $m$ bits in the $M$-dimensional bit vector corresponding to the modulation symbol input to the equivalent channel are $b_1^m$, $p(b_1^m)$ is determined based on the probability distribution of the constellation point, $p(y \mid b_1^{m-1})$ and $p(y \mid b_1^m)$ are transition probabilities of the equivalent channel, and $\Psi$ is a set of symbols output by the equivalent channel.

In some possible implementations, that the channel capacities of the $M$ modulation subchannels are determined based on the transition probability of the equivalent channel of the $M$ modulation subchannels and the probability distribution of the constellation points is specifically as follows: A channel capacity of each modulation subchannel in the channel capacities of the $M$ modulation subchannels is determined based on an error probability of each modulation subchannel, the code length $N$ of each component polar code encoder, the transition probability of the equivalent channel, and the probability distribution of the constellation point, and the error probability of each modulation subchannel is determined based on an error probability of the equivalent channel.

In some possible implementations, that the error probability of each modulation subchannel is determined based on the error probability of the equivalent channel is specifically as follows:

The error probability of each modulation subchannel satisfies Formula (2):

$$\varepsilon_m = 1 - (1 - \varepsilon)^{\frac{1}{M}} \tag{2}$$

Herein, $\varepsilon$ is the error probability of the equivalent channel, $\varepsilon$ is a preset value, and $\varepsilon_m$ is an error probability of an $m$ th modulation subchannel. Herein, $m \in [1, \cdots, M]$.

In some possible implementations, that the code rates of the $M$ component polar code encoders that correspond to the first MCS index in the MCS table are determined based on the channel capacities of the $M$ modulation subchannels corresponding to the $M$ component polar code encoders and code lengths $N$ of the $M$ component polar code encoders is specifically as follows:

The code rates of the $M$ component polar code encoder that correspond to the first MCS index in the MCS table are determined based on a quantity of information bits of each component polar code encoder and the code length $N$ of each component polar code encoder, the quantity of information bits of each component polar code encoder is determined based on a proportion of a channel capacity corresponding to each modulation subchannel to a sum of the channel capacities of the $M$ modulation subchannels and a sum of information bits corresponding to the $M$ component polar code encoders, the sum of the information bits corresponding to the $M$ component polar code encoders is obtained based on a target code rate, a quantity $M$ of modulation subchannels, and the code length $N$ of each component polar code encoder.

According to a second aspect, a decoding method is provided, including: receiving indication information, where the indication information indicates a first MCS index, the first MCS index is an MCS index in an MCS table, the MCS table includes at least one row, and each of the at least one row included in the MCS table includes an MCS index and a code rate of at least one component polar code encoder that corresponds to the MCS index included in each row; and decoding, based on a code rate of each of $M$ component polar code encoders that corresponds to the first MCS index in the MCS table, data carried on a physical shared channel.

Herein, $M$ is a positive integer.

In the foregoing solution, each row in the MCS table includes the MCS index and the code rate of the at least one component encoder that corresponds to the MCS index, and the data carried on the physical shared channel may be decoded based on code rates of the $M$ component polar code encoders that correspond to the first MCS index, to provide a method for decoding the data carried on the physical shared channel by using a polar code coding scheme.

In some possible implementations, each of the at least one row included in the MCS table further includes a modulation order and/or total spectral efficiency corresponding to the MCS index included in each row.

In some possible implementations, the MCS table is characterized by the following: a second MCS index and a third MCS index exist, and when a modulation order corresponding to the second MCS index is different from a modulation order corresponding to the third MCS index, a quantity of code rates of component polar code encoders that correspond to the second MCS index is different from a quantity of code rates of component polar code encoders that correspond to the third MCS index.

In some possible implementations, the quantity of code rates of the component polar code encoders that correspond to the second MCS index is a half of the modulation order corresponding to the second MCS index, and the quantity of code rates of the component polar code encoders that correspond to the third MCS index is a half of the modulation order corresponding to the third MCS index.

In some possible implementations, the total spectral efficiency corresponding to the MCS index included in each row is obtained based on $R_T$ and $R_S$.

$R_T$ is first spectral efficiency, the first spectral efficiency is a sum of spectral efficiency of the at least one component polar code encoder that corresponds to the MCS index included in each row, and $R_S$ is a code rate of a shaped bit of a last component polar code encoder in the at least one component polar code encoder that corresponds to the MCS index included in each row.

In some possible implementations, that the total spectral efficiency corresponding to the MCS index included in each row is obtained based on $R_T$ and $R_S$ includes: the total spectral efficiency corresponding to the MCS index included in each row is $R_T + 2R_S$.

In some possible implementations, each of the at least one row included in the MCS table further includes the code rate $R_S$ of the shaped bit of the last component polar code encoder in the at least one component polar code encoder that corresponds to the MCS index.

In some possible implementations, the decoding method further includes:

determining, in the MCS table, a code rate $R_S$ of a shaped bit of an $M$ th component polar code encoder in the $M$ component polar code encoders that corresponds to the first MCS index; and
the decoding, based on a code rate of each of $M$ component polar code encoders that corresponds to the first MCS index in the MCS table, data carried on a physical shared channel includes:
decoding, based on the code rate of each of the $M$ component polar code encoders that corresponds to the first MCS index in the MCS table and the code rate $R_S$ of the shaped bit of the $M$ th component polar code encoder in the $M$ component polar code encoders that corresponds to the first MCS index, the data carried on the physical shared channel.

In some possible implementations, the decoding method further includes:

determining, based on a Maxwell-Boltzmann parameter and a modulation order corresponding to the first MCS index, a code rate $R_S$ of a shaped bit of an $M$ th component polar code encoder in the $M$ component polar code encoders that corresponds to the first MCS index, where the Maxwell-Boltzmann parameter is a preset value; and
the decoding, based on a code rate of each of $M$ component polar code encoders that corresponds to the first MCS index in the MCS table, data carried on a physical shared channel includes:
decoding the physical shared channel based on the code rate of each of the $M$ component polar code encoders that corresponds to the first MCS index in the MCS table and the code rate $R_S$ of the shaped bit of the $M$ th component polar code encoder in the $M$ component polar code encoders that corresponds to the first MCS index.

In some possible implementations, the determining, based on a Maxwell-Boltzmann parameter and a modulation order corresponding to the first MCS index, a code rate $R_S$ of a shaped bit of an $M$ th component polar code encoder in the $M$ component polar code encoders that corresponds to the first MCS index includes: determining probability distribution of constellation points based on the Maxwell-Boltzmann parameter and the modulation order corresponding to the first MCS index; determining a conditional entropy of the $M$ th component polar code encoder based on the probability distribution of the constellation point; and determining the code rate $R_S$ of the shaped bit of the $M$ th component polar code encoder based on the conditional entropy of the $M$ th component polar code encoder.

Specifically, for descriptions of the second aspect, refer to the descriptions of the first aspect.

According to a third aspect, an encoding method is provided, including: receiving indication information, where the indication information indicates a first MCS index, the first MCS index is an MCS index in an MCS table, the MCS table includes at least one row, and each of the at least one row included in the MCS table includes an MCS index and a code rate of at least one component polar code encoder that corresponds to the MCS index included in each row; and encoding, based on a code rate of each of $M$ component polar code encoders that corresponds to the first MCS index in the MCS table, data carried on a physical shared channel.

Herein, $M$ is a positive integer.

In the foregoing solution, each row in the MCS table includes the MCS index and the code rate of the at least one component encoder that corresponds to the MCS index, and the data carried on the physical shared channel may be encoded based on code rates of the $M$ component polar code encoders that correspond to the first MCS index, to provide a method for encoding the data carried on the physical shared channel based on a polar code coding scheme.

In some possible implementations, each of the at least one row included in the MCS table further includes a modulation order and/or total spectral efficiency corresponding to the MCS index included in each row.

In some possible implementations, the MCS table is characterized by the following: a second MCS index and a third MCS index exist, and when a modulation order corresponding to the second MCS index is different from a modulation order corresponding to the third MCS index, a quantity of code rates of component polar code encoders that correspond to the second MCS index is different from a quantity of code rates of component polar code encoders that correspond to the third MCS index.

In some possible implementations, the quantity of code rates of the component polar code encoders that correspond to the second MCS index is a half of the modulation order corresponding to the second MCS index, and the quantity of code rates of the component polar code encoders that correspond to the third MCS index is a half of the modulation order corresponding to the third MCS index.

In some possible implementations, the total spectral efficiency corresponding to the MCS index included in each row is obtained based on $R_T$ and $R_S$.

$R_T$ is first spectral efficiency, the first spectral efficiency is a sum of spectral efficiency of the at least one component polar code encoder that corresponds to the MCS index included in each row, and $R_S$ is a code rate of a shaped bit of a last component polar code encoder in the at least one component polar code encoder that corresponds to the MCS index included in each row.

In some possible implementations, that the total spectral efficiency corresponding to the MCS index included in each row is obtained based on $R_T$ and $R_S$ includes: the total spectral efficiency corresponding to the MCS index included in each row is $R_T + 2R_S$.

In some possible implementations, each of the at least one row included in the MCS table further includes the code rate $R_S$ of the shaped bit of the last component polar code encoder in the at least one component polar code encoder that corresponds to the MCS index.

In some possible implementations, the encoding method further includes:

determining, in the MCS table, a code rate $R_S$ of a shaped bit of an $M^{th}$ component polar code encoder in the $M$ component polar code encoders that corresponds to the first MCS index; and
the encoding, based on a code rate of each of $M$ component polar code encoders that corresponds to the first MCS index in the MCS table, data carried on a physical shared channel includes:
encoding, based on the code rate of each of the $M$ component polar code encoders that corresponds to the first MCS index in the MCS table and the code rate $R_S$ of the shaped bit of the $M^{th}$ component polar code encoder in the $M$ component polar code encoders that corresponds to the first MCS index, the data carried on the physical shared channel.

In some possible implementations, the encoding method further includes:

determining, based on a Maxwell-Boltzmann parameter and a modulation order corresponding to the first MCS index, a code rate $R_S$ of a shaped bit of an $M^{th}$ component polar code encoder in the $M$ component polar code encoders that corresponds to the first MCS index, where the Maxwell-Boltzmann parameter is a preset value; and
the encoding, based on a code rate of each of $M$ component polar code encoders that corresponds to the first MCS index in the MCS table, data carried on a physical shared channel includes:
encoding, based on the code rate of each of the $M$ component polar code encoders that corresponds to the first MCS index in the MCS table and the code rate $R_S$ of the shaped bit of the $M^{th}$ component polar code encoder in the $M$ component polar code encoders that corresponds to the first MCS index, the data carried on the physical shared channel.

In some possible implementations, the determining, based on a Maxwell-Boltzmann parameter and a modulation order corresponding to the first MCS index, a code rate $R_S$ of a shaped bit of an $M^{th}$ component polar code encoder in the *M* component polar code encoders that corresponds to the first MCS index includes:

> determining probability distribution of constellation points based on the Maxwell-Boltzmann parameter and the modulation order corresponding to the first MCS index;
> determining a conditional entropy of the $M^{th}$ component polar code encoder based on the probability distribution of the constellation point; and
> determining the code rate $R_S$ of the shaped bit of the $M^{th}$ component polar code encoder based on the conditional entropy of the $M^{th}$ component polar code encoder.

Specifically, for descriptions of the third aspect, refer to the descriptions of the first aspect.

According to a fourth aspect, a decoding method is provided, including: sending indication information, where the indication information indicates a first MCS index, the first MCS index is an MCS index in an MCS table, the MCS table includes at least one row, and each of the at least one row included in the MCS table includes an MCS index and a code rate of at least one component polar code encoder that corresponds to the MCS index included in each row; and decoding, based on a code rate of each of *M* component polar code encoders that corresponds to the first MCS index in the MCS table, data carried on a physical shared channel.

Herein, *M* is a positive integer.

In the foregoing solution, each row in the MCS table includes the MCS index and the code rate of the at least one component encoder that corresponds to the MCS index, and the data carried on the physical shared channel may be decoded based on code rates of the *M* component polar code encoders that correspond to the first MCS index, to provide a method for decoding the data carried on the physical shared channel by using a polar code coding scheme.

In some possible implementations, each of the at least one row included in the MCS table further includes a modulation order and/or total spectral efficiency corresponding to the MCS index included in each row.

In some possible implementations, the MCS table is characterized by the following: a second MCS index and a third MCS index exist, and when a modulation order corresponding to the second MCS index is different from a modulation order corresponding to the third MCS index, a quantity of code rates of component polar code encoders that correspond to the second MCS index is different from a quantity of code rates of component polar code encoders that correspond to the third MCS index.

In some possible implementations, the quantity of code rates of the component polar code encoders that correspond to the second MCS index is a half of the modulation order corresponding to the second MCS index, and the quantity of code rates of the component polar code encoders that correspond to the third MCS index is a half of the modulation order corresponding to the third MCS index.

In some possible implementations, the total spectral efficiency corresponding to the MCS index included in each row is obtained based on $R_T$ and $R_S$.

$R_T$ is first spectral efficiency, the first spectral efficiency is a sum of spectral efficiency of the at least one component polar code encoder that corresponds to the MCS index included in each row, and $R_S$ is a code rate of a shaped bit of a last component polar code encoder in the at least one component polar code encoder that corresponds to the MCS index included in each row.

In some possible implementations, that the total spectral efficiency corresponding to the MCS index included in each row is obtained based on $R_T$ and $R_S$ includes: the total spectral efficiency corresponding to the MCS index included in each row is $R_T + 2R_S$.

In some possible implementations, each of the at least one row included in the MCS table further includes the code rate $R_S$ of the shaped bit of the last component polar code encoder in the at least one component polar code encoder that corresponds to the MCS index.

In some possible implementations, the decoding method further includes:

> determining, in the MCS table, a code rate $R_S$ of a shaped bit of an $M^{th}$ component polar code encoder in the *M* component polar code encoders that corresponds to the first MCS index; and
> the decoding, based on a code rate of each of *M* component polar code encoders that corresponds to the first MCS index in the MCS table, data carried on a physical shared channel includes:
> decoding, based on the code rate of each of the *M* component polar code encoders that corresponds to the first MCS index in the MCS table and the code rate $R_S$ of the shaped bit of the $M^{th}$ component polar code encoder in the *M* component polar code encoders that corresponds to the first MCS index, the data carried on the physical shared channel.

In some possible implementations, the decoding method further includes:

> determining, based on a Maxwell-Boltzmann parameter and a modulation order corresponding to the first MCS index, a code rate $R_S$ of a shaped bit of an $M$ th component polar code encoder in the $M$ component polar code encoders that corresponds to the first MCS index, where the Maxwell-Boltzmann parameter is a preset value; and the decoding, based on a code rate of each of $M$ component polar code encoders that corresponds to the first MCS index in the MCS table, data carried on a physical shared channel includes:

decoding, based on the code rate of each of the $M$ component polar code encoders that corresponds to the first MCS index in the MCS table and the code rate $R_S$ of the shaped bit of the $M$ th component polar code encoder in the $M$ component polar code encoders that corresponds to the first MCS index, the data carried on the physical shared channel.

In some possible implementations, the determining, based on a Maxwell-Boltzmann parameter and a modulation order corresponding to the first MCS index, a code rate $R_S$ of a shaped bit of an $M$ th component polar code encoder in the $M$ component polar code encoders that corresponds to the first MCS index includes: determining probability distribution of constellation points based on the Maxwell-Boltzmann parameter and the modulation order corresponding to the first MCS index;

determining a conditional entropy of the $M$ th component polar code encoder based on the probability distribution of the constellation point; and
determining the code rate $R_S$ of the shaped bit of the $M$ th component polar code encoder based on the conditional entropy of the $M$ th component polar code encoder.

Specifically, for descriptions of the fourth aspect, refer to the descriptions of the first aspect.

According to a fifth aspect, a method for determining a code rate of a component polar code encoder is provided. The method includes: obtaining first spectral efficiency; determining a channel capacity of each of $M$ modulation subchannels corresponding to $M$ component polar code encoders based on the first spectral efficiency, where the $M$ component polar code encoders are in one-to-one correspondence with the $M$ modulation subchannels, and a code length of each of the $M$ component polar code encoders is $N$ ; and determining a code rate of each component polar code encoder based on the channel capacity corresponding to each modulation subchannel and the code length $N$ of each component polar code encoder. Herein, $N$ and $M$ are positive integers.

In the foregoing solution, code rates of the $M$ component polar code encoders may be determined based on channel capacities of the $M$ modulation subchannels and the code length $N$ of each component polar code encoder, and the channel capacity of the modulation subchannel may represent reliability of the modulation subchannel to some extent. Therefore, the code rate of each component polar code encoder may be determined based on the channel capacity of the modulation subchannel, to improve applicability, and avoid a problem that complexity is high when a quantity of information bits of each component polar code encoder is determined in a numerical search method.

In some possible implementations, the determining a channel capacity of each of $M$ modulation subchannels corresponding to $M$ component polar code encoders based on the first spectral efficiency includes:

determining a transition probability of an equivalent channel corresponding to the $M$ component polar code encoders based on the first spectral efficiency and probability distribution of constellation points, where the probability distribution of the constellation points is probability distribution that is of the constellation points and that corresponds to the modulation order and a Maxwell-Boltzmann parameter, and the Maxwell-Boltzmann parameter is a preset value; and
determining the channel capacity of each of the $M$ modulation subchannels corresponding to the equivalent channel based on the transition probability of the equivalent channel and the probability distribution of the constellation point.

In some possible implementations, the channel capacity of each of the $M$ modulation subchannels corresponding to the equivalent channel is determined based on the transition probability of the equivalent channel and the probability distribution of the constellation point, so that the channel capacity of each modulation subchannel satisfies Formula (1).

$$I(\overline{W}_m) = \sum_{y \in \Psi} \sum_{b_1^m \in \{0,1\}^m} p(y \mid b_1^m) p(b_1^m) \log_2 \frac{p(y \mid b_1^m)}{p(y \mid b_1^{m-1})} \tag{1}$$

Herein, $I(\overline{W}_m)$ is a channel capacity of an $m$ th modulation subchannel in the $M$ modulation subchannels, $m \in$

$[1, \cdots, M]$, $p(y \mid b_1^m)$ is a probability that a symbol output by the equivalent channel is $Y$ when first $m$ bits in an $M$

-dimensional bit vector corresponding to a modulation symbol input to the equivalent channel are $b_1^m$, $p(y \mid b_1^{m-1})$ is a probability that a symbol output by the equivalent channel is $y$ when first $m$-1 bits in the $M$-dimensional bit vector corresponding to the modulation symbol input to the equivalent channel are $b_1^{m-1}$, $p(b_1^m)$ is a probability that first $m$ bits in the $M$-dimensional bit vector corresponding to the modulation symbol input to the equivalent channel are $b_1^m$, $p(b_1^m)$ is determined based on the probability distribution of the constellation point, $p(y \mid b_1^{m-1})$ and $p(y \mid b_1^m)$ are transition probabilities of the equivalent channel, and $\Psi$ is a set of symbols output by the equivalent channel.

In some possible implementations, the determining the channel capacity of each of the $M$ modulation subchannels corresponding to the equivalent channel based on the transition probability of the equivalent channel and the probability distribution of the constellation points includes:

> determining an error probability of each of the $M$ modulation subchannels based on the error probability of the equivalent channel; and
> determining the channel capacity of each modulation subchannel based on the error probability of each modulation subchannel, the code length $N$ of each component polar code encoder, the transition probability of the equivalent channel, and the probability distribution of the constellation point.

In some possible implementations, the error probability of each of the $M$ modulation subchannels is determined based on the error probability of the equivalent channel, so that the error probability of each modulation subchannel satisfies Formula (2):

$$\varepsilon_m = 1 - (1-\varepsilon)^{\frac{1}{M}} \tag{2}$$

Herein, $\varepsilon$ is the error probability of the equivalent channel, $\varepsilon$ is a preset value, and $\varepsilon_m$ is an error probability of an $m$th modulation subchannel. Herein, $m \in [1, \cdots, M]$.

In some possible implementations, the determining a code rate of each component polar code encoder based on a channel capacity corresponding to each modulation subchannel and the code length $N$ of each component polar code encoder includes:

> determining a proportion of the channel capacity corresponding to each modulation subchannel to a sum of the channel capacities of the $M$ modulation subchannels;
> determining a quantity of information bits of a component polar code encoder corresponding to each modulation subchannel based on the proportion of the channel capacity corresponding to each modulation subchannel to the sum of the channel capacities of the modulation subchannels and a sum of information bits corresponding to the $M$ component polar code encoders, where the sum of the information bits corresponding to the $M$ component polar code encoders is obtained based on a target code rate, a quantity $M$ of modulation subchannels, and the code length $N$ of each component polar code encoder; and
> determining a code rate of the information bit of each component polar code encoder based on a quantity of information bits of a component polar code encoder corresponding to each modulation subchannel and the code length $N$ of each component polar code encoder.

In some possible implementations, the method further includes:

> determining a conditional entropy corresponding to an $M$th component polar code encoder in the $M$ component polar code encoders based on the probability distribution of the constellation point, where the code length of each component polar code encoder is $N$, the probability distribution of the constellation points is the probability distribution that is of the constellation points and that corresponds to the modulation order and the Maxwell-Boltzmann parameter, and the Maxwell-Boltzmann parameter is a preset value;
> determining a quantity of shaped bits in the $M$th component polar code encoder based on the conditional entropy corresponding to the $M$th component polar code encoder; and
> determining a code rate of the shaped bit of the $M$th component polar code encoder based on the quantity of shaped bits of the $M$th component polar code encoder and the code length $N$ of the $M$th component polar code encoder.

According to a sixth aspect, a code rate determining method is provided, including: determining a conditional entropy corresponding to an $M^{th}$ component polar code encoder in the $M$ component polar code encoders based on the probability distribution of the constellation point, where the code length of each component polar code encoder is $N$, the probability distribution of the constellation points is probability distribution that is of the constellation points and that corresponds to a modulation order and a Maxwell-Boltzmann parameter, and the Maxwell-Boltzmann parameter is a preset value; determining a quantity of shaped bits of the $M^{th}$ component polar code encoder based on the conditional entropy corresponding to the $M^{th}$ component polar code encoder; and determining the code rate of the shaped bit of the $M^{th}$ component polar code encoder based on the quantity of shaped bits of the $M^{th}$ component polar code encoder and a code length $N$ of the $M^{th}$ component polar code encoder.

In the foregoing solution, the conditional entropy corresponding to the $M^{th}$ component polar code encoder in the $M$ component polar code encoders may be determined based on the probability distribution of the constellation point, and the code rate of the shaped bit of the $M^{th}$ component polar code encoder may be determined based on the conditional entropy corresponding to the $M^{th}$ component polar code encoder. In other words, the code rate of the shaped bit of the $M^{th}$ component polar code encoder may be determined based on a probabilistic shaping scheme, to avoid complexity of determining the quantity of shaped bits of the $M^{th}$ component polar code encoder in a numerical search method, and improve applicability.

Optionally, the probability distribution of the constellation points may be determined based on the Maxwell-Boltzmann parameter and the modulation order.

Optionally, the determining a code rate of a shaped bit of the $M^{th}$ component polar code encoder based on the conditional entropy corresponding to the $M^{th}$ component polar code encoder includes: determining the quantity of shaped bits of the $M^{th}$ component polar code encoder based on the conditional entropy corresponding to the $M^{th}$ component polar code encoder; and determining the code rate of the shaped bit of the $M^{th}$ component polar code encoder based on the quantity of shaped bits of the $M^{th}$ component polar code encoder and the code length $N$ of the $M^{th}$ component polar code encoder.

According to a seventh aspect, this application provides a communication apparatus. The apparatus has a function of implementing a behavior of each device in the foregoing aspects and the possible implementations of the foregoing aspects. The function may be implemented by using hardware, or may be implemented by hardware executing corresponding software. The hardware or the software includes one or more modules or units corresponding to the function. For example, a determining module or unit, or a transceiver module or unit.

According to an eighth aspect, this application provides an electronic device. The apparatus includes a processor, the processor is coupled to a memory, the memory is configured to store a computer program or instructions, and the processor is configured to execute the computer program or the instructions stored in the memory, to perform the method in the foregoing aspects and the possible implementations of the foregoing aspects.

For example, the processor is configured to execute the computer program or instructions stored in the memory, so that the apparatus performs the method in the foregoing aspects and the possible implementations of the foregoing aspects.

Optionally, the apparatus includes one or more processors.

Optionally, the apparatus may further include the memory coupled to the processor.

Optionally, the apparatus may include one or more memories.

Optionally, the memory and the processor may be integrated, or may be disposed separately.

Optionally, the apparatus may further include a transceiver.

According to a ninth aspect, this application provides an electronic device, including one or more processors, a memory, and one or more computer programs. The one or more computer programs are stored in the memory. The one or more computer programs include instructions. When the instructions are executed by the electronic device, one or more processors are enabled to perform the method in any one of the foregoing aspects and the possible implementations of the foregoing aspects, or the method described in any embodiment of this application.

Optionally, the electronic device may further include a touchscreen and/or a camera. The touchscreen includes a touch-sensitive surface and a display.

According to a tenth aspect, this application provides a computer-readable storage medium, including computer instructions. When the computer instructions are run on an electronic device, the electronic device is enabled to perform the method in any one of the foregoing aspects and the possible implementations of the foregoing aspects, or the method described in any embodiment of this application.

According to an eleventh aspect, this application provides a computer program product. When the computer program product is run on an electronic device, the electronic device is enabled to perform the method in any one of the foregoing aspects and the possible implementations of the foregoing aspects, or the method described in any embodiment of this application.

According to a twelfth aspect, this application provides an apparatus, including a unit configured to perform the method described in any embodiment of this application.

## BRIEF DESCRIPTION OF DRAWINGS

FIG. 1 is a schematic diagram of an application scenario according to an embodiment of this application;
FIG. 2 is a schematic diagram of a method for determining a code rate of a component polar code encoder according to an embodiment of this application;
FIG. 3 is a schematic diagram of a method for determining a code rate of a shaped bit according to an embodiment of this application;
FIG. 4 is a schematic diagram of an encoding method and a decoding method according to an embodiment of this application;
FIG. 5 is a schematic diagram of another encoding method and another decoding method according to an embodiment of this application;
FIG. 6 is a schematic diagram of a process in which an encoding device performs encoding by using $M$ component polar code encoders according to an embodiment of this application;
FIG. 7 is a schematic diagram of effect of an encoding method and a decoding method according to an embodiment of this application;
FIG. 8 is a schematic diagram of effect of another encoding method and another decoding method according to an embodiment of this application; and
FIG. 9 is a schematic block diagram of a communication apparatus according to an embodiment of this application.

## DESCRIPTION OF EMBODIMENTS

The following describes the technical solutions in embodiments of this application with reference to the accompanying drawings in embodiments of this application.

The technical solutions in embodiments of this application may be applied to various communication systems such as a global system for mobile communications (global system for mobile communications, GSM), a code division multiple access (code division multiple access, CDMA) system, a wideband code division multiple access (wideband code division multiple access, WCDMA) system, a general packet radio service (general packet radio service, GPRS), a long term evolution (long term evolution, LTE) system, an LTE frequency division duplex (frequency division duplex, FDD) system, an LTE time division duplex (time division duplex, TDD) system, a universal mobile telecommunications system (universal mobile telecommunications system, UMTS), a worldwide interoperability for microwave access (worldwide interoperability for microwave access, WiMAX) communication system, a 5th generation (5th generation, 5G) system, a new radio (new radio, NR) system, or another communication system in the future.

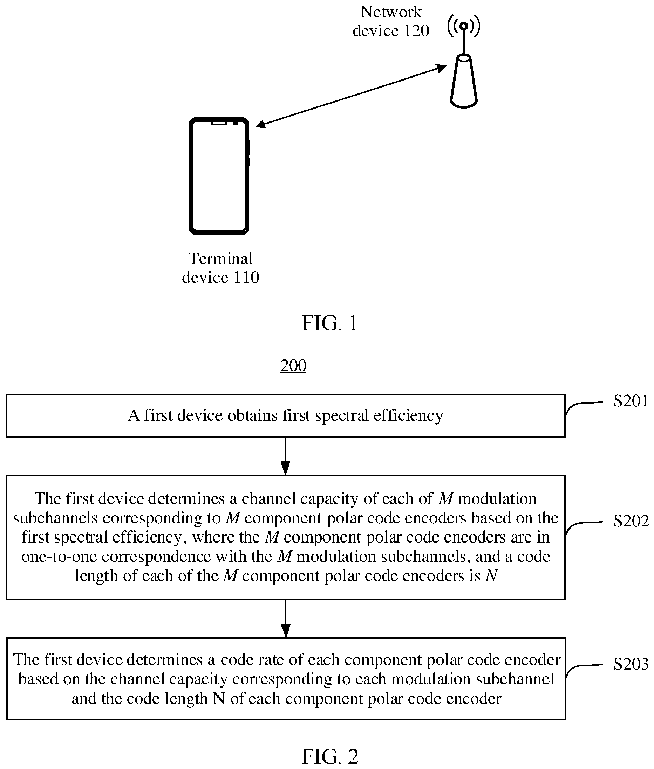

FIG. 1 is a schematic diagram of an application scenario applied to an embodiment of this application. As shown in FIG. 1, a system includes a terminal device 110 and a network device 120.

The terminal device 110 is also referred to as user equipment (user equipment, UE), a mobile station (mobile station, MS), a mobile terminal (mobile terminal, MT), an access terminal, a subscriber unit, a subscriber station, a mobile station, a remote station, a remote terminal, a mobile device, a user terminal, a terminal, a wireless communication device, a user agent, or a user communication apparatus.

The terminal device 110 may be a device that provides voice/data connectivity for a user, for example, a hand-held device or a vehicle-mounted device with a wireless connection function. Currently, examples of some terminal devices include a mobile phone (mobile phone), a tablet, a notebook computer, a palmtop computer, a mobile internet device (mobile internet device, MID), a wearable device, a virtual reality (virtual reality, VR) device, an augmented reality (augmented reality, AR) device, a wireless terminal in industrial control (industrial control), a wireless terminal in self driving (self driving), a wireless terminal in remote medical surgery (remote medical surgery), a wireless terminal in smart grid (smart grid), a wireless terminal in transportation safety (transportation safety), a wireless terminal in smart city (smart city), a wireless terminal in smart home (smart home), a cellular phone, a cordless phone, a session initiation protocol (session initiation protocol, SIP) phone, a wireless local loop (wireless local loop, WLL) station, a personal digital assistant (personal digital assistant, PDA), a handheld device with a wireless communication function, a computing device or another processing device connected to a wireless modem, a vehicle-mounted device, a wearable device, a terminal device in a 5G network, a terminal device in a future evolved public land mobile network (public land mobile network, PLMN), or the like. This is not limited in this application.

The network device 120 may also be referred to as a radio access network (radio access network, RAN) or a radio access network device. The network device 120 may be a transmission reception point (transmission reception point, TRP), or may be an evolved NodeB (evolved NodeB, eNB or eNodeB) in an LTE system, or may be a home base station (for example, home evolved NodeB, or home NodeB, HNB) or a base band unit (base band unit, BBU), or may be a radio controller in a cloud radio access network (cloud radio access network, CRAN) scenario. The network device 120 may alternatively be a relay station, an access point, a vehicle-mounted device, a wearable device, a network device in a 5G network, or a network device in a future evolved PLMN network, or the like, or may be an access point (access point, AP) in a wireless local area network (wireless local area network, WLAN), or may be a gNB in an NR system. The network device 120 may alternatively be a city base station, a micro base station, a picocell base station, a femto base station, or the like. This is not limited in this application.

In a network structure, the network device 120 may include a central unit (central unit, CU) node, a distributed unit (distributed unit, DU) node, a radio access network (radio access network, RAN) device including a CU node and a DU node, or a device including a control plane CU node (CU-CP node), a user plane CU node (CU-UP node), and a DU node.

It should be understood that, only for ease of understanding, the terminal device 110 and the network device 120 are schematically shown in FIG. 1. However, this should not constitute any limitation in this application. A wireless communications system may further include more network devices, or may include more or fewer terminal devices. This is not limited in this application. The terminal device 110 may have a fixed position, or is movable.

Optionally, the network device 120 in FIG. 1 may be further replaced with a terminal device, and a data transmission link between terminal devices is referred to as a sidelink (sidelink). The sidelink is usually used in a scenario of direct communication that may be performed between devices, for example, vehicle-to-another device (vehicle to everything, V2X) communication or device-to-device (device to device, D2D) communication. V2X communication may be considered as a special case of D2D communication. Optionally, a new radio (new radio, NR) access technology is a current mainstream wireless communication technology. For a V2X service feature and a new service requirement, the new radio access technology may support lower-delay and higher-reliability V2X communication. V2X is a basis and a key technology for implementing an intelligent vehicle, self driving, and an intelligent transportation system. V2X may include vehicle to network (vehicle to network, V2N), vehicle-to-vehicle (vehicle-to-vehicle, V2V), vehicle to infrastructure (vehicle to infrastructure, V2I), vehicle-to-pedestrian (vehicle to pedestrian, V2P), and the like.

In the following, for ease of description, a device number is omitted. For example, "terminal device 110" may be simplified as "terminal device", and "network device 120" may be simplified as "network device".

Polar code coding is an only channel coding method that is theoretically proven to be capable of reaching a Shannon limit currently. During polar code coding, redundant information is introduced, to improve transmission reliability. A transmission rate may be reduced because the redundant information is introduced. To improve the transmission rate, high-dimensional modulation may be used on a channel with a limited bandwidth. In an embodiment, a design scheme of polar-coded modulation may be used, and polar-coded modulation is a design scheme of combined optimization of a polar code and modulation, and may be theoretically proven to be capable of reaching a capacity of a symmetrical channel. However, on an additive white Gaussian noise (additive white Gaussian noise, AWGN) channel, a symmetrical channel capacity cannot be achieved through uniformly distributed equal-probability constellation modulation. Therefore, a probabilistic shaping scheme for polar-coded modulation may be used. In some embodiments, in the probabilistic shaping scheme for polar-coded modulation, a polar code is empirically constructed, and cannot be adapted to any coding and modulation system. An application range is limited. For example, in a multi-level polar-coded modulation (multi-level polar-coded modulation, MLC-PCM) scheme, the polar code may be constructed in a numeric search manner. The numeric search manner is to attempt to construct a code rate of a component polar code encoder. If the code rate of the component polar code encoder is constructed inaccurately in an attempt, an attempt to construct the code rate of the component polar code encoder is made again, until an accurate code rate of the component polar code encoder is found. Consequently, computing complexity is high, and this scheme cannot be applied to a random communication system.

Therefore, an embodiment of this application provides a method for determining a code rate of a component polar code encoder. The method may be applied to any communication system. Computing complexity is low, and the code rate of the component polar code encoder is prevented from being constructed in a numerical search manner.

With reference to FIG. 2, the following describes a method 200 for determining a code rate of a component polar code encoder according to an embodiment of this application. The method 200 is applicable to a first device. As shown in FIG. 2, the method 200 includes the following steps.

S201: A first device obtains first spectral efficiency.

Optionally, the first device in the method 200 may be the terminal device or the network device in FIG. 1, or another device different from the terminal device and the network device. In other words, in this embodiment of this application, the another device different from the terminal device and the network device may determine code rates of $M$ component polar code encoders.

Alternatively, S201 may be replaced with: the first device may obtain a modulation order and a target code rate. The first device may determine the first spectral efficiency based on the modulation order and the target code rate. For example, a product of the modulation order and the target code rate is equal to the first spectral efficiency.

Optionally, if the first device is the terminal device, the terminal device may obtain the first spectral efficiency from the network device.

Optionally, the method 200 further includes: The first device obtains the modulation order.

Optionally, the method 200 further includes: The first device obtains the target code rate; and the first device determines the modulation order based on the first spectral efficiency and the target code rate. For example, the first device may divide the first spectral efficiency by the target code rate, to obtain the modulation order.

Optionally, S201 includes: The first device obtains total spectral efficiency; and the first device determines the first spectral efficiency based on second spectral efficiency of a shaped bit. The first spectral efficiency is first spectral efficiency of an information bit.

It should be understood that the total spectral efficiency may be a sum of the first spectral efficiency of the information bit and the second spectral efficiency of the shaped bit. After obtaining the total spectral efficiency, the first device may determine the second spectral efficiency of the shaped bit, and then subtract the second spectral efficiency of the shaped bit from the total spectral efficiency, to obtain the first spectral efficiency of the information bit.

S202: The first device determines a channel capacity of each of $M$ modulation subchannels corresponding to the $M$ component polar code encoders based on the first spectral efficiency, where the $M$ component polar code encoders are in one-to-one correspondence with the $M$ modulation subchannels. A code length of each of the $M$ component polar code encoders is $N$.

Optionally, one polar code encoder may correspond to $M$ component polar code encoder, $M$ may be a preset value, and values of $M$ in different application scenarios may be different. A codeword sequence output by each component polar code encoder corresponds to one modulation subchannel.

Optionally, $N$ is a length of the codeword sequence output by each of the $M$ component polar code encoders.

Optionally, the length $N$ of the codeword sequence output by each component polar code encoder is determined based on a sum of information bits and the first spectral efficiency. For example, the length $N$ of the codeword sequence output by each component polar code encoder may be obtained by dividing the sum of the information bits by the first spectral efficiency.

Optionally, the length $N$ of the codeword sequence output by the component polar code encoder is the power of 2, that is, $N = 2^n$.

Optionally, the sum of the information bits is equal to a product of the length $N$ of the codeword sequence and the first spectral efficiency. For example, if the sum of the information bits is $K$, and the first spectral efficiency is $R_T$, $K = 2^n \cdot R_T$.

Optionally, S202 includes an operation A and an operation B. Operation A: The first device may determine a transition probability of an equivalent channel corresponding to the $M$ component polar code encoders based on the first spectral efficiency and probability distribution of constellation points. Operation B: The first device may determine the channel capacity of each of the $M$ modulation subchannels based on the transition probability of the equivalent channel and the probability distribution of the constellation point.

Optionally, the first device may equivalently obtain an equivalent channel $\overline{W}$ based on the first spectral efficiency, so that a channel capacity $I(\overline{W})$ of the equivalent channel $\overline{W}$ is equal to the first spectral efficiency, and the first spectral efficiency may be represented by $R_T$, that is, $I(\overline{W}) = R_T$.

Optionally, the operation A includes: The first device may determine the transition probability of the equivalent channel corresponding to the $M$ component polar code encoders based on the first spectral efficiency and the probability distribution of the constellation point, so that the transition probability of the equivalent channel satisfies Formula (3).

$$I(\overline{W}) = R_T = \sum_{x \in \Xi} \sum_{y \in \Psi} \overline{W}(y \mid x) p(x) \log_2 \frac{\overline{W}(y \mid x)}{\sum_{x' \in \Xi} \overline{W}(y \mid x') p(x')} \tag{3}$$

Herein, $\Xi$ is a constellation point set, $\Psi$ is a set of symbols output by the equivalent channel after a constellation point in the constellation point set $\Xi$ is input to the equivalent channel, $p(x)$ is a probability of $x$ in the constellation point set $\Xi$, $p(x')$ is also a probability of $x'$ in the constellation point set $\Xi$, $W(y|x)$ is the transition probability of the equivalent channel, $\overline{W}(y|x')$ is also the transition probability of the equivalent channel, and $x'$ indicates that all constellation points in $\Xi$ are traversed. In other words, in Formula (3), $R_T$, $p(x)$, and $p(x')$ are known quantities, and $\overline{W}(y|x)$ and $\overline{W}(y|x')$ are quantities related to a variance $\sigma^2$ of the equivalent channel. In other words, the variance $\sigma^2$ of noise of the equivalent channel is an unknown quantity. After the variance $\sigma^2$ of the noise of the equivalent channel is determined according to Formula (3), a value of $\overline{W}(y|x)$ and a value of $\overline{W}(y|x')$ may be determined. An average value of the noise of the equivalent channel may be 0.

Optionally, after obtaining the modulation order, the first device may determine, based on the modulation order, a quantity of constellation points included in the constellation point set $\Xi$. For example, if the modulation order is $Q_m$, the quantity of constellation points included in the constellation point set $\Xi$ is $2^{Q_m}$, that is, $|\Xi| = 2^{Q_m}$.

Optionally, the first device may determine the probability $p(x)$ of $x$ in the constellation point set $\Xi$ based on the modulation order and a Maxwell-Boltzmann parameter. The Maxwell-Boltzmann parameter may be a preset value. For example, $p(x)$ that may be determined by the first device satisfies Formula (4).

$$p(x) = \frac{\exp(-vx^2)}{\sum\limits_{\hat{x}\in\Xi}(-v\hat{x}^2)} \tag{4}$$

Herein, $v$ is the Maxwell-Boltzmann parameter, $\Xi$ is the constellation point set, and $\hat{x}$ and $x$ are constellation points in the constellation point set $\Xi$.

The operation B is described in the following two cases: The first device may determine the channel capacity of each of the $M$ modulation subchannels based on the transition probability of the equivalent channel and the probability distribution of the constellation point.

Case 1: The first device may determine the channel capacity of each of the $M$ modulation subchannels based on the transition probability of the equivalent channel and the probability distribution of the constellation point, so that the channel capacity of each modulation subchannel satisfies Formula (5).

$$I(\overline{W}_m) = \sum_{y\in\Psi}\sum_{b_1^m\in\{0,1\}^m} p(y\,|\,b_1^m)p(b_1^m)\log_2\frac{p(y\,|\,b_1^m)}{p(y\,|\,b_1^{m-1})} \tag{5}$$

Herein, $I(\overline{W}_m)$ is a channel capacity of an $m$ th modulation subchannel in the $M$ modulation subchannels, $m\in[1,\cdots,M]$, $p(y\,|\,b_1^m)$ is a probability that a symbol output by the equivalent channel is $y$ when first $m$ bits in an $M$ -dimensional bit vector corresponding to a modulation symbol input to the equivalent channel are $b_1^m$, $p(y\,|\,b_1^{m-1})$ is a probability that a symbol output by the equivalent channel is $Y$ when first $m$ - 1 bits in the $M$ -dimensional bit vector corresponding to the modulation symbol input to the equivalent channel are $b_1^{m-1}$, $p(b_1^m)$ is a probability that first $m$ bits in the $M$ -dimensional bit vector corresponding to the modulation symbol input to the equivalent channel are $b_1^m$, $p(b_1^m)$ is determined based on the probability distribution of the constellation point, $p(y\,|\,b_1^{m-1})$ and $p(y\,|\,b_1^m)$ are transition probabilities of the equivalent channel, and $\Psi$ is the set of symbols output by the equivalent channel. Formula (5) may be the same as Formula (1).

The transition probability $\overline{W}(y|x)$ of the equivalent channel may be obtained according to Formula (3). In a mapping process, the $M$ -dimensional bit vector $b_1^M\in\{0,1\}^M$ is given. Herein, $b_1^M\in\{0,1\}^M$ represents that the $M$ -dimensional bit vector $b_1^M$ includes 0 and 1, $M$ in $b_1^M$ represents a length of the bit vector, a mapping rule of a modulation symbol is $\varphi(b_1^M)\mapsto x\in\Xi$, and $\varphi$ represents set partition (Set Partition, SP) mapping. Therefore, $\overline{W}(y\,|\,x)=\overline{W}(y\,|\,\varphi(b_1^M))=p(y\,|\,b_1^M)$.

$$p(y\,|\,b_1^m)=\frac{p(b_1^m,y)}{p(b_1^m)}=\frac{\sum\limits_{b_{m+1}^M}p(b_1^m,b_{m+1}^M,y)}{p(b_1^m)}=\frac{\sum\limits_{b_{m+1}^M}[p(y\,|\,b_1^m,b_{m+1}^M)p(b_1^m,b_{m+1}^M)]}{p(b_1^m)}$$

Herein, in Formula (1), . Herein, ( $b_1^m,b_{m+1}^M$ ) represents a M -dimensional bit vector, and is obtained by concatenating $b_1^m$ and $b_{m+1}^M$ , $p(y\,|\,b_1^M)=p(y\,|\,b_1^m,b_{m+1}^M)=p(y\,|\,\varphi(b_1^m,b_{m+1}^M))$ , $p(y\,|\,\varphi(b_1^m,b_{m+1}^M))$ is a transition probability of a constellation point $\varphi(b_1^m,b_{m+1}^M)\mapsto x$ corresponding to the bit vector $b_1^m,b_{m+1}^M$ ,

$$p(b_1^m, b_{m+1}^M) = p(\varphi(b_1^m, b_{m+1}^M)), \quad p(b_1^m) = \sum_{b_{m+1}^M} p(b_1^m, b_{m+1}^M) = \sum_{b_{m+1}^M} p(\varphi(b_1^m, b_{m+1}^M))$$ , and $p(\varphi(b_1^m, b_{m+1}^M))$ is a

value probability of a constellation point corresponding to the bit vector ( $b_1^m, b_{m+1}^M$ ), that is, $p(b_1^m)$ is a sum of probabilities of a constellation point corresponding to the $M$-dimensional bit vector $b_1^M$ whose first $m$ bits are equal to $b_1^m$.

Case 2: The operation B includes: The first device determines an error probability of each of the $M$ modulation subchannels based on an error probability of the equivalent channel, and determines the channel capacity of each modulation subchannel based on the error probability of each modulation subchannel, the code length $N$ of each component polar code encoder, the transition probability of the equivalent channel, and the probability distribution of the constellation point.

Optionally, the first device determines the error probability of each of the $M$ modulation subchannels based on the error probability of the equivalent channel, so that the error probability of each modulation subchannel satisfies Formula (6):

$$\varepsilon_m = 1 - (1 - \varepsilon)^{\frac{1}{M}} \tag{6}$$

Herein, $\varepsilon$ is the error probability of the equivalent channel, $\varepsilon$ is a preset value, $\varepsilon_m$ is an error probability of an $m$ th modulation subchannel, and $m \in [1, \cdots, M]$. In other words, the error probability of each modulation subchannel may be determined when the error probability of the equivalent channel is given, and error probabilities of all the modulation subchannels may be the same. Formula (6) may be the same as Formula (2).

Optionally, that the first device determines the channel capacity of each modulation subchannel based on the error probability of each modulation subchannel, the code length $N$ of each component polar code encoder, the transition probability of the equivalent channel, and the probability distribution of the constellation points includes: The first device determines divergence of each modulation subchannel based on the transition probability of the equivalent channel, the probability distribution of the constellation point, and an original channel capacity of each modulation subchannel; and determines the channel capacity of each modulation subchannel based on the divergence of each modulation subchannel, the code length $N$ of each component polar code encoder, the error probability of each modulation subchannel, and the original channel capacity of each modulation subchannel.

The original channel capacity of each modulation subchannel may be the channel capacity that is of the modulation subchannel and that is obtained in Case 1. For example, the channel capacity of each modulation subchannel may be obtained according to Formula (5). To be specific, the channel capacity that is of the modulation subchannel and that is calculated in Case 1 may be directly used to calculate a code rate of each component polar code encoder in S203, or the channel capacity that is of each modulation subchannel and that is obtained in Case 1 may be calibrated in Case 2, to obtain the calibrated channel capacity of the modulation subchannel. In S203, the code rate of each component polar code encoder is calculated based on the calibrated channel capacity of the modulation subchannel.

Optionally, the first device determines the divergence of each modulation subchannel based on the transition probability of the equivalent channel, the probability distribution of the constellation point, and the original channel capacity of each modulation subchannel, so that the divergence $V_m$ of each modulation subchannel satisfies Formula (7).

$$V_m = \sum_y \sum_{b_1^m} p(y \mid b_1^m) p(b_1^m) \left[ \log_2 \frac{p(y \mid b_1^m)}{p(y \mid b_1^{m-1})} \right]^2 - I^2(\overline{W}_m) \tag{7}$$

Herein, $V_m$ is the divergence of the $m$ th modulation subchannel, $p(y \mid b_1^m)$ is the probability that the symbol output by the equivalent channel is $y$ when the first $m$ bits in the $M$-dimensional bit vector corresponding to the modulation symbol input to the equivalent channel are $b_1^m$, $p(y \mid b_1^{m-1})$ is the probability that the symbol output by the equivalent channel is $y$ when the first $m$-1 bits in the $M$-dimensional bit vector corresponding to the modulation symbol input to the equivalent channel are $b_1^{m-1}$, $p(b_1^m)$ is the probability that the first $m$ bits in the $M$-dimensional bit vector corresponding to the modulation symbol input to the equivalent channel are $b_1^m$, $p(b_1^m)$ is determined based on the probability distribution of the constellation point, $I(\overline{W}_m)$ is the original channel capacity of each modulation subchannel, and $I(\overline{W}_m)$ may be obtained according to Formula (5).

Optionally, the first device determines the channel capacity of each modulation subchannel based on the divergence of each modulation subchannel, the code length $N$ of each component polar code encoder, the error probability of each modulation subchannel, and the original channel capacity of each modulation subchannel, so that the channel capacity $E(\hat{W}_m,N,\varepsilon_m)$ of each modulation subchannel to satisfies Formula (8).

$$E(\hat{W}_m, N, \varepsilon_m) = I(\overline{W}_m) - \sqrt{\frac{V_m}{N}} Q^{-1}(\varepsilon_m) \qquad (8)$$

Herein, $E(\hat{W}_m,N,\varepsilon_m)$ is the channel capacity of the $m$ th modulation subchannel, $I(\overline{W}_m)$ is the original channel capacity of each modulation subchannel, $I(\overline{W}_m)$ may be obtained according to Formula (1), $V_m$ is the divergence of the $m$ th modulation subchannel, $\varepsilon_m$ is the error probability of the $m$ th modulation subchannel, and $Q(\cdot)$ is a complementary Gaussian cumulative distribution function.

S203: The first device determines the code rate of each component polar code encoder based on the channel capacity corresponding to each modulation subchannel and the code length $N$ of each component polar code encoder.

Optionally, S203 includes: The first device determines a proportion of the channel capacity corresponding to each modulation subchannel to a sum of the channel capacities of the $M$ modulation subchannels; the first device determines a quantity of information bits of a component polar code encoder corresponding to each modulation subchannel based on a proportion of the channel capacity corresponding to each modulation subchannel to a sum of channel capacities of $M$ modulation subchannels and a sum of information bits corresponding to the $M$ component polar code encoders, where the sum of the information bits corresponding to the $M$ component polar code encoders is obtained based on the target code rate, a quantity $M$ of modulation subchannels, and the code length $N$ of each component polar code encoder; and the first device determines the code rate of each component polar code encoder based on the quantity of information bits of the component polar code encoder corresponding to each modulation subchannel and the code length $N$ of each component polar code encoder.

Optionally, the first device may obtain the target code rate, or the first device may obtain the target code rate based on the first spectral efficiency and the modulation order.

In the foregoing solution, the first device may proportionally determine the quantity of information bits of the component polar code encoder corresponding to each modulation subchannel based on the proportion of the channel capacity corresponding to each modulation subchannel to the sum of the channel capacities of the $M$ modulation subchannels, and determine the code rate of each component polar code encoder based on the quantity of information bits of the component polar code encoder corresponding to each modulation subchannel and the code length $N$. In other words, a higher channel capacity of a modulation subchannel indicates higher reliability of the modulation subchannel, and a lower channel capacity of the modulation subchannel indicates lower reliability of the modulation subchannel. The first device allocates a large quantity of information bits to a component polar code encoder corresponding to a modulation subchannel with high reliability, and allocates a small quantity of information bits to a component polar code encoder corresponding to a modulation subchannel with low reliability. For example, if a channel capacity of a modulation subchannel 1 is less than a channel capacity of a modulation subchannel 2, the modulation subchannel 1 corresponds to a component polar code encoder 1, and the modulation subchannel 2 corresponds to a component polar code encoder 2, a quantity of information bits allocated by the first device to the component polar code encoder 1 is less than a quantity of information bits allocated to the component polar code encoder 2.

The following describes two cases. The first device determines the proportion of the channel capacity corresponding to each modulation subchannel to the sum of the channel capacities of the $M$ modulation subchannels; the first device determines the quantity of information bits of the component polar code encoder corresponding to each modulation subchannel from the sum of the information bits based on the proportion of the channel capacity corresponding to each modulation subchannel to the sum of the channel capacities of $M$ modulation subchannels; and the first device determines the code rate of each component polar code encoder based on the quantity of information bits of the component polar code encoder corresponding to each modulation subchannel and the code length $N$ of each component polar code encoder.

Case 1: For Case 1 in S202, the first device splits a channel for sending a modulated symbol into $M$ modulation subchannels $W_m$. Herein, $m \in [1,\cdots,M]$. Optionally, the channel of the modulated symbol may be an AWGN channel. For example, the AWGN channel may be W, and $I(X;Y)$ is mutual information between an input and an output of the channel

$W$. From a perspective of the mutual information, it may be learned that a sum of channel capacities of all modulation subchannels is a channel capacity of the channel W. Therefore, Formula (9) exists.

$$\sum_{m=1}^{M} I(W_m) = I(X;Y) = I(W) \tag{9}$$

Herein, $I(W_m)$ is a channel capacity of each modulation subchannel, and $I(W)$ is a channel capacity of the AWGN channel. In other words, because the sum of the channel capacities of all the modulation subchannels is the channel capacity of the channel $W$, a quantity of information bits may be allocated to the component polar code encoder corresponding to each modulation subchannel based on the proportion of the channel capacity corresponding to each modulation subchannel to the sum of the channel capacities of the $M$ modulation subchannels. In other words, Formula (9) represents a relationship between the channel capacity of each modulation subchannel and the channel capacity of the channel $W$. In a process of allocating the quantity of information bits to the component polar code encoder corresponding to each modulation subchannel, reference may be made to the relationship represented by Formula (9).

It should be understood that the channel $W$ is an actual physical transmission channel, and the channel $W$ is related to a transmission environment. $\overline{W}$ is an equivalent channel of the channel $W$ equivalently obtained based on the modulation order and the target code rate, and $I(\overline{W})$ is a channel capacity of the equivalent channel. With reference to a relationship between a channel capacity of the actual physical transmission channel $W$ and channel capacities of $M$ modulation subchannels $W_m$ corresponding to the channel $W$ in Formula (9), a relationship between the equivalent channel $\overline{W}$ and channel capacities of $M$ modulation subchannels $\overline{W}_m$ corresponding to the equivalent channel $\overline{W}$ may be a relationship represented by Formula (10).

$$\sum_{m=1}^{M} I(\overline{W}_m) = I(\overline{W}) \tag{10}$$

Because the relationship between the equivalent channel $\overline{W}$ and channel capacities of $M$ modulation subchannels $\overline{W}_m$ corresponding to the equivalent channel $\overline{W}$ may be the relationship represented by Formula (10), the quantity of information bits may be allocated to the component polar code encoder corresponding to each modulation subchannel based on the proportion of the channel capacity $I(\overline{W}_m)$ corresponding to each modulation subchannel to the sum of the channel capacities of the M modulation subchannels. For example, a channel capacity sequence of channel capacities $I(\overline{W}_m)$ of the $M$ modulation subchannels satisfies Formula (11).

$$I(\overline{W}_{m_1}) \geq I(\overline{W}_{m_2}) \geq \cdots \geq I(\overline{W}_{m_t}) \geq \cdots \geq I(\overline{W}_{m_M}) \tag{11}$$

Subscripts $m_1$, $m_2$, $m_t$, and $m_M$ of $I(\overline{W}_{m1})$, $I(\overline{W}_{m2})$, ..., $I(\overline{W}_{mt})$, ..., and $I(\overline{W}_{mM})$ in Formula (11) are subscripts of channel capacities of modulation subchannels sorted based on channel capacities. A quantity $K_{m_t}$ of information bits allocated to an $(m_t)^{\text{th}}$ component polar code encoder satisfies Formula (12).

$$K_{m_t} = \left\lceil \left( K - \sum_{t'=1}^{t-1} K_{m_{t'}} \right) \cdot \frac{I(\overline{W}_{m_t})}{\sum_{t'=t}^{M} I(\overline{W}_{m_{t'}})} \right\rceil \tag{12}$$

In Formula (12), $\lceil \cdot \rceil$ is a rounding up operation, $K$ is the sum of the information bits, $K = N \cdot M \cdot R$, and $R$ is the target code rate. If the first device obtains the first spectral efficiency $R_T$ and the modulation order $Q_m$, the first device may determine $R = \dfrac{R_T}{Q_m}$. Alternatively, the first device may directly obtain $K$, and the first device may determine $R$ based on $K$, $N$, and $M$. After $K_{m_t}$ is calculated, it may be calculated that the code rate of the component polar code encoder is $R_{m_t} = \dfrac{K_{m_t}}{N}$ .

The following provides example descriptions of Formula (10) and Formula (11). For example, if $I(\overline{W}_1)$ = 0.1, $I(\overline{W}_2)$ = 0.3, $I(\overline{W}_3)$ = 0.5, $I(\overline{W}_4)$ = 0.7, and $M$ = 4, after sorting is performed according to Formula (7), $I(\overline{W}_4)$ = 0.7 > $I(\overline{W}_3)$ = 0.5 > $I(\overline{W}_2)$ = 0.3 > $I(\overline{W}_1)$ = 0.1 . Herein, $m_1$ = 4, $m_2$ = 3, $m_3$ = 2, $m_4$ = 1, and $t$ = 1,$\cdots$,4. If $K$ = 320,

$$K_{m_1} = \left\lceil (320 - 0) \cdot \frac{0.7}{0.7 + 0.5 + 0.3 + 0.1} \right\rceil = 140 \quad , \quad K_{m_2} = \left\lceil (320 - 140) \cdot \frac{0.5}{0.5 + 0.3 + 0.1} \right\rceil = 100$$ ,

$$K_{m_3} = \left\lceil (320 - 140 - 100) \cdot \frac{0.3}{0.3 + 0.1} \right\rceil = 60 \quad , \text{ and} \quad K_{m_4} = \left\lceil (320 - 140 - 100 - 60) \cdot \frac{0.1}{0.1} \right\rceil = 20$$ . . If $W_1$ corresponds to the component polar code encoder 1, $\overline{W}_2$ corresponds to the component polar code encoder 2, $\overline{W}_3$ corresponds to a component polar code encoder 3, and $\overline{W}_4$ corresponds to a component polar code encoder 4, the quantity of information bits allocated by the first device to the component polar code encoder 1 is 20, the quantity of information bits allocated to the component polar code encoder 2 is 60, a quantity of information bits allocated to the component polar code encoder 3 is 100, and a quantity of information bits allocated to the component polar code encoder 4 is 140. If a code length of each component polar code encoder is 256, a code rate of the component polar code encoder 1 is 20/256 , a code rate of the component polar code encoder 2 is 60/ 256 , a code rate of the component polar code encoder 3 is 100 / 256, and a code rate of the component polar code encoder 4 is 140/256.

It may be understood that Formula (11) and Formula (12) may be further replaced with

$$K_m = \left\lceil \left( K \cdot \frac{I(\overline{W}_m)}{\sum_{m'=1}^{M} I(\overline{W}_{m'})} \right) \right\rceil$$ . To be specific, there is no need to sort channel capacities of all modulation subchannels, and a quantity of information bits allocated to the $m^{\text{th}}$ modulation subchannel based on the proportion of the channel capacity of each modulation subchannel the sum of the capacities of the $M$ modulation subchannels is $K_m$.

Case 2: Case 2 of S202 is the same as Formula (9). Formula (9) represents a relationship between the channel capacity of each modulation subchannel and the channel capacity of the channel $W$. In a process of allocating the quantity of information bits to the component polar code encoder corresponding to each modulation subchannel, reference may be made to the relationship represented by Formula (9).

It should be understood that the channel $W$ is an actual physical transmission channel, and the channel $W$ is related to a transmission environment. $\hat{W}$ is an equivalent channel of the channel $W$ equivalently obtained based on the modulation order and the target code rate in a case of a limited code length. $E(\hat{W},N,\varepsilon)$ is a channel capacity of the equivalent channel in a case of the limited code length $N$ . With reference to formula (9), a channel capacity relationship between the equivalent channel $\hat{W}$ and $M$ modulation subchannels $\hat{W}_m$ corresponding to the equivalent channel $\hat{W}$ satisfies Formula (13).

$$\sum_{m=1}^{M} E(\hat{W}_m, N, \varepsilon_m) = E(\hat{W}, N, \varepsilon) = R_T \tag{13}$$

Because the relationship between the equivalent channel $\hat{W}$ and channel capacities of $M$ modulation subchannels $\hat{W}_m$ corresponding to the equivalent channel $\hat{W}$ may be the relationship represented by Formula (13), the quantity of information bits may be allocated to the component polar code encoder corresponding to each modulation subchannel based on the proportion of the channel capacity $E(\hat{W}_m, N, \varepsilon_m)$ corresponding to each modulation subchannel to the sum of the channel capacities of the M modulation subchannels. For example, a channel capacity sequence of channel capacities $E(\hat{W}_m, N, \varepsilon_m)$ of the $M$ modulation subchannels satisfies Formula (14).

$$E(\hat{W}_{m_1}, N, \varepsilon_{k_1}) \geq E(\hat{W}_{m_2}, N, \varepsilon_{k_2}) \geq \cdots \geq E(\hat{W}_{m_M}, N, \varepsilon_{k_m}) \tag{14}$$

In Formula (14), subscripts $m_1$, $m_2$, and $m_M$ of $E(\hat{W}_{m1}, N, \varepsilon_{k1})$, $E(\hat{W}_{m2}, N, \varepsilon_{k2})$, and $E(\hat{W}_{mM}, N, \varepsilon_{km})$ are subscripts of of channel capacities of modulation subchannels sorted based on channel capacities. A quantity $K_{m_t}$ of information

bits allocated to an $(m_t)^{th}$ component polar code encoder satisfies Formula (15).

$$K_{m_t} = \left\lceil (K - \sum_{t=1}^{t-1} K_{m_t}) \cdot \frac{M(\hat{W}_{m_t}, N, \varepsilon_{k_t})}{\sum_{t=t}^{M} M(\hat{W}_{m_t}, N, \varepsilon_{m_t})} \right\rceil \qquad (15)$$

In Formula (15), $\lceil \cdot \rceil$ is a rounding up operation, $K$ is the sum of the information bits, $K = N \cdot M \cdot R$, and $R$ is the target code rate. If the first device obtains the first spectral efficiency $R_T$ and the modulation order $Q_m$, the first device may determine $R = \dfrac{R_T}{Q_m}$. Alternatively, the first device may directly obtain $K$, and the first device may determine $R$ based on $K$, $N$, and $M$. After $K_{m_t}$ is calculated, it may be calculated that the code rate of the component polar code encoder is $R_{m_t} = \dfrac{K_{m_t}}{N}$.

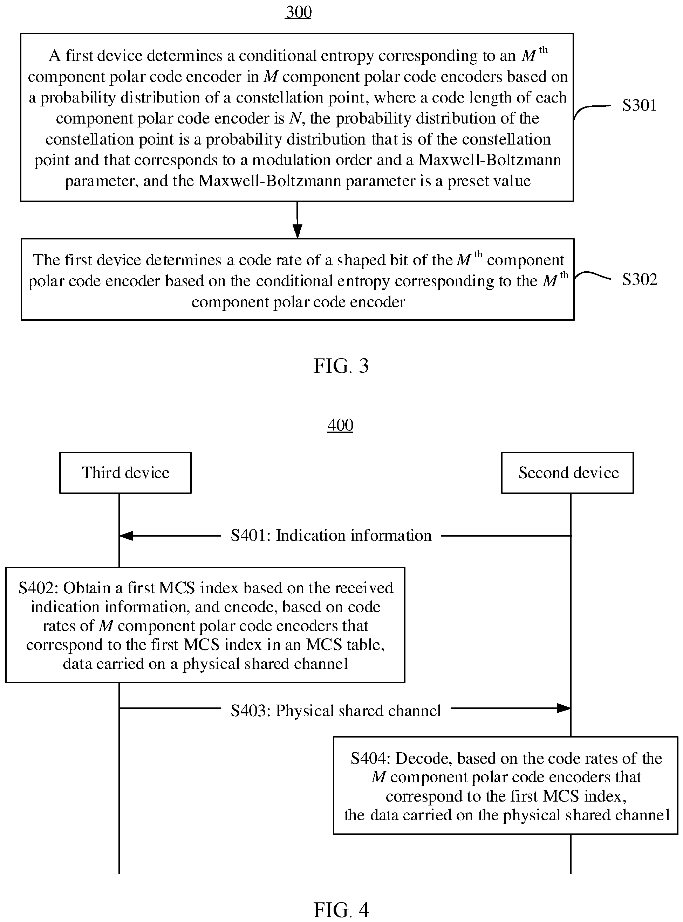

It should be understood that, the code rate of each of the $M$ component polar code encoders that is described and determined in S201 to S203 is a code rate of an information bit of each component polar code encoder. In a polar code coding scheme, it is verified that a shaped bit needs to be added to a last component polar code encoder, so that a mapped modulation symbol can comply with Maxwell-Boltzmann (Maxwell-Boltzmann). However, in some embodiments, a quantity of shaped bits added to the last component polar code encoder is also determined in a numerical search method. Consequently, complexity of determining the shaped bit is high. With reference to FIG. 3, the following describes a method 300 for determining a code rate of a shaped bit in an embodiment of this application. This can reduce complexity of determining the shaped bit.

S301: A first device determines a conditional entropy corresponding to an $M^{th}$ component polar code encoder in $M$ component polar code encoders based on probability distribution of constellation points, where a code length of each component polar code encoder is $N$, the probability distribution of the constellation points is probability distribution that is of the constellation points and that corresponds to a modulation order and a Maxwell-Boltzmann parameter, and the Maxwell-Boltzmann parameter is a preset value.

For the probability distribution of the constellation point, refer to the descriptions of Formula (4).

Optionally, the conditional entropy corresponding to the $M^{th}$ component polar code encoder satisfies Formula (16).

$$H(W_M) = H(b_M | b_1^{M-1}) = - \sum_{b_1^M \in \{0,1\}^M} p(\phi(b_1^M)) \log_2 \frac{p(\phi(b_1^M))}{p(\phi(b_1^{M-1}, 0)) + p(\phi(b_1^{M-1}, 1))} \qquad (16)$$

Herein, $p(\varphi(b_1^M)) = p(x)$, $p(\phi(b_1^{M-1}, 0))$ represents a probability that an $M^{th}$-dimensional bit vector is 0 when first $M - 1$ dimensions of an $M$-dimensional bit vector are known, $p(\phi(b_1^{M-1}, 1))$ represents a probability that the $M^{th}$-dimensional bit vector is 1 when the first $M-1$ dimensions of the M -dimensional bit vector are known, and $p(\phi(b_1^{M-1}, 0))$ and $p(\phi(b_1^{M-1}, 1))$ may be obtained based on the probability distribution of the constellation points in Formula (4).

S302: The first device determines a code rate of a shaped bit of the $M^{th}$ component polar code encoder based on the conditional entropy corresponding to the $M^{th}$ component polar code encoder.

Optionally, S302 includes: The first device determines a quantity of shaped bits of the $M^{th}$ component polar code encoder based on the conditional entropy corresponding to the $M^{th}$ component polar code encoder; and the first device determines the code rate of the shaped bit of the $M^{th}$ component polar code encoder based on the quantity of shaped bits of the $M^{th}$ component polar code encoder and the code length $N$ of the $M^{th}$ component polar code encoder.

Optionally, that the first device determines a quantity of shaped bits of the $M^{th}$ component polar code encoder based on the conditional entropy corresponding to the $M^{th}$ component polar code encoder includes: The first device determines the quantity of shaped bits of the $M^{th}$ component polar code encoder based on the conditional entropy corresponding to the $M^{th}$ component polar code encoder and the code length $N$ of the $M^{th}$ component polar code encoder.

For example, the first device may determine the quantity $K_S$ of shaped bits of the $M^{th}$ component polar code encoder according to Formula (17).

$$K_S = \lfloor (1 - H(W_M)) \cdot N \rfloor \qquad (17)$$

In Formula (17), $H(W_M)$ is the conditional entropy of the $M^{th}$ component polar code encoder, and $\lfloor \cdot \rfloor$ is a rounding down operation.

Optionally, that the first device determines the code rate of the shaped bit of the $M^{th}$ component polar code encoder based on the quantity of shaped bits of the $M^{th}$ component polar code encoder and the code length N of the $M^{th}$ component polar code encoder may include: The first device divides the quantity of shaped bits of the $M^{th}$ component polar code encoder by the code length $N$ of the $M^{th}$ component polar code encoder, to obtain the code rate of the shaped bit of the $M^{th}$ component polar code encoder. For example, the code rate of the shaped bit of the $M^{th}$ component polar code encoder satisfies Formula (18).

$$R_S = K_S / N \qquad (18)$$

An embodiment of this application may provide an MCS table. The MCS table may include at least one row, and each row in the MCS table includes a code rate of at least one component polar code encoder, or each row included in the MCS table includes a code rate of at least one component polar code encoder and a code rate of a shaped bit.

In some possible implementations, the code rate of the at least one component polar code encoder that is included in each row in the MCS table may be determined in the method 200.

In some possible implementations, the code rate of the shaped bit that is included in each row in the MCS table may be determined in the method 300.

In some possible implementations, each row in the MCS table may further include at least one of an MCS index, a modulation order corresponding to the MCS index, or total spectral efficiency. The total spectral efficiency may include first spectral efficiency and second spectral efficiency.

Optionally, different modulation orders in the MCS table may correspond to different values of the Maxwell-Boltzmann parameter v .

In some possible implementations, a quantity of code rates of component polar code encoders that correspond to the MCS index included in each of the at least one row included in the MCS table is determined based on a modulation order corresponding to the MCS index.

In some possible implementations, that the quantity of code rates of the component polar code encoders that correspond to the MCS index included in each of the at least one row included in the MCS table is determined based on the modulation order corresponding to the MCS index includes: The quantity of code rates of the component polar code encoders that correspond to the MCS index included in each of the at least one row included in the MCS table is a half of the modulation order corresponding to the MCS index.

In some possible implementations, the MCS table is characterized by the following: a second MCS index and a third MCS index exist in the MCS table, and when a modulation order corresponding to the second MCS index is different from a modulation order corresponding to the third MCS index, a quantity of code rates of component polar code encoders that correspond to the second MCS index is different from a quantity of code rates of component polar code encoders that correspond to the third MCS index.

In some possible implementations, the quantity of code rates of the component polar code encoders that correspond to the second MCS index is a half of the modulation order corresponding to the second MCS index, and the quantity of code rates of the component polar code encoders that correspond to the third MCS index is a half of the modulation order corresponding to the third MCS index.

In some possible implementations, that the quantity of code rates of the component polar code encoders that correspond to the MCS index included in each of the at least one row included in the MCS table is determined based on the modulation order corresponding to the MCS index includes: The quantity of code rates of the component polar code encoders that correspond to the MCS index included in each of the at least one row included in the MCS table is equal to the modulation order corresponding to the MCS index.

The following describes the MCS table by using an example with reference to Table 1, Table 2, and Table 3.

In Table 1 to Table 3, a corresponding value of the Maxwell-Boltzmann parameter $v$ is 0 when the modulation order is 2, a corresponding value of the Maxwell-Boltzmann parameter v is 0.171 when the modulation order is 4, and a corresponding value of the Maxwell-Boltzmann parameter $v$ is 0.041 when the modulation order is 6. In Table 2, a corresponding value of the Maxwell-Boltzmann parameter $v$ is 0.01 when the modulation order is 8. In Table 1 and Table 3, MCS indexes whose values are 0 to 28 are used for initial transmission, and MCS indexes whose values are 29 to 31 are used for retransmission. In Table 2, MCS indexes whose values are 0 to 27 are used for initial transmission, and MCS indexes whose values are 28 to 31 are used for retransmission. In Table 1 to Table 3, spectral efficiency may be the total spectral efficiency, and the total spectral efficiency includes the first spectral efficiency and the second spectral efficiency. For example, in Table 1 to Table 3, the spectral efficiency is $2R_S + \sum_{i=1}^{Q_m/2} Q_m R_i$. Herein, $\sum_{i=1}^{Q_m/2} Q_m R_i$ is the first spectral efficiency $R_T$, and $2R_S$ is the second spectral efficiency of the shaped bit.

**Table 1**

| MCS index $I_{MCS}$ | Modulation order $Q_m$ | Spectral efficiency | $R_1$ | $R_2$ | $R_3$ | $R_S$ |
|---|---|---|---|---|---|---|
| 0 | 2 | 0.2344 | 0.1172 | X | X | 0.0000 |
| 1 | 2 | 0.3066 | 0.1533 | X | X | 0.0000 |
| 2 | 2 | 0.3770 | 0.1885 | X | X | 0.0000 |
| 3 | 2 | 0.4902 | 0.2451 | X | X | 0.0000 |
| 4 | 2 | 0.6016 | 0.3008 | X | X | 0.0000 |
| 5 | 2 | 0.7402 | 0.3701 | X | X | 0.0000 |
| 6 | 2 | 0.8770 | 0.4385 | X | X | 0.0000 |
| 7 | 2 | 1.0273 | 0.5137 | X | X | 0.0000 |
| 8 | 2 | 1.1758 | 0.5879 | X | X | 0.0000 |
| 9 | 2 | 1.3262 | 0.6631 | X | X | 0.0000 |
| 10 | 4 | 1.3281 | 0.0293 | 0.3633 | X | 0.2715 |
| 11 | 4 | 1.4727 | 0.0449 | 0.4199 | X | 0.2715 |
| 12 | 4 | 1.6953 | 0.0781 | 0.4980 | X | 0.2715 |
| 13 | 4 | 1.9141 | 0.1230 | 0.5625 | X | 0.2715 |
| 14 | 4 | 2.1602 | 0.1895 | 0.6191 | X | 0.2715 |
| 15 | 4 | 2.4023 | 0.2676 | 0.6621 | X | 0.2715 |
| 16 | 4 | 2.5664 | 0.3281 | 0.6836 | X | 0.2715 |
| 17 | 6 | 2.5605 | 0.0029 | 0.3281 | 0.6797 | 0.2695 |
| 18 | 6 | 2.7246 | 0.0059 | 0.3896 | 0.6973 | 0.2695 |
| 19 | 6 | 3.0234 | 0.0176 | 0.5098 | 0.7148 | 0.2695 |
| 20 | 6 | 3.3223 | 0.0381 | 0.6299 | 0.7236 | 0.2695 |
| 21 | 6 | 3.6094 | 0.0732 | 0.7354 | 0.7266 | 0.2695 |
| 22 | 6 | 3.9023 | 0.1289 | 0.8262 | 0.7266 | 0.2695 |
| 23 | 6 | 4.2070 | 0.2109 | 0.8965 | 0.7266 | 0.2695 |
| 24 | 6 | 4.5234 | 0.3164 | 0.9492 | 0.7266 | 0.2695 |
| 25 | 6 | 4.8105 | 0.4336 | 0.9756 | 0.7266 | 0.2695 |
| 26 | 6 | 5.1152 | 0.5684 | 0.9932 | 0.7266 | 0.2695 |
| 27 | 6 | 5.3320 | 0.6709 | 0.9990 | 0.7266 | 0.2695 |
| 28 | 6 | 5.5488 | 0.7793 | 0.9990 | 0.7266 | 0.2695 |

(continued)

| MCS index $I_{MCS}$ | Modulation order $Q_m$ | Spectral efficiency | $R_1$ | $R_2$ | $R_3$ | $R_S$ |
|---|---|---|---|---|---|---|
| 29 | 2 | Reserved | | | | |
| 30 | 4 | Reserved | | | | |
| 31 | 6 | Reserved | | | | |

Table 2

| MCS index $I_{MCS}$ | Modulation order $Q_m$ | Spectral efficiency | $R_1$ | $R_2$ | $R_3$ | $R_4$ | $R_S$ |
|---|---|---|---|---|---|---|---|
| 0 | 2 | 0.2344 | 0.1172 | X | X | X | 0.0000 |
| 1 | 2 | 0.3770 | 0.1885 | X | X | X | 0.0000 |
| 2 | 2 | 0.6016 | 0.3008 | X | X | X | 0.0000 |
| 3 | 2 | 0.8770 | 0.4385 | X | X | X | 0.0000 |
| 4 | 2 | 1.1758 | 0.5879 | X | X | X | 0.0000 |
| **5** | **4** | **1.4727** | **0.0449** | **0.4199** | **X** | **X** | **0.2715** |
| 6 | 4 | 1.6953 | 0.0781 | 0.4980 | X | X | 0.2715 |
| 7 | 4 | 1.9141 | 0.1230 | 0.5625 | X | X | 0.2715 |
| 8 | 4 | 2.1602 | 0.1895 | 0.6191 | X | X | 0.2715 |
| 9 | 4 | 2.4023 | 0.2676 | 0.6621 | X | X | 0.2715 |
| 10 | 4 | 2.5664 | 0.3281 | 0.6836 | X | X | 0.2715 |
| 11 | 6 | 2.7246 | 0.0059 | 0.3896 | 0.6973 | X | 0.2695 |
| 12 | 6 | 3.0234 | 0.0176 | 0.5098 | 0.7148 | X | 0.2695 |
| 13 | 6 | 3.3223 | 0.0381 | 0.6299 | 0.7236 | X | 0.2695 |
| **14** | **6** | **3.6094** | **0.0732** | **0.7354** | **0.7266** | **X** | **0.2695** |
| 15 | 6 | 3.9023 | 0.1289 | 0.8262 | 0.7266 | X | 0.2695 |
| 16 | 6 | 4.2070 | 0.2109 | 0.8965 | 0.7266 | X | 0.2695 |
| 17 | 6 | 4.5234 | 0.3164 | 0.9492 | 0.7266 | X | 0.2695 |
| 18 | 6 | 4.8105 | 0.4336 | 0.9756 | 0.7266 | X | 0.2695 |
| 19 | 6 | 5.1152 | 0.5684 | 0.9932 | 0.7266 | X | 0.2695 |
| 20 | 8 | 5.3281 | 0.0391 | 0.6289 | 0.9961 | 0.7344 | 0.2656 |
| 21 | 8 | 5.5547 | 0.0625 | 0.7148 | 1.0000 | 0.7344 | 0.2656 |
| 22 | 8 | 5.8828 | 0.1250 | 0.8203 | 1.0000 | 0.7305 | 0.2656 |
| 23 | 8 | 6.2266 | 0.2109 | 0.9023 | 1.0000 | 0.7344 | 0.2656 |
| 24 | 8 | 6.5625 | 0.3320 | 0.9531 | 1.0000 | 0.7305 | 0.2656 |
| 25 | 8 | 6.9141 | 0.4727 | 0.9844 | 1.0000 | 0.7344 | 0.2656 |
| 26 | 8 | 7.1563 | 0.5820 | 0.9961 | 1.0000 | 0.7344 | 0.2656 |
| 27 | 8 | 7.3984 | 0.6992 | 1.0000 | 1.0000 | 0.7344 | 0.2656 |
| 28 | 2 | Reserved | | | | | |
| 29 | 4 | Reserved | | | | | |
| 30 | 6 | Reserved | | | | | |

(continued)

| MCS index $I_{MCS}$ | Modulation order $Q_m$ | Spectral efficiency | $R_1$ | $R_2$ | $R_3$ | $R_4$ | $R_S$ |
|---|---|---|---|---|---|---|---|
| 31 | 8 | Reserved | | | | | |

**Table 3**

| MCS index $I_{MCS}$ | Modulation order $Q_m$ | Spectral efficiency | $R_1$ | $R_2$ | $R_3$ | $R_S$ |
|---|---|---|---|---|---|---|
| 0 | 2 | 0.0586 | 0.0293 | X | X | 0.0000 |
| 1 | 2 | 0.0781 | 0.0391 | X | X | 0.0000 |
| 2 | 2 | 0.0977 | 0.0489 | X | X | 0.0000 |
| 3 | 2 | 0.1250 | 0.0625 | X | X | 0.0000 |
| 4 | 2 | 0.1523 | 0.0762 | X | X | 0.0000 |
| 5 | 2 | 0.1934 | 0.0967 | X | X | 0.0000 |
| 6 | 2 | 0.2344 | 0.1172 | X | X | 0.0000 |
| 7 | 2 | 0.3066 | 0.1533 | X | X | 0.0000 |
| 8 | 2 | 0.3770 | 0.1885 | X | X | 0.0000 |
| 9 | 2 | 0.4902 | 0.2451 | X | X | 0.0000 |
| 10 | 2 | 0.6016 | 0.3008 | X | X | 0.0000 |
| 11 | 2 | 0.7402 | 0.3701 | X | X | 0.0000 |
| 12 | 2 | 0.8770 | 0.4385 | X | X | 0.0000 |
| 13 | 2 | 1.0273 | 0.5137 | X | X | 0.0000 |
| 14 | 2 | 1.1758 | 0.5879 | X | X | 0.0000 |
| 15 | 4 | 1.3281 | 0.0293 | 0.3633 | X | 0.2715 |
| 16 | 4 | 1.4727 | 0.0449 | 0.4199 | X | 0.2715 |
| 17 | 4 | 1.6953 | 0.0781 | 0.4980 | X | 0.2715 |
| 18 | 4 | 1.9141 | 0.1230 | 0.5625 | X | 0.2715 |
| 19 | 4 | 2.1602 | 0.1895 | 0.6191 | X | 0.2715 |
| 20 | 4 | 2.4023 | 0.2676 | 0.6621 | X | 0.2715 |
| 21 | 6 | 2.5605 | 0.0029 | 0.3281 | 0.6797 | 0.2695 |
| 22 | 6 | 2.7246 | 0.0059 | 0.3896 | 0.6973 | 0.2695 |
| 23 | 6 | 3.0234 | 0.0176 | 0.5098 | 0.7148 | 0.2695 |
| 24 | 6 | 3.3223 | 0.0381 | 0.6299 | 0.7236 | 0.2695 |
| 25 | 6 | 3.6094 | 0.0732 | 0.7354 | 0.7266 | 0.2695 |
| 26 | 6 | 3.9023 | 0.1289 | 0.8262 | 0.7266 | 0.2695 |
| 27 | 6 | 4.2070 | 0.2109 | 0.8965 | 0.7266 | 0.2695 |
| 28 | 6 | 4.5234 | 0.3164 | 0.9492 | 0.7266 | 0.2695 |
| 29 | 2 | Reserved | | | | |
| 30 | 4 | Reserved | | | | |
| 31 | 6 | Reserved | | | | |

In Table 1 to Table 3, a quantity of code rates of component polar code encoders is a half of the modulation order, a first column represents the MCS index, a second column represents the modulation order, and a third column represents the spectral efficiency. The spectral efficiency is also referred to as the total spectral efficiency, and the total

spectral efficiency is $2R_S + \sum_{i=1}^{Q_m/2} Q_m R_i$ . Herein, $\sum_{i=1}^{Q_m/2} Q_m R_i$ is first spectral efficiency $R_T$ of an information bit, $2R_S$ is the second spectral efficiency of the shaped bit, $R_1$ is a code rate of a 1$^{st}$ component polar code encoder, $R_2$ is a code rate of a 2$^{nd}$ component polar code encoder, $R_3$ is a code rate of a 3$^{rd}$ component polar code encoder, $R_4$ is a code rate of a 4$^{th}$ component polar code encoder, and $R_S$ is a code rate of a shaped bit of a last component polar code encoder. For example, when the modulation order is equal to 2, a quantity of component polar code encoders is 1, and $R_S$ is 0, in other words, the code rate of the shaped bit is 0; when the modulation order is equal to 4, the quantity of component polar code encoders is 2, and $R_S$ is a code rate of a shaped bit in the 2$^{nd}$ component polar code encoder; and when the modulation order is equal to 6, the quantity of component polar code encoders is 3, and $R_S$ is a code rate of a shaped bit in the 3$^{rd}$ component polar code encoder. For example, when the modulation order is 2, the quantity of component polar code encoders is 1, and there is one corresponding code rate of the component polar code encoder; when the modulation order is 4, the quantity of component polar code encoders is 2, and there are two corresponding code rates of the component polar code encoders; and when the modulation order is 6, the quantity of component polar code encoders is 3, and there are three corresponding code rates of the component polar code encoders.

It should be noted that Table 1 to Table 3 are merely described as an example. In this embodiment of this application, the MCS table is not limited. For the value of the Maxwell-Boltzmann parameter $v$, a value of the total spectral efficiency, and the MCS index that are given, any row in the MCS table may be obtained.

It should be noted that in Table 1 to Table 3, $m$ in $Q_m$ is different from $m$ in an $m^{th}$ component polar code encoder, or in Table 1 to Table 3, $m$ in $Q_m$ is different from $m$ in an $m^{th}$ modulation subchannel.

It should be further noted that "X" in Table 1 to Table 3 indicates that nonexistence, to be specific, the code rate does not exist.

In some possible implementations, when each row in the MCS table includes a code rate of at least one component polar code encoder, the code rate of the shaped bit may be determined in the method 300. In this case, the determined code rate of the shaped bit may not be included in the MCS table. For example, in this case, the column of $R_S$ may not be included in Table 1 to Table 3.

Optionally, the first device determines the code rate of the $M^{th}$ polar code encoder in the MCS table based on the value of the Maxwell-Boltzmann parameter $v$, the value of the total spectral efficiency, a length $N$ of a codeword sequence, and the MCS index.

Optionally, that the first device determines the code rate of the $M^{th}$ polar code encoder in the MCS table based on the value of the Maxwell-Boltzmann parameter $v$, the value of the total spectral efficiency, the length of the codeword sequence, and the MCS index may include: The first device determines a modulation order G corresponding to the MCS index based on the MCS index; and the first device determines the probability distribution of the constellation point based on the modulation order and the value of the Maxwell-Boltzmann parameter $v$ (for example, Formula (4)). The first device determines the quantity $K_S$ of shaped bits in the method 300, and determines the code rate $R_S$ of the shaped bit (for example, Formula (18)). In other words, the first device determines a value of $R_S$ in the MCS table. The first device calculates the second spectral efficiency of the shaped bit based on a value of $J \cdot R_S$. Herein, $J$ is a quantity of dimensions of constellation modulation corresponding to the MCS table. For example, if a modulation scheme corresponding to the MCS table is two-dimensional constellation modulation, a value of $J$ is 2. It may be understood that one constellation point in a phase shift keying (phase shift keying, PSK) modulation scheme and Quadrature amplitude modulation a quadrature amplitude modulation (quadrature amplitude modulation, QAM) modulation scheme includes two paths of amplitude shift keying Amplitude shift keying (amplitude shift keying, ASK). When the modulation order is 4, the corresponding modulation constellation diagram is 16QAM, and 16QAM may include two paths of 4ASK. Therefore, the value of $J$ may be understood as a quantity of paths of ASK that forms the modulation constellation diagram. If a modulation scheme corresponding to the MCS table is one-dimensional constellation modulation, the value of $J$ is 1. The total first spectral efficiency of the information bit is obtained by subtracting the second spectral efficiency of the shaped bit from the given total spectral efficiency. Then, the first device determines the code rate of each component polar code encoder in the method 200, to obtain the code rate of each component polar code encoder in the MCS table.

Optionally, the first device determines the code rate of the $M^{th}$ polar code encoder in the MCS table based on the value of the Maxwell-Boltzmann parameter $v$, the sum of the information bits, the length $N$ of the codeword sequence, and the MCS index.

Optionally, that the first device determines the code rate of the $M^{th}$ polar code encoder in the MCS table based on the value of the Maxwell-Boltzmann parameter $v$, the sum of the information bits, the length $N$ of the codeword sequence, and the MCS index includes: The first device determines a total codeword length based on a product of the length $N$ of the codeword sequence and the quantity $M$ of component polar code encoders, and obtains the target code rate by dividing the sum of the information bits by the total codeword length. The first device determines the first spectral efficiency based on a product of the target code rate and the modulation order corresponding to the MCS index, and then obtains the code rate of each component polar code encoder in the method 200, for example, obtains the code rate of the shaped bit in the method 300.

It may be understood that the total spectral efficiency may be given, and the first device may obtain the first spectral efficiency of the information bit by subtracting the second spectral efficiency of the shaped bit from the total spectral efficiency, and further determine the code rate of each component polar code encoder in the method 200. Alternatively, the sum of the information bits may be given, a total code length is determined based on the quantity $M$ of component polar code encoders and the code length $N$ output by each component polar code encoder, the target code rate is determined based on a ratio of the sum of the information bits to the total code length, and the first spectral efficiency is obtained based on a product of the modulation order and the target code rate.

The following describes an encoding method and a decoding method with reference to an MCS table. As shown in FIG. 4, a method 400 includes the following steps.

S401: A second device sends indication information, and a third device receives the indication information.

The indication information indicates a first MCS index, and the first MCS index is an MCS index in the MCS table. For example, the first MCS index is an MCS index in the MCS table, and the MCS table is described above.

Optionally, S401 includes: The second device sends control information, and the third device receives the control information. The control information includes the indication information.

Optionally, that the indication information included in the control information indicates the first MCS index may include: The indication information included in the control information indicates the first MCS index in real time.

Optionally, that the control information indicates the first MCS index may include: The indication information included in the control information indicates a first MCS index for semi-static scheduling.

Optionally, the control information further indicates a physical shared channel.

Optionally, that the control information indicates the physical shared channel may include: The control information is used to schedule the physical shared channel.

Optionally, that the control information indicates the physical shared channel may include: The control information activates a physical shared channel for semi-static scheduling.

For example, the control information may be DCI, the physical shared channel is at least one physical uplink shared channel PUSCH scheduled based on the DCI, and the physical shared channel may be dynamically scheduled after the DCI is scrambled by a C-RNTI, or may be configured grant activated after the DCI is scrambled by a CS-RNTI.

Optionally, the third device may be an encoding device, and the second device may be a decoding device.

Optionally, the second device may be a terminal device, and the third device may be another terminal device.

Optionally, the physical shared channel may be a physical sidelink shared channel (physical sidelink shared channel, PSSCH).

Optionally, the second device may be a network device, and the third device may be a terminal device.

Optionally, the control information may indicate the first MCS index and information about the physical shared channel. For example, downlink control information (downlink control information, DCI) may indicate the first MCS index by using a modulation and coding scheme field, and indicate a time-frequency domain resource of the physical shared channel by using a frequency domain resource assignment field and a time domain resource assignment field.

Optionally, the physical shared channel may be a physical uplink shared channel (physical uplink shared channel, PUSCH).

Optionally, S401 includes: The second device sends radio resource control (radio resource control, RRC) signaling, and the third device receives the RRC signaling. The RRC signaling includes the indication information. The RRC signaling is used to configure the first MCS index and the physical shared channel. Optionally, configuration information in the RRC signaling indicates the first MCS index and the physical shared channel, and the configuration information may include the indication information.

Optionally, the configuration information in the RRC signaling may further include at least one of ConfiguredGrantConfig or SL-ConfiguredGrantConfig.

For example, in uplink transmission, the second device may indicate the first MCS index by using mcsAndTBS signaling in a ConfiguredGrantConfig information element in the RRC signaling, and indicate the time-frequency domain resource of the PUSCH by using timeDomainAllocation signaling and timeDomainAllocation signaling.

Optionally, information indicating the first MCS index and information indicating the physical shared channel may be different information.

Optionally, when the second device may be a terminal device, and the third device may be another terminal device, the RRC signaling may be PC5 RRC signaling.

Optionally, the second device and the foregoing first device that determines code rates of $M$ component polar code encoders may be a same device or different devices. This is not limited in this embodiment of this application.

Optionally, the third device and the foregoing first device that determines the code rates of the *M* component polar code encoders may be a same device or different devices. This is not limited in this embodiment of this application.

Optionally, the second device may include the foregoing first device that determines the code rates of the *M* component polar code encoders.

Optionally, the third device may include the foregoing first device that determines the code rates of the *M* component polar code encoders.

S402: The third device obtains the first MCS index based on the received indication information, and encodes, based on the *M* component polar code encoders that correspond to the first MCS index and that are in the MCS table, data carried on the physical shared channel.

Optionally, S402: The third device obtains the first MCS index based on the received indication information, and encodes, based on a code rate of each of the M component polar code encoders that corresponds to the first MCS index in the MCS table, data carried on the physical shared channel.

Optionally, S402 includes: The third device determines a quantity of information bits of each of the *M* component polar code encoders based on the code rate of each component polar code encoder in the code rates of the *M* component polar code encoders that correspond to the first MCS index; and the third device performs encoding based on the quantity of information bits of each component polar code encoder.

Optionally, that the third device determines a quantity of information bits of each of the *M* component polar code encoders based on the code rate of each component polar code encoder in the code rates of the *M* component polar code encoders that correspond to the first MCS index includes: The third device determines the quantity of information bits of each component polar code encoder based on the code rate of each component polar code encoder and a code length of each component polar code encoder.

Optionally, code lengths of all of the *M* component polar code encoders may be the same or different. This is not limited in this embodiment of this application.

Optionally, S402 includes: The third device encodes, based on the code rates of the *M* component polar code encoders that correspond to the first MCS index in the MCS table, one CB carried on the physical shared channel. A quantity of information bits of one CB may be *K*.

Optionally, for one of one or more CBs corresponding to the physical shared channel, the third device may encode one CB based on the code rates of the *M* component polar code encoders that correspond to the first MCS index in the MCS table.

Optionally, the information bit of one CB may include a bit corresponding to data from a higher layer and a cyclic redundancy check (cyclic redundancy check, CRC) bit. In other words, the information bit of one CB not only includes the bit of the data from the higher layer but also includes a check bit. Optionally, the data from the higher layer may include data from a higher layer application and data from a higher layer header.

With reference to the CB, the following describes cases of a process in which the third device performs encoding.

Case 1

Operation 1: The third device determines a quantity of CBs based on a total code length and a code length of the CB.

Optionally, the third device may determine the total code length based on parameters such as a modulation order corresponding to the first MCS index and a physical resource allocated by the second device to the third device. The total code length may be understood as a code length sum after a plurality of CBs are encoded. The total code length may also be understood as a total length of a bit sequence that may be transmitted by the third device, and is obtained based on a total quantity of resource elements (resource element, RE) in a slot, a modulation order $Q_m$, and a quantity v of space layers. The control information in S401 may indicate a total quantity of REs, or the RRC signaling may indicate a total quantity of REs, and the quantity v of space layers may be semi-statically configured by using higher layer signaling. For example, the total code length may be obtained based on $N_{total} = N_{RE} \cdot Q_m \cdot v$. Herein, $N_{total}$ is the total length of the bit sequence that may be transmitted by the third device, or may be understood as the total code length, $N_{RE}$ is a total quantity of REs in a slot scheduled based on the control information or a total quantity of REs in a slot indicated by the RRC signaling, and $Q_m$ is a modulation order corresponding to the first MCS index, and has a meaning the same as a meaning of $Q_m$ in Table 1 to Table 3. Alternatively, the total code length may be obtained in another manner. This is not limited in this application.

Optionally, the code length of the CB may be a preset value. To be specific, the code length of the CB is a known parameter of the second device and the third device, or the code length of the CB may be semi-statically configured by the third device for the second device, or the code length of the CB is semi-statically configured by the second device for the third device.

Optionally, code lengths of all CBs may be equal, or an actual code length of a last CB may be different from an actual code length of another CB. The code length of the CB may be understood as a length of a bit sequence or a quantity of bits of an encoded CB.

For example, if the total code length determined by the third device is $N_{total}$, and the code length of the CB is

$$C = \lceil N_{total} / N_{cb} \rceil$$

$N_{cb}$, the quantity C of CBs may be . In other words, a total of $C$ CBs exist. Herein, a code length of each CB in first $C$-1 CBs is $N_{cb}$, and a code length of a last CB is $N_{total}$ - ($C$ -1)· $N_{cb}$. Herein, $\lceil \cdot \rceil$ is rounding up. For example, $N_{cb}$ may be $M \cdot N$. To be specific, a code length after one CB is encoded may be a code length sum $M \cdot N$ after M component polar code encoders corresponding to the CB perform encoding.

Operation 2: The third device determines a quantity $K_{cb}$ of information bits of each CB based on the code length $N_{cb}$ of the CB and a target code rate.

It should be understood that a quantity $K_{cb}$ of information bits of one CB may include a bit corresponding to the data from the higher layer, or a quantity $K_{cb}$ of information bits of one CB may further include a bit corresponding to the data from the higher layer and a CRC bit. In other words, the information bit $K_{cb}$ of one CB not only includes the bit of the data from the higher layer but also includes a check bit. Optionally, the data from the higher layer may include data from a higher layer application and data from a higher layer header.

Optionally, the target code rate may be a code rate corresponding to first spectral efficiency corresponding to the first MCS index. For example, if $R_T$ is the first spectral efficiency corresponding to the first MCS index, and $Q_m$ is the modulation order corresponding to the first MCS index, the target code rate is $R = R_T / Q_m$.

With reference to an example of the operation 1, the quantity of information bits of each CB in the first $C$-1 CBs is $K_{cb} = N_{cb} \cdot R = M \cdot N \cdot R$, R is a target code rate corresponding to the first MCS index, and the target code rate corresponding to the first MCS index is $R = R_T / Q_m$.

A quantity $K_{cb}^{C}$ of information bits of a $C$th CB may be determined in two manners. In a first manner, it is determined that a value that is of a maximum integral power of 2 and that is less than or equal to $N_{total}$ - ($C$ - 1) · $N_{cb}$ is

$N_{cb1}$, and the quantity of information bits of the $C$ th CB is $K_{cb}^{C} = N_{cb1} \cdot R$ . In this manner, a remaining bit of the $C$th CB may be padded in a padding (padding) manner, for example, may be padded with a plurality of bits "0" or bits "1". For example, if a value of $N_{total}$ - ($C$ - 1) · $N_{cb}$ is 300, and a maximum integral power of 2 less than 300 is 256, $N_{cb1}$ is 256, and remaining 44 bits may be all padded with "0" or "1". In a second manner, it is determined that a value of a minimum integral power of 2 greater than $N_{total}$-($C$-1)· $N_{cb}$ is $N_{cb2}$, and a quantity of information bits of the $C$ th CB is

$K_{cb}^{C} = N_{cb2} \cdot R$ . Because $N_{cb2}$ is greater than $N_{total}$-($C$ -1)·$N_{cb}$, an encoded bit of the $C$ th CB needs to be punctured or truncated. For example, if a value of $N_{total}$-($C$-1)·$N_{cb}$ is 500, a minimum integral power of 2 greater than 500 is $N_{cb2}$=512. Therefore, 512 encoded bits are punctured or truncated to obtain 500 bits. Whether to choose to perform puncturing or truncation may be determined based on a value relationship between the target code rate corresponding to the first MCS index and a threshold code rate. Specifically, if the target code rate corresponding to the first MCS index is less than or equal to the threshold code rate, the 512 encoded bits are reduced to 500 bits in a puncturing manner; or if the target code rate corresponding to the first MCS index is greater than the threshold code rate, the 512 bits are reduced to 500 bits in a truncation manner. The threshold code rate is indicated or preconfigured by using higher layer signaling. For example, when $R \leq R_{th}$, the puncturing manner is used to reduce the 512 bits to 500 bits; or when $R > R_{th}$, the truncation manner is selected. $R_{th}$ is the threshold code rate.

Operation 3: The third device encodes an information bit of each CB based on a code rate of a component polar code encoder that corresponds to the first MCS index in the MCS table.

All CBs correspond to a same first MCS index. In this case, all CBs correspond to a same code rate and same spectral efficiency.

Optionally, the third device determines the quantity of information bits of each component polar code encoder based on a quantity $K_{cb}$ of information bits of a first CB, the code rate of each component polar code encoder, and the code length $N$ of each component polar code encoder. The third device performs encoding based on the information bits of each component polar code encoder, and the first CB is one of the one or more CBs corresponding to the physical shared channel. By analogy, the third device may encode $C$-1 CBs. Code lengths of $M$ component polar code encoders corresponding to a $C$ th CB may be unequal to $N_{cb}$, and may be less than $N_{cb}$. The third device may perform encoding the $M$ component polar code encoders corresponding to the $C$ th CB, to complete an encoding process of the physical shared channel.

Case 2

Operation 1: The third device determines a quantity of CBs based on a length of an information bit of each CB and a length of total information bits.

Optionally, a quantity $K_{cb}$ of information bits of each CB may be preconfigured, semi-statically configured by the second device for the third device, or semi-statically configured by the third device for the second device.

Optionally, the quantity $K_{cb}$ of information bits of each CB may include a bit corresponding to the data from the higher layer, or a quantity $K_{cb}$ of information bits of one CB may further include a bit corresponding to the data from the higher layer and a CRC bit. In other words, the information bit $K_{cb}$ of one CB not only includes the bit of the data from the higher layer but also includes a check bit. Optionally, the data from the higher layer includes data from a higher layer application and data from a higher layer header.

Optionally, the total information bits include the bit corresponding to the data from the higher layer and the CRC bit. Therefore, the length of the total information bits is a sum of a length of the bit corresponding to the data from the higher layer and a length of the CRC bit. Optionally, the data from the higher layer may include data from a higher layer application and data from a higher layer header.

For example, if the length of the bit corresponding to the data from the higher layer is A, and a length of an added CRC check bit is $L$, the length of the total information bits is $B = A + L$, and the length of the information bit of each CB is $K_{cb}$. Therefore, the quantity of CBs is determined based on $B$ and $K_{cb}$. For example, the quantity of CBs is

$$C = \lceil A/(K_{cb} - L) \rceil$$. Herein, $\lceil \cdot \rceil$ is rounding up.

When $C > 1$, a quantity of information bits of first C-1 CBs is $K_{cb}$, a quantity $K_{cb}^{C}$ of information bits of a $C$ th CB may be less than or equal to $K_{cb}$, and may be obtained based on $K_{cb}^{C} = B - (K_{cb} - L) \cdot (C - 1) + L$. When $C = 1$, in other words, when there is only one CB, an actual size of the CB is a length of total information bits. In other words, $K_{cb}^{C} = B$. In this case, a CRC check bit is not additionally added to the CB.

Optionally, the third device determines the length $B$ of the total information bits based on a parameter corresponding to the first MCS index, a quantity of space layers, and a total quantity of REs in a slot. The quantity of space layers may be semi-statically configured by higher layer signaling. This is not limited in this embodiment of this application. In S401, the control information may indicate the total quantity of REs, or the RRC signaling may indicate the total quantity of REs. Optionally, the parameter corresponding to the first MCS index includes the modulation order corresponding to the first MCS index and a code rate corresponding to the first MCS index. The third device may determine the length of the total information bits based on parameters such as the modulation order corresponding to the first MCS index, the code rate corresponding to the first MCS index, the total quantity of REs in the slot, and the quantity of space layers. For example, the length of the total information bits may be based on $B = N_{RE} \cdot Q_m \cdot v \cdot R$. Herein, $B$ is a length of total information bits before encoding, or may be understood as a total code length before encoding, $N_{RE}$ is a total quantity of REs in a slot scheduled based on the control information or a total quantity of REs in a slot indicated by the RRC signaling, $Q_m$ is the modulation order corresponding to the first MCS index, and has a meaning the same as a meaning of $Q_m$ in Table 1 to Table 3, and $R$ is a target code rate corresponding to the first MCS index. Alternatively, the length of the total information bits may be obtained in another manner. This is not limited in this application.

Operation 2: The third device encodes an information bit of each CB based on the information bit of each CB and a code rate of a component polar code encoder that corresponds to the first MCS index in the MCS table.

All CBs correspond to a same first MCS index. In this case, all CBs correspond to a same code rate and same spectral efficiency.

Optionally, the third device determines the quantity of information bits of each component polar code encoder based on an information bit $K_{cb}$ of a first CB, the code rate of each component polar code encoder, and the code length $N$ of each component polar code encoder. The third device performs encoding based on the quantity of information bits of each component polar code encoder, and the first CB is one of the one or more CBs corresponding to the physical shared channel. By analogy, the third device may encode each CB, to complete an encoding process of the physical shared channel.

S403: The third device sends the physical shared channel to the second device, and the second device receives the physical shared channel.

It should be understood that the indication information in S401 may indicate a plurality of physical shared channels. For example, indication information, for example, a modulation and coding scheme field, included in one piece of control information may indicate to encode data carried on the plurality of physical shared channels, and the physical shared channels may be on adjacent or non-adjacent time units, for example, slots, symbols, or subframes. In other words, one piece of indication information in S401 may indicate to encode the data carried on the plurality of physical shared channels in S403. For example, DCI scrambled by one CS-RNTI may activate semi-static scheduling, for example, configured grant. To be specific, within a transmission time period, one time of existence of the indication information and the corresponding control information in S401 may indicate to encode data carried on physical shared channels at a plurality of different transmission moments, and a transmission time interval of the physical shared channels is configured by using RRC signaling. For another example, during dynamic scheduling, one piece of indication information may indicate to encode data carried on a plurality of physical shared channels.

Optionally, the physical shared channel carries encoded data. Optionally, the encoded data may be an encoded CB.

Optionally, the physical shared channel may be a physical shared channel scheduled based on the control information in S401. For example, the control information may be DCI, and a physical shared channel scheduled based on the DCI may be a PUSCH. For another example, the control information may be any SCI, and a shared channel scheduled based on the SCI may be aPSSCH.

Optionally, the physical shared channel may be a physical shared channel that is used for semi-static scheduling and that is activated by the control information in S401. For example, the control information in S401 may be DCI scrambled by a cell-radio network temporary identifier (cell-radio network temporary identifier, C-RNTI), and is used to activate a PUSCH for semi-static scheduling. The control information in S401 may be any SCI scrambled by a sidelink cell-radio network temporary identifier (sidelink cell-radio network temporary identifier, SL-C-RNTI), and is used to activate a PSSCH for semi-static scheduling. Optionally, the control information in S401 further indicates parameters such as a time-frequency resource for semi-static scheduling and the first MCS index, and is used to activate parameters such as the time-frequency resource for semi-static scheduling and the first MCS index. Semi-static scheduling includes semi-persistent scheduling (semi-persistent scheduling, SPS) and configured grant (configured grant, CG). Specifically, when semi-static scheduling is activated based on the control information, the third device periodically sends the physical shared channel to the second device. The periodicity parameter may be configured by the second device for the third device, or may be configured by the third device for the second device. This is not limited in this embodiment of this application.

Optionally, the physical shared channel may be a physical shared channel configured by using RRC signaling in S401.

Optionally, S403 may further include a modulation and demodulation process. To avoid repetition, details are not described.

It should be noted that S403 may be an optional step. This embodiment of this application may not include S403. To be specific, this embodiment of this application mainly describes a manner in which the third device encodes the physical shared channel based on the code rates of the $M$ component polar code encoders that correspond to the first MCS index, and the second device decodes the physical shared channel based on the code rates of the $M$ component polar code encoders that correspond to the first MCS index. Whether the third device sends the physical shared channel may be ignored.

S404: The second device decodes, based on the code rates of the $M$ component polar code encoders that correspond to the first MCS index, the data carried on the physical shared channel.

Optionally, the information bit may be obtained after decoding in S404.

Optionally, S404 includes: The second device decodes, based on the code rate of each of the $M$ component polar code encoders that corresponds to the first MCS index, the data carried on the physical shared channel.

Optionally, the information bit in S404 may be the information bit of each CB.

A principle in which the second device decodes, based on the code rates of the $M$ component polar code encoders that correspond to the first MCS index, the data carried on the physical shared channel is an inverse process of a principle in which the third device performs encoding. To avoid repetition, details are not described.

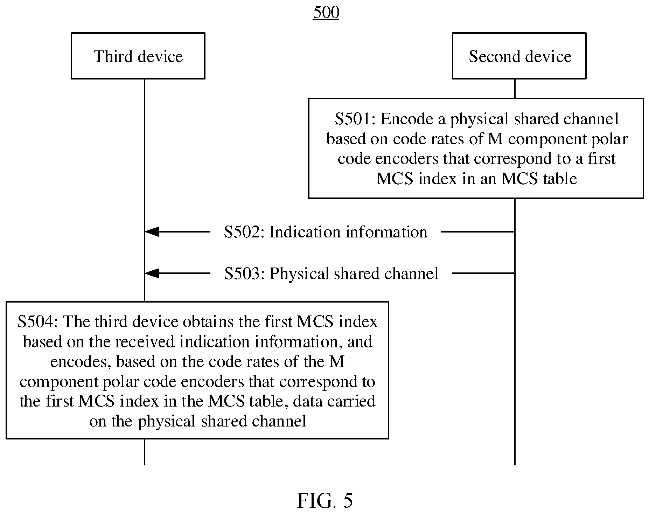

The following describes another encoding method and another decoding method with reference to an MCS table. As shown in FIG. 5, a method 500 includes the following steps.

S501: A second device encodes a physical shared channel based on code rates of $M$ component polar code encoders that correspond to a first MCS index in an MCS table.

Optionally, S501: A second device encodes a physical shared channel based on a code rate of each of $M$ component polar code encoders that corresponds to a first MCS index in an MCS table.

Specifically, for S501, refer to the descriptions in S402. A principle in which the second device performs encoding is similar to a principle in which a third device performs encoding in S402. To avoid repetition, details are not described.

S502: The second device sends indication information, and the third device receives the indication information.

The indication information indicates the first MCS index, and the first MCS index is an MCS index in the MCS table. For example, the first MCS index is an MCS index in the MCS table, and the MCS table is described above.

Optionally, S502 includes: The second device sends control information, and the third device receives the control information. The control information includes the indication information.

Optionally, that the indication information included in the control information indicates the first MCS index may include: The indication information included in the control information indicates the first MCS index in real time.

Optionally, that the control information indicates the first MCS index may include: The indication information included in the control information indicates a first MCS index for semi-static scheduling.

Optionally, the control information further indicates the physical shared channel.

Optionally, that the control information indicates the physical shared channel may include: The control information is used to schedule the physical shared channel.

Optionally, that the control information indicates the physical shared channel may include: The control information activates a physical shared channel for semi-static scheduling.

For example, the control information may be downlink control information DCI, the physical shared channel is at least one physical downlink shared channel PDSCH scheduled based on the DCI, and the physical shared channel may be dynamically scheduled after the DCI is scrambled by a C-RNTI, or may be semi-persistent scheduling (semi-persistent scheduling, SPS) activated after the DCI is scrambled by a CS-RNTI.

Optionally, the physical shared channel may be a physical downlink shared channel (physical downlink shared channel, PDSCH).

Optionally, the second device may be an encoding device, and the third device may be a decoding device.

Optionally, the second device may be a terminal device, and the third device may be another terminal device.

For example, the control information may be in a sidelink control information (sidelink control information, SCI) format 1. The SCI format 1 may indicate the first MCS index by using a modulation and coding scheme field, and may indicate the physical shared channel by using a time resource assignment field and a frequency resource assignment field. The SCI format 1 may be in an SCI format 1-A.

Optionally, the physical shared channel may be a physical sidelink shared channel (physical sidelink shared channel, PSSCH).

Optionally, the second device may be a network device, and the third device may be a terminal device.

Optionally, the control information may indicate the first MCS index and the physical shared channel. For example, the DCI may indicate the first MCS index and the physical shared channel by using a modulation and coding scheme field.

Optionally, the physical shared channel may be a physical downlink shared channel (physical downlink shared channel, PDSCH).

Optionally, S502 includes: The second device sends RRC signaling, and the third device receives the RRC signaling. The RRC signaling includes the indication information. The RRC signaling is used to configure the first MCS index and the physical shared channel. Optionally, configuration information in the RRC signaling indicates the first MCS index and the physical shared channel, and the configuration information may include the indication information.

Optionally, information indicating the first MCS index and information indicating the physical shared channel may be different information.

Optionally, the configuration information in the RRC signaling may further include at least one of SPS-Config, ConfiguredGrantConfig, or SL-ConfiguredGrantConfig.

Optionally, when the second device may be a terminal device, and the third device may be another terminal device, the RRC signaling may be PC5 RRC signaling.

Optionally, the second device and the foregoing first device that determines code rates of *M* component polar code encoders may be a same device or different devices. This is not limited in this embodiment of this application.

Optionally, the third device and the foregoing first device that determines the code rates of the *M* component polar code encoders may be a same device or different devices. This is not limited in this embodiment of this application.

Optionally, the second device may include the foregoing first device that determines the code rates of the *M* component polar code encoders.

Optionally, the third device may include the foregoing first device that determines the code rates of the *M* component polar code encoders.

S503: The second device sends the physical shared channel to the third device, and the third device receives the physical shared channel.

Optionally, the physical shared channel in S503 and the indication information in S502 may be located in a same slot, or a slot in which the physical shared channel in S503 is located is located in any slot after a slot in which the indication information in S502 is located.

It may be understood that the physical shared channel in S503 may be the encoded physical shared channel in S501.

It should be noted that a sequence of S501, S502, and S503 is not limited. For example, in a dynamic scheduling scenario, S501 may be before S502; and for semi-static scheduling, for example, SPS, S502 may be before S501 and/or S503, or performing S502 for one time may be performing S501 for a plurality of times and/or performing S503 for a plurality of times, and performing S501 for one time corresponds to performing S503 for one time.

Optionally, S503 may further include a modulation and demodulation process. To avoid repetition, details are not described.

It should be noted that S503 may be an optional step. This embodiment of this application may not include S503. To be specific, this embodiment of this application mainly describes a manner in which the second device encodes the physical shared channel based on the code rates of the $M$ component polar code encoders that correspond to the first MCS index, and the third device decodes the physical shared channel based on the code rates of the $M$ component polar code encoders that correspond to the first MCS index. Whether the second device sends the physical shared channel may be ignored.

S504: The third device obtains the first MCS index based on the received indication information, and decodes, based on code rates of the $M$ component polar code encoders that correspond to the first MCS index in the MCS table, data carried on the physical shared channel.

Optionally, the information bit may be obtained after decoding in S504.

Optionally, S504 includes: The third device obtains the first MCS index based on the received indication information, and decodes, based on a code rate of each of the $M$ component polar code encoders that corresponds to the first MCS index in the MCS table, the data carried on the physical shared channel.

It should be understood that the indication information in S502 may indicate a plurality of physical shared channels. For example, indication information, for example, a modulation and coding scheme field, included in one piece of control information may indicate to encode data carried on the plurality of physical shared channels, and the physical shared channels may be on adjacent or non-adjacent time units, for example, slots, symbols, or subframes. In other words, one piece of indication information in S502 may indicate to encode the data carried on the plurality of physical shared channels in S503. For example, DCI scrambled by one CS-RNTI may activate semi-static scheduling, for example, semi-persistent scheduling. To be specific, within a transmission time period, one time of existence of the indication information and the corresponding control information in S502 may indicate to encode data carried on physical shared channels at a plurality of different transmission moments, and a transmission time interval of the physical shared channels is configured by using RRC signaling. For another example, during dynamic scheduling, one piece of indication information may indicate to encode data carried on a plurality of physical shared channels.

Optionally, the information bit in S504 may be the information bit of each CB.

A principle in which the third device decodes, based on the code rates of the $M$ component polar code encoders that correspond to the first MCS index, the data carried on the physical shared channel is an inverse process of a principle in which the second device performs encoding. To avoid repetition, details are not described.

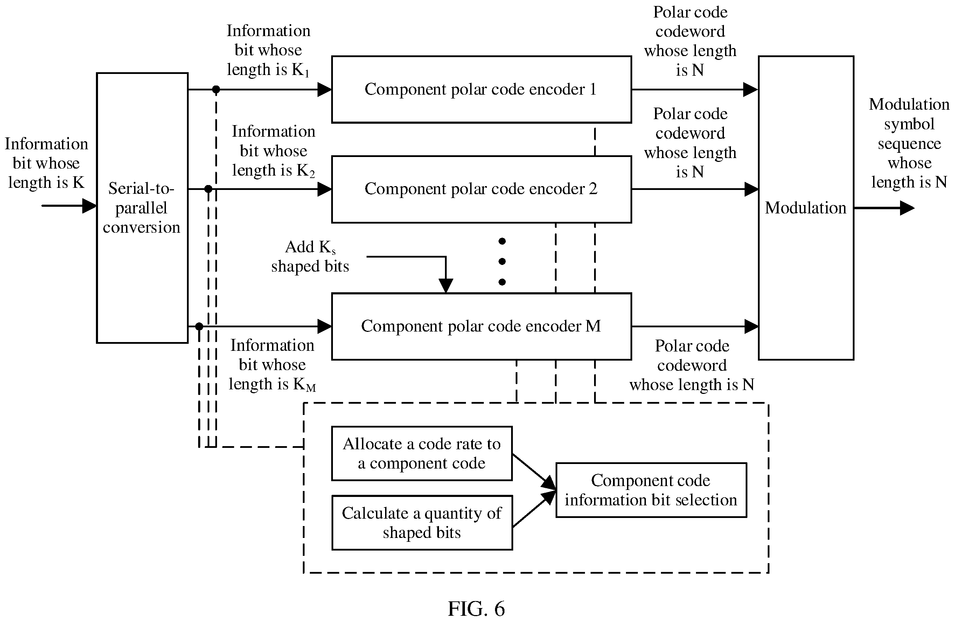

The following describes a schematic diagram of a process of performing encoding by using a component polar code encoder in an MCS table. For example, the process may be a process of encoding a CB by a third device in the method 400, or may be a process of encoding a CB by a network device in the method 500. FIG. 6 is a schematic diagram of a process in which an encoding device performs encoding by using $M$ component polar code encoders. In FIG. 6, a polar code encoder includes $M$ component polar code encoders. An encoding device obtains a first MCS index, determines a modulation order $G$ corresponding to the first MCS index, total spectral efficiency $R_T + J \cdot R_S$ corresponding to the first MCS index, code rates $R_1$, $R_2$, ..., and $R_M$ of $M$ component polar code encoders that correspond to the first MCS index, and a code rate $R_S$ of a shaped bit of an $M^{\text{th}}$ component polar code encoder based on the MCS table. The encoding device determines second spectral efficiency of the shaped bit based on $J \cdot R_S$. Herein, $J$ is a quantity of dimensions of constellation modulation corresponding to the MCS table. For example, if a modulation scheme corresponding to the MCS table is two-dimensional constellation modulation, a value of $J$ is 2; or if a modulation scheme corresponding to the MCS table is one-dimensional constellation modulation, a value of $J$ is 1. The encoding device determines first spectral efficiency $R_T$ of an information bit by subtracting the spectral efficiency of the shaped bit $J \cdot R_S$ from the total spectral efficiency $R_T + J \cdot R_S$. The encoding device determines a target code rate $R = R_T / G$ based on the modulation order $G$ corresponding to the first MCS index and the first spectral efficiency $R_T$ of the information bit. The encoding device determines total information bits $K = M \cdot N \cdot R = (M \cdot N \cdot R_T)/G$ corresponding to the $M$ component polar code encoders based on the target code rate. The encoding device determines, based on the code rates $R_1$, $R_2$, ..., and $R_M$ of the $M$ component polar code encoders and a code length $N$ of each component polar code encoder, that quantities of information bits of all component polar code encoders are $K_1 = R_1 \cdot N$, $K_2 = R_2 \cdot N$, ..., and $K_M = R_M \cdot N$. The encoding device determines a quantity $K_S = R_S \cdot N$ of shaped bits in an $M^{\text{th}}$ component polar code encoder based on the code rate $R_S$ of the shaped bit and a code length $N$ of the $M^{th}$ component polar code encoder. Therefore, sizes of information bit sets of first $M$-1 component polar code encoders are $|A_1| = K_1$, $|A_2| = K_2$, ..., and $|A_{M-1}| = K_{m-1}$, and a size of an information bit set of a last component polar code encoder (that is, the $M^{\text{th}}$ component polar code encoder) is $|A_M| = K_M + K_S$. To be specific, a $1^{\text{st}}$ component polar code encoder needs to use $K_1$ bit positions to carry $K_1$ information bits, a $2^{\text{nd}}$ component polar code encoder needs to use $K_2$ bit positions to carry $K_2$ information bits, ..., an $(M\text{-}1)^{\text{th}}$ component polar code encoder needs to use $K_{M-1}$ bit positions to carry $K_{M-1}$ information bits, and an $M^{\text{th}}$ component polar code encoder needs to use $K_M + K_S$ bit positions to carry $K_M$ information bits and $K_S$ shaped bits. The encoding device may determine an information bit set $A_1$ of the 1st component polar code encoder, an information bit set $A_2$ of the 2nd component polar code encoder, ..., and an information bit set $A_{M-1}$ of the $(M-1)^{th}$ component polar code encoder based on the code length $N$ of each component polar code encoder and a reliability order table of polar codes. For example, a reliability order of a polar code may be obtained through measurement based on a polarization weight (polarization weight, PW). Specifically, the encoding device may determine that $K_1$ bit positions with highest reliability carry $K_1$ information bits, determine that $K_2$ bit positions with highest reliability carry $K_2$ information bits, ..., and determine that $K_M + K_S$ bit positions with highest reliability carry $K_M + K_S$ information bits.

Optionally, the encoding device may determine, based on reliability of a polar subchannel, a position that carries an information bit in each component polar code encoder. For example, if a length of a codeword sequence of one component polar code encoder is $N$, the component polar code encoder corresponds to $N$ polar subchannels, and the encoding device determines, from reliability corresponding to the $N$ polar subchannels, that a polar subchannel with highest reliability carries an information bit. Specifically, a polar sequence $Q_0^{N_{max}-1} = \{Q_0^{N_{max}}, Q_1^{N_{max}}, \cdots, Q_{N_{max}-1}^{N_{max}}\}$ is sorted in ascending manner of the reliability of the polar subchannels. Herein, $N_{max}$ is a length of the polar sequence or a quantity of polar subchannels. For example, if the length of the polar sequence in 5G is 1024, $N_{max}$ is 1024. To be

specific, $W(Q_0^{N_{max}}) < W(Q_1^{N_{max}}) < \cdots < W(Q_{N_{max}-1}^{N_{max}})$. Herein, $W(Q_i^{N_{max}})$ represents reliability of a $(Q_i^{N_{max}})^{th}$

polar subchannel. In other words, $Q_i^{N_{max}}$ may be understood as a channel number of the polar subchannel. For a component polar code encoder whose code length is $N$, a reliability order

$Q_0^{N-1} = \{Q_0^N, Q_1^N, Q_2^N, \cdots, Q_{N-1}^N\} = \{Q_i^{N_{mac}} | Q_i^{N_{mac}} < N\}$ may be obtained by querying reliability orders of the N polar subchannels. Herein, $Q_0^{N-1} \in Q_0^{N_{max}-1}$. Because sizes of information bit sets of first $M$-1 component polar code encoders are $|A_1| = K_1$, $|A_2| = K_2$, ..., and $|A_{M-1}| = K_{M-1}$, the encoding device may determine an information bit set

$A_m = \{Q_j^N | j \geq N - K_m\}$ based on the sizes $|A_m| = K_m$ of the information bit sets of the first $M$-1 component polar code encoders and the reliability order $Q_0^{N-1}$. Herein, $m \in [1, \cdots, M-1]$. The encoding device determines an information bit set $A_M = \{Q_j^N | j \geq N - K_M - K_S\}$ based on a size of an information bit set $|A_M| = K_M + K_S$ of the $M^{th}$ component polar code encoder and the reliability order $Q_0^{N-1}$. For example, Table 4 is a reliability order table of a polar sequence whose length is 1024 in 5G. The reliability order of the polar sequence may be reliability orders of 1024 polar subchannels.

For example, when $M$ is 2, $N$ is 8, $K_1$ is 3, $K_2$ is 2, and $K_S$ is 2, $Q_0^7 = \{0,1,2,4,3,5,6,7\}$ and

$A_1 = \{Q_j^N | j \geq N - K_1 = 5\} = \{Q_5^N, Q_6^N, Q_7^N\} = \{5,6,7\}$. To be specific, a 5th bit, a 6th bit, and a 7th bit of a 1st component polar code encoder carry information bits of the 1st component polar code encoder, and

$A_2 = \{Q_j^N | j \geq N - K_2 - K_S = 4\} = \{Q_4^N, Q_5^N, Q_6^N, Q_7^N\} = \{3,5,6,7\}$. To be specific, a 3rd bit, a 5th bit, a 6th bit, and a 7th bit of a 2nd component polar code encoder carry information bits and shaped bits of the 2nd component polar code encoder.

**Table 4**

| $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ |
|---|---|---|---|---|---|---|---|---|---|---|---|---|---|---|---|
| 0 | 0 | 128 | 518 | 256 | 94 | 384 | 214 | 512 | 364 | 640 | 414 | 768 | 819 | 896 | 966 |
| 1 | 1 | 129 | 54 | 257 | 204 | 385 | 309 | 513 | 654 | 641 | 223 | 769 | 814 | 897 | 755 |
| 2 | 2 | 130 | 83 | 258 | 298 | 386 | 188 | 514 | 659 | 642 | 663 | 770 | 439 | 898 | 859 |
| 3 | 4 | 131 | 57 | 259 | 400 | 387 | 449 | 515 | 335 | 643 | 692 | 771 | 929 | 899 | 940 |
| 5 | 16 | 133 | 112 | 261 | 352 | 389 | 408 | 517 | 315 | 645 | 619 | 773 | 623 | 901 | 911 |
| 6 | 32 | 134 | 135 | 262 | 325 | 390 | 609 | 518 | 221 | 646 | 472 | 774 | 671 | 902 | 871 |
| 7 | 3 | 135 | 78 | 263 | 533 | 391 | 596 | 519 | 370 | 647 | 455 | 775 | 739 | 903 | 639 |
| 8 | 5 | 136 | 289 | 264 | 155 | 392 | 551 | 520 | 613 | 648 | 796 | 776 | 916 | 904 | 888 |
| 9 | 64 | 137 | 194 | 265 | 210 | 393 | 650 | 521 | 422 | 649 | 809 | 777 | 463 | 905 | 479 |
| 10 | 9 | 138 | 85 | 266 | 305 | 394 | 229 | 522 | 425 | 650 | 714 | 778 | 843 | 906 | 946 |
| 11 | 6 | 139 | 276 | 267 | 547 | 395 | 159 | 523 | 451 | 651 | 721 | 779 | 381 | 907 | 750 |
| 12 | 17 | 140 | 522 | 268 | 300 | 396 | 420 | 524 | 614 | 652 | 837 | 780 | 497 | 908 | 969 |
| 13 | 10 | 141 | 58 | 269 | 109 | 397 | 310 | 525 | 543 | 653 | 716 | 781 | 930 | 909 | 508 |
| 14 | 18 | 142 | 168 | 270 | 184 | 398 | 541 | 526 | 235 | 654 | 864 | 782 | 821 | 910 | 861 |
| 15 | 128 | 143 | 139 | 271 | 534 | 399 | 773 | 527 | 412 | 655 | 810 | 783 | 726 | 911 | 757 |
| 16 | 12 | 144 | 99 | 272 | 537 | 400 | 610 | 528 | 343 | 656 | 606 | 784 | 961 | 912 | 970 |
| 17 | 33 | 145 | 86 | 273 | 115 | 401 | 657 | 529 | 372 | 657 | 912 | 785 | 872 | 913 | 919 |
| 18 | 65 | 146 | 60 | 274 | 167 | 402 | 333 | 530 | 775 | 658 | 722 | 786 | 492 | 914 | 875 |
| 19 | 20 | 147 | 280 | 275 | 225 | 403 | 119 | 531 | 317 | 659 | 696 | 787 | 631 | 915 | 862 |
| 20 | 256 | 148 | 89 | 276 | 326 | 404 | 600 | 532 | 222 | 660 | 377 | 788 | 729 | 916 | 758 |
| 21 | 34 | 149 | 290 | 277 | 306 | 405 | 339 | 533 | 426 | 661 | 435 | 789 | 700 | 917 | 948 |
| 22 | 24 | 150 | 529 | 278 | 772 | 406 | 218 | 534 | 453 | 662 | 817 | 790 | 443 | 918 | 977 |
| 23 | 36 | 151 | 524 | 279 | 157 | 407 | 368 | 535 | 237 | 663 | 319 | 791 | 741 | 919 | 923 |
| 24 | 7 | 152 | 196 | 280 | 656 | 408 | 652 | 536 | 559 | 664 | 621 | 792 | 845 | 920 | 972 |
| 25 | 129 | 153 | 141 | 281 | 329 | 409 | 230 | 537 | 833 | 665 | 812 | 793 | 920 | 921 | 761 |

(continued)

| $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ |
|---|---|---|---|---|---|---|---|---|---|---|---|---|---|---|---|
| 26 | 66 | 154 | 101 | 282 | 110 | 410 | 391 | 538 | 804 | 666 | 484 | 794 | 382 | 922 | 877 |
| 27 | 512 | 155 | 147 | 283 | 117 | 411 | 313 | 539 | 712 | 667 | 430 | 795 | 822 | 923 | 952 |
| 28 | 11 | 156 | 176 | 284 | 212 | 412 | 450 | 540 | 834 | 668 | 838 | 796 | 851 | 924 | 495 |
| 29 | 40 | 157 | 142 | 285 | 171 | 413 | 542 | 541 | 661 | 669 | 667 | 797 | 730 | 925 | 703 |
| 30 | 68 | 158 | 530 | 286 | 776 | 414 | 334 | 542 | 808 | 670 | 488 | 798 | 498 | 926 | 935 |
| 31 | 130 | 159 | 321 | 287 | 330 | 415 | 233 | 543 | 779 | 671 | 239 | 799 | 880 | 927 | 978 |
| 32 | 19 | 160 | 31 | 288 | 226 | 416 | 555 | 544 | 617 | 672 | 378 | 800 | 742 | 928 | 883 |
| 33 | 13 | 161 | 200 | 289 | 549 | 417 | 774 | 545 | 604 | 673 | 459 | 801 | 445 | 929 | 762 |
| 34 | 48 | 162 | 90 | 290 | 538 | 418 | 175 | 546 | 433 | 674 | 622 | 802 | 471 | 930 | 503 |
| 35 | 14 | 163 | 545 | 291 | 387 | 419 | 123 | 547 | 720 | 675 | 627 | 803 | 635 | 931 | 925 |
| 36 | 72 | 164 | 292 | 292 | 308 | 420 | 658 | 548 | 816 | 676 | 437 | 804 | 932 | 932 | 878 |
| 37 | 257 | 165 | 322 | 293 | 216 | 421 | 612 | 549 | 836 | 677 | 380 | 805 | 687 | 933 | 735 |
| 38 | 21 | 166 | 532 | 294 | 416 | 422 | 341 | 550 | 347 | 678 | 818 | 806 | 903 | 934 | 993 |
| 39 | 132 | 167 | 263 | 295 | 271 | 423 | 777 | 551 | 897 | 679 | 461 | 807 | 825 | 935 | 885 |
| 40 | 35 | 168 | 149 | 296 | 279 | 424 | 220 | 552 | 243 | 680 | 496 | 808 | 500 | 936 | 939 |
| 41 | 258 | 169 | 102 | 297 | 158 | 425 | 314 | 553 | 662 | 681 | 669 | 809 | 846 | 937 | 994 |
| 42 | 26 | 170 | 105 | 298 | 337 | 426 | 424 | 554 | 454 | 682 | 679 | 810 | 745 | 938 | 980 |
| 43 | 513 | 171 | 304 | 299 | 550 | 427 | 395 | 555 | 318 | 683 | 724 | 811 | 826 | 939 | 926 |
| 44 | 80 | 172 | 296 | 300 | 672 | 428 | 673 | 556 | 675 | 684 | 841 | 812 | 732 | 940 | 764 |
| 45 | 37 | 173 | 163 | 301 | 118 | 429 | 583 | 557 | 618 | 685 | 629 | 813 | 446 | 941 | 941 |
| 46 | 25 | 174 | 92 | 302 | 332 | 430 | 355 | 558 | 898 | 686 | 351 | 814 | 962 | 942 | 967 |
| 47 | 22 | 175 | 47 | 303 | 579 | 431 | 287 | 559 | 781 | 687 | 467 | 815 | 936 | 943 | 886 |
| 48 | 136 | 176 | 267 | 304 | 540 | 432 | 183 | 560 | 376 | 688 | 438 | 816 | 475 | 944 | 831 |
| 49 | 260 | 177 | 385 | 305 | 389 | 433 | 234 | 561 | 428 | 689 | 737 | 817 | 853 | 945 | 947 |
| 50 | 264 | 178 | 546 | 306 | 173 | 434 | 125 | 562 | 665 | 690 | 251 | 818 | 867 | 946 | 507 |

| $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ |
|---|---|---|---|---|---|---|---|---|---|---|---|---|---|---|---|
| 51 | 38 | 179 | 324 | 307 | 121 | 435 | 557 | 563 | 736 | 691 | 462 | 819 | 637 | 947 | 889 |
| 52 | 514 | 180 | 208 | 308 | 553 | 436 | 660 | 564 | 567 | 692 | 442 | 820 | 907 | 948 | 984 |
| 53 | 96 | 181 | 386 | 309 | 199 | 437 | 616 | 565 | 840 | 693 | 441 | 821 | 487 | 949 | 751 |
| 54 | 67 | 182 | 150 | 310 | 784 | 438 | 342 | 566 | 625 | 694 | 469 | 822 | 695 | 950 | 942 |
| 55 | 41 | 183 | 153 | 311 | 179 | 439 | 316 | 567 | 238 | 695 | 247 | 823 | 746 | 951 | 996 |
| 56 | 144 | 184 | 165 | 312 | 228 | 440 | 241 | 568 | 359 | 696 | 683 | 824 | 828 | 952 | 971 |
| 57 | 28 | 185 | 106 | 313 | 338 | 441 | 778 | 569 | 457 | 697 | 842 | 825 | 753 | 953 | 890 |
| 58 | 69 | 186 | 55 | 314 | 312 | 442 | 563 | 570 | 399 | 698 | 738 | 826 | 854 | 954 | 509 |
| 59 | 42 | 187 | 328 | 315 | 704 | 443 | 345 | 571 | 787 | 699 | 899 | 827 | 857 | 955 | 949 |
| 60 | 516 | 188 | 536 | 316 | 390 | 444 | 452 | 572 | 591 | 700 | 670 | 828 | 504 | 956 | 973 |
| 61 | 49 | 189 | 577 | 317 | 174 | 445 | 397 | 573 | 678 | 701 | 783 | 829 | 799 | 957 | 1000 |
| 62 | 74 | 190 | 548 | 318 | 554 | 446 | 403 | 574 | 434 | 702 | 849 | 830 | 255 | 958 | 892 |
| 63 | 272 | 191 | 113 | 319 | 581 | 447 | 207 | 575 | 677 | 703 | 820 | 831 | 964 | 959 | 950 |
| 64 | 160 | 192 | 154 | 320 | 393 | 448 | 674 | 576 | 349 | 704 | 728 | 832 | 909 | 960 | 863 |
| 65 | 520 | 193 | 79 | 321 | 283 | 449 | 558 | 577 | 245 | 705 | 928 | 833 | 719 | 961 | 759 |
| 66 | 288 | 194 | 269 | 322 | 122 | 450 | 785 | 578 | 458 | 706 | 791 | 834 | 477 | 962 | 1008 |
| 67 | 528 | 195 | 108 | 323 | 448 | 451 | 432 | 579 | 666 | 707 | 367 | 835 | 915 | 963 | 510 |
| 68 | 192 | 196 | 578 | 324 | 353 | 452 | 357 | 580 | 620 | 708 | 901 | 836 | 638 | 964 | 979 |
| 69 | 544 | 197 | 224 | 325 | 561 | 453 | 187 | 581 | 363 | 709 | 630 | 837 | 748 | 965 | 953 |
| 70 | 70 | 198 | 166 | 326 | 203 | 454 | 236 | 582 | 127 | 710 | 685 | 838 | 944 | 966 | 763 |
| 71 | 44 | 199 | 519 | 327 | 63 | 455 | 664 | 583 | 191 | 711 | 844 | 839 | 869 | 967 | 974 |
| 72 | 131 | 200 | 552 | 328 | 340 | 456 | 624 | 584 | 782 | 712 | 633 | 840 | 491 | 968 | 954 |
| 73 | 81 | 201 | 195 | 329 | 394 | 457 | 587 | 585 | 407 | 713 | 711 | 841 | 699 | 969 | 879 |
| 74 | 50 | 202 | 270 | 330 | 527 | 458 | 780 | 586 | 436 | 714 | 253 | 842 | 754 | 970 | 981 |
| 75 | 73 | 203 | 641 | 331 | 582 | 459 | 705 | 587 | 626 | 715 | 691 | 843 | 858 | 971 | 982 |

(continued)

| $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ |
|---|---|---|---|---|---|---|---|---|---|---|---|---|---|---|---|
| 76 | 15 | 204 | 523 | 332 | 556 | 460 | 126 | 588 | 571 | 716 | 824 | 844 | 478 | 972 | 927 |
| 77 | 320 | 205 | 275 | 333 | 181 | 461 | 242 | 589 | 465 | 717 | 902 | 845 | 968 | 973 | 995 |
| 78 | 133 | 206 | 580 | 334 | 295 | 462 | 565 | 590 | 681 | 718 | 686 | 846 | 383 | 974 | 765 |
| 79 | 52 | 207 | 291 | 335 | 285 | 463 | 398 | 591 | 246 | 719 | 740 | 847 | 910 | 975 | 956 |
| 80 | 23 | 208 | 59 | 336 | 232 | 464 | 346 | 592 | 707 | 720 | 850 | 848 | 815 | 976 | 887 |
| 81 | 134 | 209 | 169 | 337 | 124 | 465 | 456 | 593 | 350 | 721 | 375 | 849 | 976 | 977 | 985 |
| 82 | 384 | 210 | 560 | 338 | 205 | 466 | 358 | 594 | 599 | 722 | 444 | 850 | 870 | 978 | 997 |
| 83 | 76 | 211 | 114 | 339 | 182 | 467 | 405 | 595 | 668 | 723 | 470 | 851 | 917 | 979 | 986 |
| 84 | 137 | 212 | 277 | 340 | 643 | 468 | 303 | 596 | 790 | 724 | 483 | 852 | 727 | 980 | 943 |
| 85 | 82 | 213 | 156 | 341 | 562 | 469 | 569 | 597 | 460 | 725 | 415 | 853 | 493 | 981 | 891 |
| 86 | 56 | 214 | 87 | 342 | 286 | 470 | 244 | 598 | 249 | 726 | 485 | 854 | 873 | 982 | 998 |
| 87 | 27 | 215 | 197 | 343 | 585 | 471 | 595 | 599 | 682 | 727 | 905 | 855 | 701 | 983 | 766 |
| 88 | 97 | 216 | 116 | 344 | 299 | 472 | 189 | 600 | 573 | 728 | 795 | 856 | 931 | 984 | 511 |
| 89 | 39 | 217 | 170 | 345 | 354 | 473 | 566 | 601 | 411 | 729 | 473 | 857 | 756 | 985 | 988 |
| 90 | 259 | 218 | 61 | 346 | 211 | 474 | 676 | 602 | 803 | 730 | 634 | 858 | 860 | 986 | 1001 |
| 91 | 84 | 219 | 531 | 347 | 401 | 475 | 361 | 603 | 789 | 731 | 744 | 859 | 499 | 987 | 951 |
| 92 | 138 | 220 | 525 | 348 | 185 | 476 | 706 | 604 | 709 | 732 | 852 | 860 | 731 | 988 | 1002 |
| 93 | 145 | 221 | 642 | 349 | 396 | 477 | 589 | 605 | 365 | 733 | 960 | 861 | 823 | 989 | 893 |
| 94 | 261 | 222 | 281 | 350 | 344 | 478 | 215 | 606 | 440 | 734 | 865 | 862 | 922 | 990 | 975 |
| 95 | 29 | 223 | 278 | 351 | 586 | 479 | 786 | 607 | 628 | 735 | 693 | 863 | 874 | 991 | 894 |
| 96 | 43 | 224 | 526 | 352 | 645 | 480 | 647 | 608 | 689 | 736 | 797 | 864 | 918 | 992 | 1009 |
| 97 | 98 | 225 | 177 | 353 | 593 | 481 | 348 | 609 | 374 | 737 | 906 | 865 | 502 | 993 | 955 |
| 98 | 515 | 226 | 293 | 354 | 535 | 482 | 419 | 610 | 423 | 738 | 715 | 866 | 933 | 994 | 1004 |
| 99 | 88 | 227 | 388 | 355 | 240 | 483 | 406 | 611 | 466 | 739 | 807 | 867 | 743 | 995 | 1010 |
| 100 | 140 | 228 | 91 | 356 | 206 | 484 | 464 | 612 | 793 | 740 | 474 | 868 | 760 | 996 | 957 |

(continued)

| $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ |
|---|---|---|---|---|---|---|---|---|---|---|---|---|---|---|---|
| 101 | 30 | 229 | 584 | 357 | 95 | 485 | 680 | 613 | 250 | 741 | 636 | 869 | 881 | 997 | 983 |
| 102 | 146 | 230 | 769 | 358 | 327 | 486 | 801 | 614 | 371 | 742 | 694 | 870 | 494 | 998 | 958 |
| 103 | 71 | 231 | 198 | 359 | 564 | 487 | 362 | 615 | 481 | 743 | 254 | 871 | 702 | 999 | 987 |
| 104 | 262 | 232 | 172 | 360 | 800 | 488 | 590 | 616 | 574 | 744 | 717 | 872 | 921 | 1000 | 1012 |
| 105 | 265 | 233 | 120 | 361 | 402 | 489 | 409 | 617 | 413 | 745 | 575 | 873 | 501 | 1001 | 999 |
| 106 | 161 | 234 | 201 | 362 | 356 | 490 | 570 | 618 | 603 | 746 | 913 | 874 | 876 | 1002 | 1016 |
| 107 | 576 | 235 | 336 | 363 | 307 | 491 | 788 | 619 | 366 | 747 | 798 | 875 | 847 | 1003 | 767 |
| 108 | 45 | 236 | 62 | 364 | 301 | 492 | 597 | 620 | 468 | 748 | 811 | 876 | 992 | 1004 | 989 |
| 109 | 100 | 237 | 282 | 365 | 417 | 493 | 572 | 621 | 655 | 749 | 379 | 877 | 447 | 1005 | 1003 |
| 110 | 640 | 238 | 143 | 366 | 213 | 494 | 219 | 622 | 900 | 750 | 697 | 878 | 733 | 1006 | 990 |
| 111 | 51 | 239 | 103 | 367 | 568 | 495 | 311 | 623 | 805 | 751 | 431 | 879 | 827 | 1007 | 1005 |
| 112 | 148 | 240 | 178 | 368 | 832 | 496 | 708 | 624 | 615 | 752 | 607 | 880 | 934 | 1008 | 959 |
| 113 | 46 | 241 | 294 | 369 | 588 | 497 | 598 | 625 | 684 | 753 | 489 | 881 | 882 | 1009 | 1011 |
| 114 | 75 | 242 | 93 | 370 | 186 | 498 | 601 | 626 | 710 | 754 | 866 | 882 | 937 | 1010 | 1013 |
| 115 | 266 | 243 | 644 | 371 | 646 | 499 | 651 | 627 | 429 | 755 | 723 | 883 | 963 | 1011 | 895 |
| 116 | 273 | 244 | 202 | 372 | 404 | 500 | 421 | 628 | 794 | 756 | 486 | 884 | 747 | 1012 | 1006 |
| 117 | 517 | 245 | 592 | 373 | 227 | 501 | 792 | 629 | 252 | 757 | 908 | 885 | 505 | 1013 | 1014 |
| 118 | 104 | 246 | 323 | 374 | 896 | 502 | 802 | 630 | 373 | 758 | 718 | 886 | 855 | 1014 | 1017 |
| 119 | 162 | 247 | 392 | 375 | 594 | 503 | 611 | 631 | 605 | 759 | 813 | 887 | 924 | 1015 | 1018 |
| 120 | 53 | 248 | 297 | 376 | 418 | 504 | 602 | 632 | 848 | 760 | 476 | 888 | 734 | 1016 | 991 |
| 121 | 193 | 249 | 770 | 377 | 302 | 505 | 410 | 633 | 690 | 761 | 856 | 889 | 829 | 1017 | 1020 |
| 122 | 152 | 250 | 107 | 378 | 649 | 506 | 231 | 634 | 713 | 762 | 839 | 890 | 965 | 1018 | 1007 |
| 123 | 77 | 251 | 180 | 379 | 771 | 507 | 688 | 635 | 632 | 763 | 725 | 891 | 938 | 1019 | 1015 |
| 124 | 164 | 252 | 151 | 380 | 360 | 508 | 653 | 636 | 482 | 764 | 698 | 892 | 884 | 1020 | 1019 |
| 125 | 768 | 253 | 209 | 381 | 539 | 509 | 248 | 637 | 806 | 765 | 914 | 893 | 506 | 1021 | 1021 |

(continued)

| $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ | $W(Q_i^{N_{max}})$ | $Q_i^{N_{max}}$ |
|---|---|---|---|---|---|---|---|---|---|---|---|---|---|---|---|
| 126 | 268 | 254 | 284 | 382 | 111 | 510 | 369 | 638 | 427 | 766 | 752 | 894 | 749 | 1022 | 1022 |
| 127 | 274 | 255 | 648 | 383 | 331 | 511 | 190 | 639 | 904 | 767 | 868 | 895 | 945 | 1023 | 1023 |

For example, the first MCS index is 14 in Table 2, a quantity of output symbols is 256, a corresponding modulation order when the MCS index is 14 is 6, and a modulation scheme is 64QAM. Because two paths of I/Q are independent and each path represents two bits in 64QAM, 6/2=3 component polar code encoders whose code length is 512 may be used. Because each symbol occupies 6 bits, 256 symbols occupy a total of 256*6=1536 bits. Therefore, a code length $N$ of each component polar code encoder is 1536/3=512. Corresponding spectral efficiency when the MCS index 14 is 3.6094. Therefore, a sum of a quantity of total information bits and a quantity of shaped bits corresponding to the $M$ component polar code encoders needs to be 256*3.6094≈924. Because a case in which the MCS index is 14 in Table 2 corresponds to $R_1$ = 0.0732, a quantity of information bits of the 1st component polar code encoder is $K_1 = N \cdot R_1$ = 512·0.0732 ≈ 37 . Because a case in which the MCS index is 14 in Table 2 corresponds to $R_2$ = 0.7354, a quantity of information bits of the 2nd component polar code encoder is $K_2 = N \cdot R_2$ = 512·0.7354 ≈ 377. Because a case in which the MCS index is 14 in Table 2 corresponds to $R_3$ = 0.7266, a quantity of information bits of the 3rd component polar code encoder is $K_3 = N \cdot R_3$ = 512·0.7266 ≈ 372. Because a case in which the MCS index is 14 in Table 2 corresponds to $R_S$ = 0.2695 , the quantity of information bits of the 3rd component polar code encoder is $K_S = N \cdot R_S$ = 512 - 0.2695 ≈ 138 . Herein, 138+372+377+37=924. Therefore, a size of the information bit set of the 1st component polar code encoder is | $A_1$ |= 37, a size of the information bit set of the 2nd component polar code encoder is | $A_2$ |= 377, and a size of the information bit set of the 3rd component polar code encoder is | $A_3$ |= $K_3 + K_S$ = 372 + 138 = 510 .

For another example, the first MCS index is 5 in Table 2, a quantity of output symbols is 256, a corresponding modulation order when the MCS index is 5 is 4, and a modulation scheme is 16 quadrature amplitude modulation (quadrature amplitude modulation, QAM) Because two paths of I/Q are independent and each path represents two bits in 16QAM, 4/2=2 component polar code encoders whose code length is 512 may be used. In other words, each symbol occupies 4 bits, 256 symbols occupy a total of 256*4=1024 bits. Therefore, a code length $N$ of each component polar code encoder is 1024/2=512. Corresponding total spectral efficiency when the MCS index 5 is 1.4727. Therefore, a sum of a quantity of total information bits and a quantity of shaped bits corresponding to the $M$ component polar code encoders is 256*1.4727≈377. Because a case in which the MCS index is 5 in Table 2 corresponds to $R_1$ = 0.0449, a quantity of information bits of the 1st component polar code encoder is $K_1 = N \cdot R_1$ = 512·0.0449 ≈ 23. Because a case in which the MCS index is 5 in Table 2 corresponds to R2 = 0.4199 , a quantity of information bits of the 2nd component polar code encoder is $K_2 = N \cdot R_2$ = 512·0.4199 ≈ 215. Because a case in which the MCS index is 5 in Table 2 corresponds to $R_S$ = 0.2715 , the quantity of information bits of the 2nd component polar code encoder is $K_S = N \cdot R_S$ = 512·0.2715 ≈ 139. Herein, 23+215+139=377. Therefore, a size of the information bit set of the 1st component polar code encoder is | $A_1$ |= 23, and a size of the information bit set of the 2nd component polar code encoder is | $A_2$ |= $K_2 + K_S$ =215+139 =354.

As shown in FIG. 6, the encoding device determines the code rate of each component polar code encoder based on the code rate in the MCS table, that is, allocation of a code rate to a component code in FIG. 6. The encoding device determines, based on the code rate of each component polar code encoder, that sizes of information bit sets of the $M$ component polar code encoders are $K_1$, $K_2$, ..., and $K_M$. The encoding device divides information bits with a length of $K$ into $M$ sub-streams through serial-to-parallel conversion. Sizes of information bits of the $M$ sub-streams are $K_1$, $K_2$, ..., and $K_M$. The encoding device calculates the quantity $K_S$ of shaped bits in the foregoing method (that is, calculation of the quantity of shaped bits in FIG. 6). After obtaining a size of an information bit set of each component polar code encoder in the foregoing method, the encoding device may obtain each information bit set based on the reliability order of the polar sequence (that is, component code information bit selection in FIG. 6). The encoding device may perform encoding in the first $M$-1 component polar code encoders based on a generation matrix $\mathbf{G_N}$, to obtain a codeword sequence whose length is $N$ . The encoding device needs to calculate a value of the shaped bit of the $M$ th component polar code encoder. In other words, the calculated $K_S$ is the quantity of shaped bits. Specifically, the encoding device calculates a value of $K_S$ shaped bits may include: The encoding device determines, based on first $M$-1 output codeword sequences $\mathbf{c_m}$ ($1 \le m \le M$ -1) and a Maxwell-Boltzmann parameter $v$, a bit-likelihood ratio of a codeword sequence $\mathbf{c}_M$ output by the $M$ th component polar code encoder; and the encoding device performs successive cancellation (successive cancellation, SC) decoding based on the quantity $K_S$ of shaped bits and the bit likelihood ratio of the codeword sequence $\mathbf{c}_M$, to obtain the value of the shaped bits and the encoded codeword sequence $\mathbf{c}_M$. Alternatively, the encoding device performs successive cancellation list (successive cancellation list, SCL) decoding based on the quantity $K_S$ of shaped bits and the bit likelihood ratio of the codeword sequence $\mathbf{c}_M$, to obtain the value of the shaped bits and the encoded codeword sequence $\mathbf{c}_M$.

For example, a log-likelihood ratio $\Lambda_{M,j}$ of $\mathbf{c}_M$ satisfies Formula (19).

$$\Lambda_{M,j} = \log \frac{p(\mathbf{c}_{M,j} = 0)}{p(\mathbf{c}_{M,j} = 1)} = \log \frac{p(\varphi(\mathbf{c}_{1,j}, \cdots, \mathbf{c}_{M-1,j}, 0))}{p(\varphi(\mathbf{c}_{1,j}, \cdots, \mathbf{c}_{M-1,j}, 1))} \qquad (19)$$

Herein, $\mathbf{c}_{M,j}$ represents a $j$th bit of a codeword $\mathbf{c}_m$, $1 \le m \le M$ -1 , $\Lambda_{M,j}$ represents a value likelihood ratio of $\mathbf{c}_{M,j}$, $\varphi$ represents an SP mapping, $\varphi(\mathbf{c}_{1,j}, \cdots, \mathbf{c}_{M-1,j}, 0)$ represents a value of a constellation point of an $M$ -dimensional bit vector

**EP 4 451 586 A1**

$\mathbf{c}_{1,j}, \cdots, \mathbf{c}_{M-1,j}, 0$ in a case of SP mapping, and $\varphi(\mathbf{c}_{1,j}, \cdots, \mathbf{c}_{M-1,j}, 1)$ represents a value of a constellation point of an $M$-dimensional bit vector $\mathbf{c}_{1,j}, \cdots, \mathbf{c}_{M-1,j}, 1$ in a case of SP mapping.

Optionally, the encoding device may obtain $J$ bits based on a codeword sequence $\mathbf{c_m}$ ($1 \le m \le M$) output by each of the $M$ component polar code encoders, to form a $G$-dimensional bit vector. Herein, $J = G/M$. Because the code length of each component polar code encoder is $N$, a total of $N$ $G$-dimensional bit vectors may be obtained. Each $G$-dimensional bit vector is mapped onto one modulation symbol based on a mapping rule, and finally $N$ modulation symbol sequences are obtained for sending. For example, $G = M$. If a codeword sequence output by a component polar code encoder 1 is $\{a_1^1, a_1^2, \cdots, a_1^N\}$, a codeword sequence output by a component polar code encoder 2 is $\{a_2^1, a_2^2, \cdots, a_2^N\}$, and an $N$-bit codeword sequence output by a component polar code encoder $M$ is $\{a_M^1, a_M^2, \cdots, a_M^N\}$, in a modulation process, $N$ formed sequences whose lengths are $M$ are $\{a_1^1, a_2^1, \cdots, a_M^1\}$, $\{a_1^2, a_2^2, \cdots, a_M^2\}$, ... , and $\{a_1^N, a_2^N, \cdots, a_M^N\}$, and then the $N$ bit sequences are respectively mapped onto a modulation symbol sequence with a length of $N$ for sending.

The foregoing describes a principle in which an encoding device encodes and sends a modulation symbol. On a decoding device side, a principle in which a decoding device performs decoding is similar to a principle in which the encoding device performs encoding. To avoid repetition, details are not described.

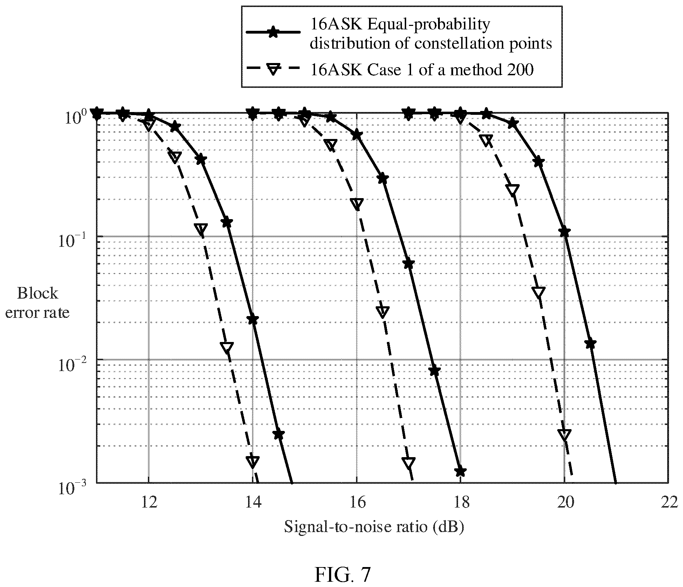

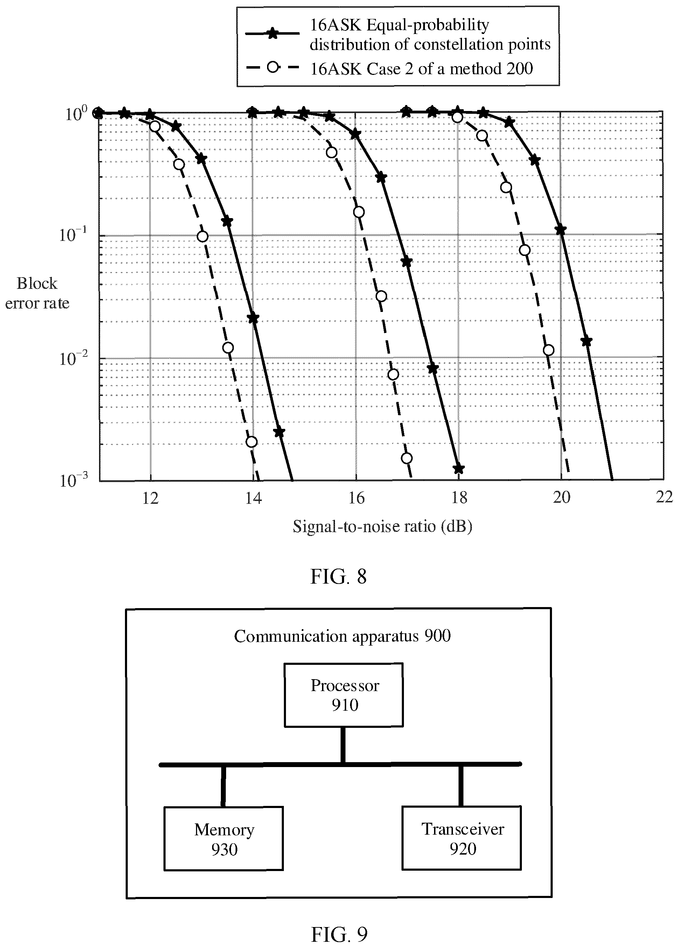

FIG. 7 and FIG. 8 are schematic diagrams of effect of processing a physical shared channel according to an embodiment of this application. FIG. 7 and FIG. 8 are diagrams of a performance comparison when a quantity of symbols is 256, 16 amplitude shift keying (amplitude shift keying, ASK) modulation is used, and a Maxwell-Boltzmann parameter is $v = 0.01$. In FIG. 7, RF-I represents a method based on Case 1 of a method 200, and in FIG. 8, RF-II represents a method based on Case 2 of the method 200. It may be learned from FIG. 7 and FIG. 8 that, compared with a case in which a method of equal-probability distribution of constellation points in constellation shaping is not used, in a case in which a constellation shaping method provided in this application is used, a block error rate (block error rate, BLER) in the method provided in this embodiment of this application is lower in a case of a same signal-to-noise ratio (signal-to-noise ratio, SNR), and a signal-to-noise ratio in the method provided in this application is lower in a case of a same block error rate, so that a significant performance gain can be obtained.

Therefore, in a method for determining a code rate of a component polar code encoder provided in an embodiment of this application, a code rate of each component polar code encoder is determined based on a channel capacity of a modulation subchannel corresponding to the component polar code encoder, and a channel capacity of a modulation subchannel may represent reliability of the modulation subchannel. Therefore, the code rate of each component polar code encoder may be determined based on the channel capacity of the modulation subchannel, to improve applicability, and avoid a problem that complexity is high when a quantity of information bits of each component polar code encoder is determined in a numerical search method.

It should be noted that, this embodiment of this application is described by using an example in which an MCS table includes at least one row, and each of at least one row in the MCS table includes an MCS index and a code rate of at least one component polar code encoder that corresponds to the MCS index included in each row. A form of the MCS table is not limited in this embodiment of this application. For example, the MCS table may include at least one column, and each of the at least one column included in the MCS table includes an MCS index and a code rate of at least one component polar code encoder that corresponds to the MCS index included in each column. For example, a row and a column in Table 1 to Table 3 may be converted, one column corresponds to one MCS index, and the MCS index corresponding to one column corresponds to a code rate of at least one component polar code encoder.

The foregoing describes the method embodiments provided in this application, and the following describes apparatus embodiments provided in this application. It should be understood that descriptions of the apparatus embodiments correspond to the descriptions of the method embodiments. Therefore, for content that is not described in detail, refer to the method embodiments. For brevity, details are not described herein again.

FIG. 9 shows a communication apparatus 900 according to an embodiment of this application. The communication apparatus 900 includes a processor 910 and a transceiver 920. The processor 910 and the transceiver 920 communicate with each other through an internal connection path, and the processor 910 is configured to execute instructions, to control the transceiver 920 to send a signal and/or receive a signal.

Optionally, the communication apparatus 900 may further include a memory 930, and the memory 930 communicates with the processor 910 and the transceiver 920 through an internal connection path. The memory 930 is configured to store instructions, and the processor 910 may execute the instructions stored in the memory 930. In a possible implementation, the communication apparatus 900 is configured to implement procedures and operations corresponding to the first device, the second device, the third device, the network device, or the terminal device in the method embodiments.

It should be understood that the communication apparatus 900 may be specifically the first device, the second device, the third device, the network device, or the terminal device in the foregoing embodiments, or may be a chip or a chip system. Correspondingly, the transceiver 920 may be a transceiver circuit of the chip. This is not limited herein. Specifically, the communication apparatus 900 may be configured to perform operations and/or procedures corresponding to the first device, the second device, the third device, the network device, or the terminal device in the method embodiments. Optionally, the memory 930 may include a read-only memory and a random access memory, and provides instructions and data for the processor. A part of the memory may further include a nonvolatile random access memory. For example, the memory may further store information about a device type. The processor 910 may be configured to execute the instructions stored in the memory, and when the processor 910 executes the instructions stored in the memory, the processor 910 is configured to perform the operations and/or procedures in the method embodiments corresponding to the first device, the second device, the third device, the network device, or the terminal device.

In an implementation process, operations in the foregoing methods may be implemented by using a hardware integrated logic circuit in the processor, or by using instructions in a form of software. The operations of the methods disclosed with reference to embodiments of this application may be directly performed by a hardware processor, or may be performed by using a combination of hardware in the processor and a software module. A software module may be located in a mature storage medium in the art such as a random access memory, a flash memory, a read-only memory, a programmable read-only memory, an electrically erasable programmable memory, or a register. The storage medium is located in the memory, and the processor reads information in the memory and completes the operations in the foregoing methods in combination with hardware of the processor. To avoid repetition, details are not described herein again.

It should be noted that, the processor in embodiments of this application may be an integrated circuit chip, and has a signal processing capability. In an implementation process, operations in the method embodiments may be implemented by using a hardware integrated logic circuit in the processor, or by using instructions in a form of software. The processor may be a general-purpose processor, a digital signal processor (DSP), an application-specific integrated circuit (ASIC), a field programmable gate array (FPGA) or another programmable logic device, a discrete gate or a transistor logic device, or a discrete hardware component. The processor may implement or perform the methods, the operations, and logical block diagrams that are disclosed in embodiments of this application. The general-purpose processor can be a microprocessor, or the processor can be any conventional processor or the like. The operations of the methods disclosed with reference to embodiments of this application may be directly performed by a hardware decoding processor, or may be performed by using a combination of hardware in the decoding processor and a software module. A software module may be located in a mature storage medium in the art such as a random access memory, a flash memory, a read-only memory, a programmable read-only memory, an electrically erasable programmable memory, or a register. The storage medium is located in the memory, and the processor reads information in the memory and completes the operations in the foregoing methods in combination with hardware of the processor.

It may be understood that the memory in this embodiment of this application may be a volatile memory or a nonvolatile memory, or may include a volatile memory and a nonvolatile memory. The nonvolatile memory may be a read-only memory (read-only memory, ROM), a programmable read-only memory (programmable ROM, PROM), an erasable programmable read-only memory (erasable PROM, EPROM), an electrically erasable programmable read-only memory (electrically EPROM, EEPROM), or a flash memory. The volatile memory may be a random access memory (random access memory, RAM), and is used as an external cache. Through example but not limitative description, many forms of RAMs may be used, for example, a static random access memory (static RAM, SRAM), a dynamic random access memory (dynamic RAM, DRAM), a synchronous dynamic random access memory (synchronous DRAM, SDRAM), a double data rate synchronous dynamic random access memory (double data rate SDRAM, DDR SDRAM), an enhanced synchronous dynamic random access memory (enhanced SDRAM, ESDRAM), a synchronous link dynamic random access memory (synchlink DRAM, SLDRAM), and a direct rambus random access memory (direct rambus RAM, DR RAM). It should be noted that the memory in the system and methods described in this specification includes but is not limited to these memories and any memory of another proper type.

According to the method provided in embodiments of this application, this application further provides a computer program product. The computer program product includes computer program code. When the computer program code is run on a computer, the computer is enabled to perform operations or procedures performed by the first device, the second device, the third device, the network device, or the terminal device in the method embodiments.

According to the method provided in embodiments of this application, this application further provides a computer-readable storage medium. The computer-readable storage medium stores program code. When the program code is run on a computer, the computer is enabled to perform operations or procedures performed by the first device, the second device, the third device, the network device, or the terminal device in the method embodiments.

According to the method provided in embodiments of this application, this application further provides a communication system. The communication system includes one or more second devices and one or more third devices.

The apparatus embodiments completely correspond to the method embodiments. A corresponding module or unit performs a corresponding operation. For example, a communication unit (a transceiver) performs a receiving operation or a sending operation in the method embodiments, and an operation other than the sending operation and the receiving operation may be performed by a processing unit (a processor). For a function of a specific unit, refer to the corresponding method embodiments. There may be one or more processors.

In embodiments of this application, all terms and English abbreviations are examples provided for ease of description, and shall not constitute any limitation on this application. In embodiments of this application, the terms and English abbreviations are all examples given for ease of description, and should not constitute any limitation on this application. This application does not exclude a possibility of defining another term that can implement a same or similar function in an existing or future protocol.

It should be understood that, "and/or" in this specification describes an association relationship between associated objects and may indicate that three relationships may exist. For example, A and/or B may indicate the following cases: Only A exists, both A and B exist, and only B exists, where A and B may be singular or plural. The character "/" usually indicates an "or" relationship between the associated objects.

A person of ordinary skill in the art may be aware that, in combination with illustrative logical blocks (illustrative logical block) and operations described in embodiments disclosed in this specification may be implemented by electronic hardware or a combination of computer software and electronic hardware. Whether the functions are performed by hardware or software depends on particular applications and design constraints of the technical solutions. A person skilled in the art may use different methods to implement the described functions for each particular application, but it should not be considered that the implementation goes beyond the scope of this application.

A person skilled in the art may clearly understand that, for the purpose of convenient and brief description, for a detailed working process of the system, apparatus, and unit, refer to a corresponding process in the method embodiments. Details are not described herein again.

In the several embodiments provided in this application, it should be understood that the disclosed system, apparatus, and method may be implemented in other manners. For example, the described apparatus embodiments are merely examples. For example, division into the units is merely logical function division and may be other division in an actual implementation. For example, a plurality of units or components may be combined or integrated into another system, or some features may be ignored or not performed. In addition, the displayed or discussed mutual couplings or direct couplings or communication connections may be implemented by using some interfaces. The indirect couplings or communication connections between the apparatuses or units may be implemented in electronic, mechanical, or other forms.

The units described as separate parts may or may not be physically separated, and parts displayed as units may or may not be physical units, that is, may be located at one place, or may be distributed on a plurality of network units. Some or all of the units may be selected based on an actual requirement, to achieve the objectives of the solutions of embodiments.

In addition, functional units in embodiments of this application may be integrated into one processing unit, each of the units may exist alone physically, or two or more units are integrated into one unit.

In the foregoing embodiments, all or some of the functions of the functional units may be implemented by software, hardware, firmware, or any combination thereof. When software is used to implement embodiments, all or some of embodiments may be implemented in a form of a computer program product. The computer program product includes one or more computer instructions (programs). When the computer program instructions (programs) are loaded and executed on a computer, the procedures or functions according to embodiments of this application are all or partially generated. The computer may be a general-purpose computer, a dedicated computer, a computer network, or another programmable apparatus. The computer instructions may be stored in a computer-readable storage medium or may be transmitted from one computer-readable storage medium to another computer-readable storage medium. For example, the computer instructions may be transmitted from one website, computer, server, or data center to another website, computer, server, or data center in a wired (for example, a coaxial cable, an optical fiber, or a digital subscriber line (DSL)) or wireless (for example, infrared, radio, and microwave, or the like) manner. The computer-readable storage medium may be any usable medium that can be accessed by a computer, or a data storage device, for example, a server or a data center, integrating one or more usable media. The usable medium may be a magnetic medium (for example, a floppy disk, a hard disk, or a magnetic tape), an optical medium (for example, a DVD), a semiconductor medium (for example, a solid state disk (solid state disk, SSD)), or the like.

When the functions are implemented in a form of a software functional unit and sold or used as an independent product, the functions may be stored in a computer-readable storage medium. Based on such an understanding, the technical solutions of this application essentially, or the part contributing to the conventional technology, or some of the technical solutions may be implemented in a form of a software product. The computer software product is stored in a storage medium, and includes several instructions for indicating a computing device (which may be a personal computer, a server, or a network device) to perform all or a part of the operations of the methods in embodiments of this application. The foregoing storage medium includes any medium that can store program code such as a USB flash drive, a removable hard disk, a read-only memory (read-only memory, ROM), a random access memory (random access memory, RAM), a magnetic disk, or an optical disc.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

**Claims**

1.  An encoding method, comprising:

    encoding, based on a code rate of each of $M$ component polar code encoders that corresponds to a first modulation and coding scheme MCS index in an MCS table, data carried on a physical shared channel, wherein the MCS table comprises at least one row, and each of the at least one row comprised in the MCS table comprises an MCS index and a code rate of at least one component polar code encoder that corresponds to the MCS index comprised in each row; and
    sending indication information, wherein the indication information indicates the first MCS index, and the first MCS index is an MCS index in the MCS table, wherein
    $M$ is a positive integer.

2.  The encoding method according to claim 1, wherein each of the at least one row comprised in the MCS table further comprises a modulation order and/or total spectral efficiency corresponding to the MCS index comprised in each row.

3.  The encoding method according to claim 2, wherein the MCS table is **characterized by** the following: a second MCS index and a third MCS index exist, and when a modulation order corresponding to the second MCS index is different from a modulation order corresponding to the third MCS index, a quantity of code rates of component polar code encoders that correspond to the second MCS index is different from a quantity of code rates of component polar code encoders that correspond to the third MCS index.

4.  The encoding method according to claim 3, wherein the quantity of code rates of the component polar code encoders that correspond to the second MCS index is a half of the modulation order corresponding to the second MCS index, and the quantity of code rates of the component polar code encoders that correspond to the third MCS index is a half of the modulation order corresponding to the third MCS index.

5.  The encoding method according to any one of claims 2 to 4, wherein the total spectral efficiency corresponding to the MCS index comprised in each row is obtained based on $R_T$ and $R_S$, wherein
    $R_T$ is first spectral efficiency, the first spectral efficiency is a sum of spectral efficiency of the at least one component polar code encoder that corresponds to the MCS index comprised in each row, and $R_S$ is a code rate of a shaped bit of a last component polar code encoder in the at least one component polar code encoder that corresponds to the MCS index comprised in each row.

6.  The encoding method according to claim 5, wherein that the total spectral efficiency corresponding to the MCS index comprised in each row is obtained based on $R_T$ and $R_S$ comprises: the total spectral efficiency corresponding to the MCS index comprised in each row is $R_T + 2R_S$.

7.  The encoding method according to any one of claims 1 to 6, wherein
    each of the at least one row comprised in the MCS table further comprises the code rate $R_S$ of the shaped bit of the last component polar code encoder in the at least one component polar code encoder that corresponds to the MCS index.

8.  The encoding method according to claim 7, wherein the encoding method further comprises:

    determining, in the MCS table, a code rate $R_S$ of a shaped bit of an $M$ th component polar code encoder in the $M$ component polar code encoders that corresponds to the first MCS index; and
    the encoding, based on a code rate of each of $M$ component polar code encoders that corresponds to a first MCS index in an MCS table, data carried on a physical shared channel comprises:
encoding, based on the code rate of each of the $M$ component polar code encoders that corresponds to the first MCS index in the MCS table and the code rate $R_S$ of the shaped bit of the $M$th component polar code encoder in the $M$ component polar code encoders that corresponds to the first MCS index, the data carried on the physical shared channel.

9. The encoding method according to any one of claims 1 to 6, wherein the encoding method further comprises:

determining, based on a Maxwell-Boltzmann parameter and a modulation order corresponding to the first MCS index, a code rate $R_S$ of a shaped bit of an $M$th component polar code encoder in the $M$ component polar code encoders that corresponds to the first MCS index, wherein the Maxwell-Boltzmann parameter is a preset value; and
the encoding, based on a code rate of each of $M$ component polar code encoders that corresponds to a first MCS index in an MCS table, data carried on a physical shared channel comprises:
encoding, based on the code rate of each of the $M$ component polar code encoders that corresponds to the first MCS index in the MCS table and the code rate $R_S$ of the shaped bit of the $M$th component polar code encoder in the $M$ component polar code encoders that corresponds to the first MCS index, the data carried on the physical shared channel.

10. The encoding method according to claim 9, wherein the determining, based on a Maxwell-Boltzmann parameter and a modulation order corresponding to the first MCS index, a code rate $R_S$ of a shaped bit of an $M$th component polar code encoder in the $M$ component polar code encoders that corresponds to the first MCS index comprises:

determining probability distribution of constellation points based on the Maxwell-Boltzmann parameter and the modulation order corresponding to the first MCS index;
determining a conditional entropy of the $M$th component polar code encoder based on the probability distribution of the constellation point; and
determining the code rate $R_S$ of the shaped bit of the $M$th component polar code encoder based on the conditional entropy of the $M$th component polar code encoder.

11. A decoding method, comprising:

receiving indication information, wherein the indication information indicates a first modulation and coding scheme MCS index, the first MCS index is an MCS index in an MCS table, the MCS table comprises at least one row, and each of the at least one row comprised in the MCS table comprises an MCS index and a code rate of at least one component polar code encoder that corresponds to the MCS index comprised in each row; and
decoding, based on a code rate of each of $M$ component polar code encoders that corresponds to the first MCS index in the MCS table, data carried on a physical shared channel, wherein
$M$ is a positive integer.

12. The decoding method according to claim 11, wherein each of the at least one row comprised in the MCS table further comprises a modulation order and/or total spectral efficiency corresponding to the MCS index comprised in each row.

13. The decoding method according to claim 12, wherein the MCS table is **characterized by** the following: a second MCS index and a third MCS index exist, and when a modulation order corresponding to the second MCS index is different from a modulation order corresponding to the third MCS index, a quantity of code rates of component polar code encoders that correspond to the second MCS index is different from a quantity of code rates of component polar code encoders that correspond to the third MCS index.

14. The decoding method according to claim 13, wherein the quantity of code rates of the component polar code encoders that correspond to the second MCS index is a half of the modulation order corresponding to the second MCS index, and the quantity of code rates of the component polar code encoders that correspond to the third MCS index is a half of the modulation order corresponding to the third MCS index.

15. The decoding method according to any one of claims 12 to 14, wherein the total spectral efficiency corresponding to the MCS index comprised in each row is obtained based on $R_T$ and $R_S$, wherein
$R_T$ is first spectral efficiency, the first spectral efficiency is a sum of spectral efficiency of the at least one component polar code encoder that corresponds to the MCS index comprised in each row, and $R_S$ is a code rate of a shaped bit of a last component polar code encoder in the at least one component polar code encoder that corresponds to the MCS index comprised in each row.

16. The decoding method according to claim 15, wherein that the total spectral efficiency corresponding to the MCS index comprised in each row is obtained based on $R_T$ and $R_S$ comprises: the total spectral efficiency corresponding to the MCS index comprised in each row is $R_T + 2R_S$.

17. The decoding method according to any one of claims 11 to 16, wherein
each of the at least one row comprised in the MCS table further comprises the code rate $R_S$ of the shaped bit of the last component polar code encoder in the at least one component polar code encoder that corresponds to the MCS index.

18. The decoding method according to claim 17, wherein the decoding method further comprises:

determining, in the MCS table, a code rate $R_S$ of a shaped bit of an $M$ th component polar code encoder in the $M$ component polar code encoders that corresponds to the first MCS index; and
the decoding, based on a code rate of each of $M$ component polar code encoders that corresponds to the first MCS index in the MCS table, data carried on a physical shared channel comprises:
decoding, based on the code rate of each of the $M$ component polar code encoders that corresponds to the first MCS index in the MCS table and the code rate $R_S$ of the shaped bit of the $M$ th component polar code encoder in the $M$ component polar code encoders that corresponds to the first MCS index, the data carried on the physical shared channel.

19. The decoding method according to any one of claims 11 to 16, wherein the decoding method further comprises:

determining, based on a Maxwell-Boltzmann parameter and a modulation order corresponding to the first MCS index, a code rate $R_S$ of a shaped bit of an $M$ th component polar code encoder in the $M$ component polar code encoders that corresponds to the first MCS index, wherein the Maxwell-Boltzmann parameter is a preset value; and
the decoding, based on a code rate of each of $M$ component polar code encoders that corresponds to the first MCS index in the MCS table, data carried on a physical shared channel comprises:
decoding the data carried on the physical shared channel based on the code rate of each of the $M$ component polar code encoders that corresponds to the first MCS index in the MCS table and the code rate $R_S$ of the shaped bit of the $M$ th component polar code encoder in the $M$ component polar code encoders that corresponds to the first MCS index.

20. The decoding method according to claim 19, wherein the determining, based on a Maxwell-Boltzmann parameter and a modulation order corresponding to the first MCS index, a code rate $R_S$ of a shaped bit of an $M$ th component polar code encoder in the $M$ component polar code encoders that corresponds to the first MCS index comprises:

determining probability distribution of constellation points based on the Maxwell-Boltzmann parameter and the modulation order corresponding to the first MCS index;
determining a conditional entropy of the $M$ th component polar code encoder based on the probability distribution of the constellation point; and
determining the code rate $R_S$ of the shaped bit of the $M$ th component polar code encoder based on the conditional entropy of the $M$ th component polar code encoder.

21. An encoding method, comprising:

receiving indication information, wherein the indication information indicates a first modulation and coding scheme MCS index, the first MCS index is an MCS index in an MCS table, the MCS table comprises at least one row, and each of the at least one row comprised in the MCS table comprises an MCS index and a code rate of at least one component polar code encoder that corresponds to the MCS index comprised in each row; and
encoding, based on a code rate of each of $M$ component polar code encoders that corresponds to the first MCS index in the MCS table, data carried on a physical shared channel, wherein
$M$ is a positive integer.

22. The encoding method according to claim 21, wherein each of the at least one row comprised in the MCS table further comprises a modulation order and/or total spectral efficiency corresponding to the MCS index comprised in each row.

23. The encoding method according to claim 22, wherein the MCS table is **characterized by** the following: a second MCS index and a third MCS index exist, and when a modulation order corresponding to the second MCS index is different from a modulation order corresponding to the third MCS index, a quantity of code rates of component polar code encoders that correspond to the second MCS index is different from a quantity of code rates of component polar code encoders that correspond to the third MCS index.

24. The encoding method according to claim 23, wherein the quantity of code rates of the component polar code encoders that correspond to the second MCS index is a half of the modulation order corresponding to the second MCS index, and the quantity of code rates of the component polar code encoders that correspond to the third MCS index is a half of the modulation order corresponding to the third MCS index.

25. The encoding method according to any one of claims 22 to 24, wherein the total spectral efficiency corresponding to the MCS index comprised in each row is obtained based on $R_T$ and $R_S$, wherein
$R_T$ is first spectral efficiency, the first spectral efficiency is a sum of spectral efficiency of the at least one component polar code encoder that corresponds to the MCS index comprised in each row, and $R_S$ is a code rate of a shaped bit of a last component polar code encoder in the at least one component polar code encoder that corresponds to the MCS index comprised in each row.

26. The encoding method according to claim 25, wherein that the total spectral efficiency corresponding to the MCS index comprised in each row is obtained based on $R_T$ and $R_S$ comprises: the total spectral efficiency corresponding to the MCS index comprised in each row is $R_T + 2R_S$.

27. The encoding method according to any one of claims 21 to 26, wherein
each of the at least one row comprised in the MCS table further comprises the code rate $R_S$ of the shaped bit of the last component polar code encoder in the at least one component polar code encoder that corresponds to the MCS index.

28. The encoding method according to claim 27, wherein the encoding method further comprises:

determining, in the MCS table, a code rate $R_S$ of a shaped bit of an $M^{th}$ component polar code encoder in the $M$ component polar code encoders that corresponds to the first MCS index; and
the encoding, based on a code rate of each of $M$ component polar code encoders that corresponds to the first MCS index in the MCS table, data carried on a physical shared channel comprises:
encoding, based on the code rate of each of the $M$ component polar code encoders that corresponds to the first MCS index in the MCS table and the code rate $R_S$ of the shaped bit of the $M^{th}$ component polar code encoder in the $M$ component polar code encoders that corresponds to the first MCS index, the data carried on the physical shared channel.

29. The encoding method according to any one of claims 21 to 28, wherein the encoding method further comprises:

determining, based on a Maxwell-Boltzmann parameter and a modulation order corresponding to the first MCS index, a code rate $R_S$ of a shaped bit of an $M^{th}$ component polar code encoders that corresponds to the first MCS index, wherein the Maxwell-Boltzmann parameter is a preset value; and
the encoding, based on a code rate of each of $M$ component polar code encoders that corresponds to the first MCS index in the MCS table, data carried on a physical shared channel comprises:
encoding, based on the code rate of each of the $M$ component polar code encoders that corresponds to the first MCS index in the MCS table and the code rate $R_S$ of the shaped bit of the $M^{th}$ component polar code encoder in the $M$ component polar code encoders that corresponds to the first MCS index, the data carried on the physical shared channel.

30. The encoding method according to claim 29, wherein the determining, based on a Maxwell-Boltzmann parameter and a modulation order corresponding to the first MCS index, a code rate $R_S$ of a shaped bit of an $M^{th}$ component polar code encoder in the $M$ component polar code encoders that corresponds to the first MCS index comprises:

determining probability distribution of constellation points based on the Maxwell-Boltzmann parameter and the modulation order corresponding to the first MCS index;

determining a conditional entropy of the $M^{th}$ component polar code encoder based on the probability distribution of the constellation point; and

determining the code rate $R_S$ of the shaped bit of the $M^{th}$ component polar code encoder based on the conditional entropy of the $M^{th}$ component polar code encoder.

31. A decoding method, comprising:

sending indication information, wherein the indication information indicates a first modulation and coding scheme MCS index, the first MCS index is an MCS index in an MCS table, the MCS table comprises at least one row, and each of the at least one row comprised in the MCS table comprises an MCS index and a code rate of at least one component polar code encoder that corresponds to the MCS index comprised in each row; and decoding, based on a code rate of each of $M$ component polar code encoders that corresponds to the first MCS index in the MCS table, data carried on a physical shared channel, wherein $M$ is a positive integer.

32. The decoding method according to claim 31, wherein each of the at least one row comprised in the MCS table further comprises a modulation order and/or total spectral efficiency corresponding to the MCS index comprised in each row.

33. The decoding method according to claim 32, wherein the MCS table is **characterized by** the following: a second MCS index and a third MCS index exist, and when a modulation order corresponding to the second MCS index is different from a modulation order corresponding to the third MCS index, a quantity of code rates of component polar code encoders that correspond to the second MCS index is different from a quantity of code rates of component polar code encoders that correspond to the third MCS index.

34. The decoding method according to claim 33, wherein the quantity of code rates of the component polar code encoders that correspond to the second MCS index is a half of the modulation order corresponding to the second MCS index, and the quantity of code rates of the component polar code encoders that correspond to the third MCS index is a half of the modulation order corresponding to the third MCS index.

35. The decoding method according to any one of claims 32 to 34, wherein the total spectral efficiency corresponding to the MCS index comprised in each row is obtained based on $R_T$ and $R_S$, wherein $R_T$ is first spectral efficiency, the first spectral efficiency is a sum of spectral efficiency of the at least one component polar code encoder that corresponds to the MCS index comprised in each row, and $R_S$ is a code rate of a shaped bit of a last component polar code encoder in the at least one component polar code encoder that corresponds to the MCS index comprised in each row.

36. The decoding method according to claim 35, wherein that the total spectral efficiency corresponding to the MCS index comprised in each row is obtained based on $R_T$ and $R_S$ comprises: the total spectral efficiency corresponding to the MCS index comprised in each row is $R_T + 2R_S$.

37. The decoding method according to any one of claims 31 to 36, wherein each of the at least one row comprised in the MCS table further comprises the code rate $R_S$ of the shaped bit of the last component polar code encoder in the at least one component polar code encoder that corresponds to the MCS index.

38. The decoding method according to claim 37, wherein the decoding method further comprises:

determining, in the MCS table, a code rate $R_S$ of a shaped bit of an $M^{th}$ component polar code encoder in the $M$ component polar code encoders that corresponds to the first MCS index; and the decoding, based on a code rate of each of $M$ component polar code encoders that corresponds to the first MCS index in the MCS table, data carried on a physical shared channel comprises: decoding, based on the code rate of each of the $M$ component polar code encoders that corresponds to the first MCS index in the MCS table and the code rate $R_S$ of the shaped bit of the $M^{th}$ component polar code encoder in the $M$ component polar code encoders that corresponds to the first MCS index, the data carried on the physical shared channel.

39. The decoding method according to any one of claims 31 to 36, wherein the decoding method further comprises:

determining, based on a Maxwell-Boltzmann parameter and a modulation order corresponding to the first MCS index, a code rate $R_S$ of a shaped bit of an $M$ th component polar code encoder in the $M$ component polar code encoders that corresponds to the first MCS index, wherein the Maxwell-Boltzmann parameter is a preset value; and
the decoding, based on a code rate of each of $M$ component polar code encoders that corresponds to the first MCS index in the MCS table, data carried on a physical shared channel comprises:
decoding, based on the code rate of each of the $M$ component polar code encoders that corresponds to the first MCS index in the MCS table and the code rate $R_S$ of the shaped bit of the $M$ th component polar code encoder in the $M$ component polar code encoders that corresponds to the first MCS index, the data carried on the physical shared channel.

40. The decoding method according to claim 39, wherein the determining, based on a Maxwell-Boltzmann parameter and a modulation order corresponding to the first MCS index, a code rate $R_S$ of a shaped bit of an M $^{th}$ component polar code encoder in the $M$ component polar code encoders that corresponds to the first MCS index comprises:

determining probability distribution of constellation points based on the Maxwell-Boltzmann parameter and the modulation order corresponding to the first MCS index;
determining a conditional entropy of the $M$ th component polar code encoder based on the probability distribution of the constellation point; and
determining the code rate $R_S$ of the shaped bit of the $M$ th component polar code encoder based on the conditional entropy of the $M$ th component polar code encoder.

41. A communication apparatus, comprising a processor, wherein the processor is coupled to a memory, and the processor is configured to execute a computer program or instructions stored in the memory, so that the communication apparatus implements the method according to any one of claims 1 to 40.

42. A computer-readable storage medium, wherein the computer-readable storage medium stores computer instructions, and when the computer instructions are run on an electronic device, the electronic device is enabled to perform the method according to any one of claims 1 to 40.

Network
device 120

Terminal
device 110

FIG. 1

<u>200</u>

A first device obtains first spectral efficiency — S201

The first device determines a channel capacity of each of $M$ modulation subchannels corresponding to $M$ component polar code encoders based on the first spectral efficiency, where the $M$ component polar code encoders are in one-to-one correspondence with the $M$ modulation subchannels, and a code length of each of the $M$ component polar code encoders is $N$ — S202

The first device determines a code rate of each component polar code encoder based on the channel capacity corresponding to each modulation subchannel and the code length N of each component polar code encoder — S203

FIG. 2

300

A first device determines a conditional entropy corresponding to an $M^{th}$ component polar code encoder in $M$ component polar code encoders based on a probability distribution of a constellation point, where a code length of each component polar code encoder is $N$, the probability distribution of the constellation point is a probability distribution that is of the constellation point and that corresponds to a modulation order and a Maxwell-Boltzmann parameter, and the Maxwell-Boltzmann parameter is a preset value

S301

The first device determines a code rate of a shaped bit of the $M^{th}$ component polar code encoder based on the conditional entropy corresponding to the $M^{th}$ component polar code encoder

S302

FIG. 3

400

Third device

Second device

S401: Indication information

S402: Obtain a first MCS index based on the received indication information, and encode, based on code rates of $M$ component polar code encoders that correspond to the first MCS index in an MCS table, data carried on a physical shared channel

S403: Physical shared channel

S404: Decode, based on the code rates of the $M$ component polar code encoders that correspond to the first MCS index, the data carried on the physical shared channel

FIG. 4

500

```
┌─────────────────┐                          ┌─────────────────┐
│   Third device  │                          │  Second device  │
└─────────────────┘                          └─────────────────┘
        │                                             │
        │                         ┌───────────────────┴───────────────────┐
        │                         │ S501: Encode a physical shared channel │
        │                         │ based on code rates of M component polar│
        │                         │ code encoders that correspond to a first│
        │                         │     MCS index in an MCS table          │
        │                         └───────────────────┬───────────────────┘
        │                                             │
        │◄──────── S502: Indication information ──────│
        │                                             │
        │◄──────── S503: Physical shared channel ─────│
        │                                             │
┌───────┴──────────────────────────────┐             │
│ S504: The third device obtains the    │             │
│ first MCS index based on the received  │             │
│ indication information, and encodes,   │             │
│ based on the code rates of the M       │             │
│ component polar code encoders that     │             │
│ correspond to the first MCS index in   │             │
│ the MCS table, data carried on the     │             │
│ physical shared channel                │             │
└───────┬──────────────────────────────┘             │
        │                                             │
```

FIG. 5

FIG. 6

EP 4 451 586 A1

FIG. 7

FIG. 8

FIG. 9

## INTERNATIONAL SEARCH REPORT

| | International application No. |
|---|---|
| | **PCT/CN2022/138444** |

**A.      CLASSIFICATION OF SUBJECT MATTER**

H04L 1/00(2006.01)i

According to International Patent Classification (IPC) or to both national classification and IPC

**B.      FIELDS SEARCHED**

Minimum documentation searched (classification system followed by classification symbols)

H04L,H04W

Documentation searched other than minimum documentation to the extent that such documents are included in the fields searched

Electronic data base consulted during the international search (name of data base and, where practicable, search terms used)

CNPAT, WPI, EPODOC, CNKI: 编码, 解码, 调制, MCS, 极化, 极化码, 码率, 共享, 信道, 链路, 数据, 表格, 索引, 指示, 频谱效率, 阶数, 条件熵, code, decode, modulate, modulation and coding scheme, polar, code rate, shared channel, data, table, index, indicate, spectrum, efficiency, order, conditional entropy

**C.      DOCUMENTS CONSIDERED TO BE RELEVANT**

| Category* | Citation of document, with indication, where appropriate, of the relevant passages | Relevant to claim No. |
|---|---|---|
| X | CN 112930666 A (NTT DOCOMO, INC.) 08 June 2021 (2021-06-08) description, paragraphs [0038]-[0274], and figures 1-15 | 1-2, 11-12, 21-22, 31-32, 41-42 |
| A | CN 110034906 A (KT CORP.) 19 July 2019 (2019-07-19) entire document | 1-42 |
| A | CN 110048727 A (CENTRAL SOUTH UNIVERSITY) 23 July 2019 (2019-07-23) entire document | 1-42 |
| A | CN 110830155 A (HUAWEI TECHNOLOGIES CO., LTD.) 21 February 2020 (2020-02-21) entire document | 1-42 |
| A | CN 112511268 A (ZTE CORP.) 16 March 2021 (2021-03-16) entire document | 1-42 |
| A | US 2019253121 A1 (INTEL CORP.) 15 August 2019 (2019-08-15) entire document | 1-42 |
| A | WO 2019225655 A1 (NTT DOCOMO, INC.) 28 November 2019 (2019-11-28) entire document | 1-42 |

☐ Further documents are listed in the continuation of Box C.          ☑ See patent family annex.

| | |
|---|---|
| *      Special categories of cited documents: | "T"   later document published after the international filing date or priority date and not in conflict with the application but cited to understand the principle or theory underlying the invention |
| "A"   document defining the general state of the art which is not considered to be of particular relevance | |
| "D"   document cited by the applicant in the international application | "X"   document of particular relevance; the claimed invention cannot be considered novel or cannot be considered to involve an inventive step when the document is taken alone |
| "E"   earlier application or patent but published on or after the international filing date | |
| "L"   document which may throw doubts on priority claim(s) or which is cited to establish the publication date of another citation or other special reason (as specified) | "Y"   document of particular relevance; the claimed invention cannot be considered to involve an inventive step when the document is combined with one or more other such documents, such combination being obvious to a person skilled in the art |
| "O"   document referring to an oral disclosure, use, exhibition or other means | |
| "P"   document published prior to the international filing date but later than the priority date claimed | "&"   document member of the same patent family |

| Date of the actual completion of the international search | Date of mailing of the international search report |
|---|---|
| **23 February 2023** | **08 March 2023** |

| Name and mailing address of the ISA/CN | Authorized officer |
|---|---|
| **China National Intellectual Property Administration (ISA/CN)** **China No. 6, Xitucheng Road, Jimenqiao, Haidian District, Beijing 100088** | |
| Facsimile No. **(86-10)62019451** | Telephone No. |

Form PCT/ISA/210 (second sheet) (July 2022)

# EP 4 451 586 A1

International application No.

**PCT/CN2022/138444**

| Patent document cited in search report | | | Publication date (day/month/year) | Patent family member(s) | | | Publication date (day/month/year) |
|---|---|---|---|---|---|---|---|
| CN | 112930666 | A | 08 June 2021 | None | | | |
| CN | 110034906 | A | 19 July 2019 | EP | 3512138 | A1 | 17 July 2019 |
| CN | 110048727 | A | 23 July 2019 | None | | | |
| CN | 110830155 | A | 21 February 2020 | WO | 2020029987 | A1 | 13 February 2020 |
| CN | 112511268 | A | 16 March 2021 | None | | | |
| US | 2019253121 | A1 | 15 August 2019 | US | 11115098 | B2 | 07 September 2021 |
| | | | | US | 2022038156 | A1 | 03 February 2022 |
| WO | 2019225655 | A1 | 28 November 2019 | None | | | |

Form PCT/ISA/210 (patent family annex) (July 2022)

**EP 4 451 586 A1**

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202210047691
- CN 202210476457